(19) Europäisches Patentamt
European Patent Office
Office européen des brevets

(11) EP 2 835 407 A1

(12) EUROPEAN PATENT APPLICATION

(43) Date of publication:
**11.02.2015 Bulletin 2015/07**

(51) Int Cl.:
***C09K 11/00*** *(2006.01)* ***C08G 61/12*** *(2006.01)*
***H01B 1/00*** *(2006.01)* ***H01L 51/00*** *(2006.01)*

(21) Application number: **13179740.9**

(22) Date of filing: **08.08.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
- **LANXESS Deutschland GmbH**
  **50569 Köln (DE)**
- **Institute of Problems of Chemical Physics RAS**
  **Chernogolovka 142432, Moscow Region (RU)**

(72) Inventors:
- **Khakina, Ekaterina A.**
  **Chernogolovka,**
  **Moscow region, 142432 (RU)**
- **Susarova, Dr. Diana K.**
  **Chernogolovka,**
  **Moscow region, 142432 (RU)**
- **Mukhacheva, Olga A.**
  **Chernogolovka,**
  **Moscow region, 142432 (RU)**
- **Troshin, Dr. Pavel A.**
  **Chernogolovka,**
  **Moscow region, 142432 (RU)**

(74) Representative: **Wichmann, Birgid et al**
**LANXESS Deutschland GmbH**
**LEX-IPR**
**LANXESS Tower**
**Kennedyplatz 1**
**50679 Köln (DE)**

(54) **Conjugated polymer compounds**

(57) The present invention relates to polymers comprising a conjugated backbone with repeating units represented by formula (I)

-[-X-A-X-]- (I)

wherein
A represents a planar aromatic unit and
X in each case independent from each other represents a divalent acetylene fragment or a thiophene unit and the use of theses polymers in photovoltaic devices.

EP 2 835 407 A1

## Description

### TECHNICAL FIELD

The present invention relates to polymers comprising at least one planar aromatic unit and their use in photovoltaic devices.

### BACKGROUND ART

According to C. Duan et. al., J. Mater. Chem., 2012, 22, 10416-10434; Z.-G. Zhang, J. Mater. Chem., 2012, 22, 4178-4187; H. Zhou, et. al., Macromolecules 2012, 45, 607-632 different polymers were designed and investigated as photoactive materials in photovoltaic devices, preferably in organic solar cells or batteries.

F. He, J. Am. Chem. Soc. 2011, 133, 3284-3287 discloses polymer structures of the formulas **PA1** and **PA2** (PA = prior art polymers),

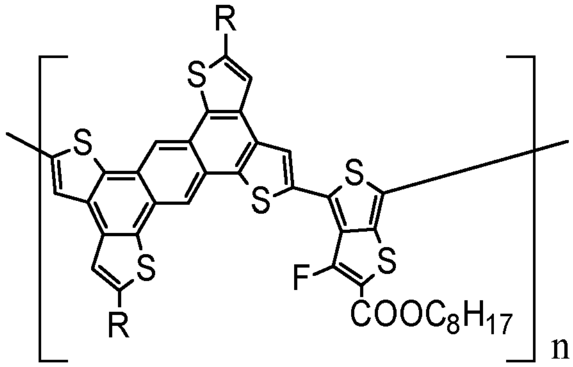

**PA1**

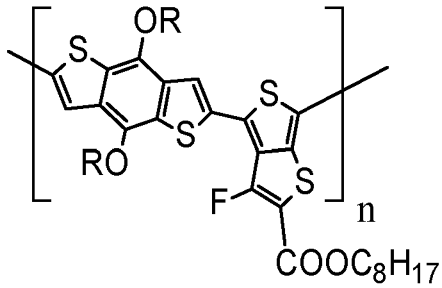

**PA2**

wherein R represents 2-butyloctyl- while n was not further defined.

The polymer **PA1** has an extended planar conjugated tetrathienoanthracene system in its repeating unit which improves significantly self-organization of the polymer chains in semiconducting thin films of photovoltaic devices and induces a high degree of crystallinity which is missing in the amorphous polymer **PA2.** As a result, **PA1** exhibits one order of magnitude higher charge carrier mobility and two times higher efficiency in solar batteries than **PA2.**

The effect of planar aromatic units on the charge carrier mobility properties of conjugated polymers is also illustrated by structures **PA3** and **PA4** disclosed in P. A. Troshin et. al. Adv. Energ. Mater. 2013, 3, 161-166 and D. A. M. Egbe et. al., Macromolecules, 2004, 37, 7451. The planar anthracene unit introduced in the polymer backbone of **PA3** improved the charge carrier mobility performance or charge carrier capacity performance in solar cells from 0.7% (recorded for **PA4** without planar anthracene unit) up to 3.5-5.0% (recorded for PA3) when used together with fullerene derivatives, while n was not further defined.

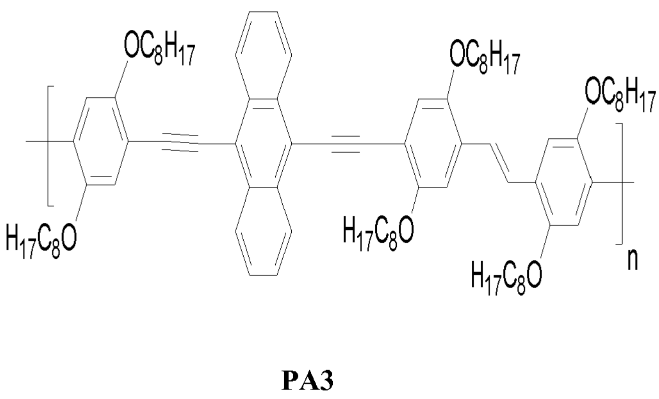

**PA3**

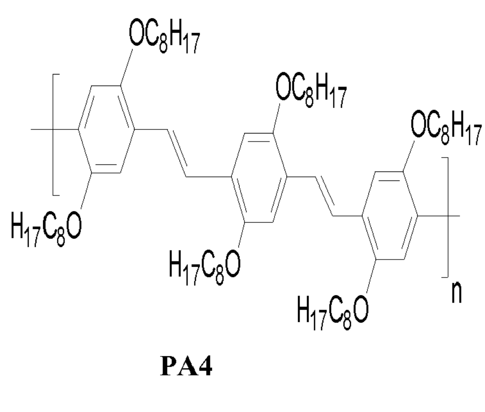

**PA4**

Further illustration is provided by conjugated polymers **PA5** and PA6 disclosed in Y. Lee et.al., J. Mater. Chem., 2011, 21, 8583-8590

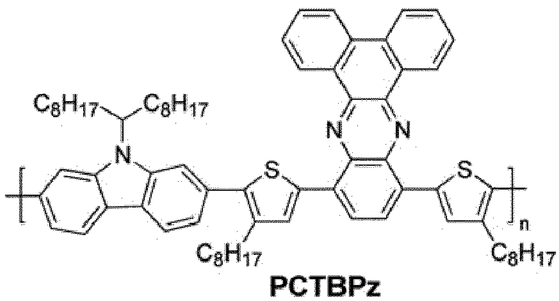

PCTBPz

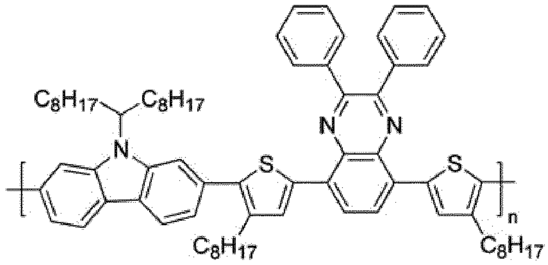

PCTPQx

**PA5** **PA6**

The polymer **PA5** comprises a planar condensed aromatic π-system which is missing in the case of **PA6** because two phenyl rings are not coplanar with the quinoxaline moiety. The molecular architecture of **PA5** results in higher charge carrier mobility and higher performance of solar cells compared to the polymer PA6 ( n was not further defined).

**PROBLEMS TO BE SOLVED BY THE INVENTION**

The object of the present invention is to provide polymers comprising aromatic π-systems with improved photoelectric conversion efficiency.

**SUMMARY OF THE INVENTION**

The object was achieved when polymers comprising a conjugated backbone with repeating units represented by general formula (I) containing at least one planar aromatic system A in their repeating unit, the backbone of the conjugated polymer, were used in semiconducting thin films of photovoltaic devices or batteries and the repeating unit is represented by formula (I)

-[-X-A-X-]- (I)

wherein
A represents a planar aromatic unit and
X in each case independent from each other represents a divalent acetylene fragment or a thiophene unit.

The present invention is therefore directed to polymers comprising a conjugated backbone with repeating units represented by formula (I)

-[-X-A-X-]- (I)

containing at least one planar aromatic system A selected from the list

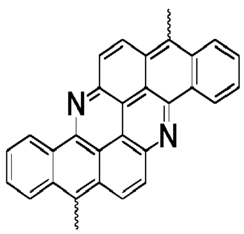

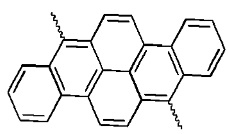

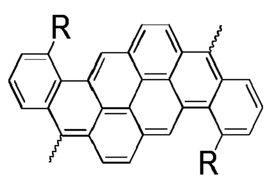

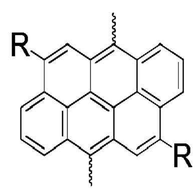

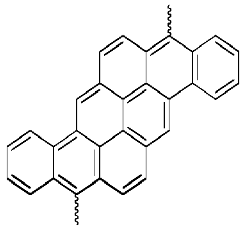 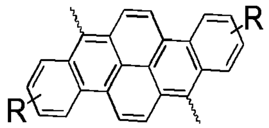 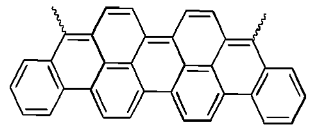 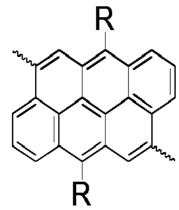

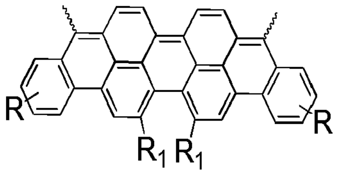 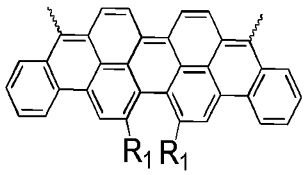 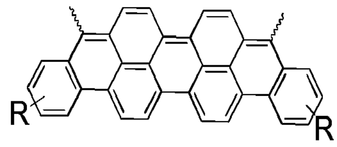

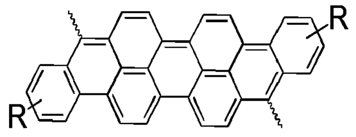 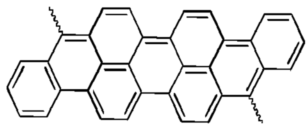 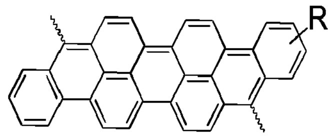

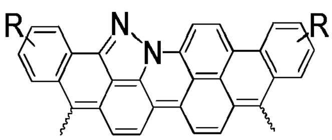 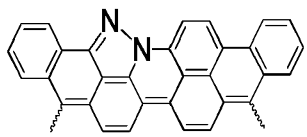

wherein

wavy bond shows the attachment positions of X-blocks in formula (I);

R represents an aryl or a heteroaryl group which is non-substituted or substituted with a solubilizing group selected from $C_1$-$C_{20}$ alkyl or $C_1$-$C_{20}$ alkoxy,

$R_1$ represents a $C_1$-$C_{20}$ alkoxy group or a $C_1$-$C_{20}$ alkylthio group,

X in each case independent from each other represents a divalent acetylene fragment $X_1$ or a thiophene unit $X_2$

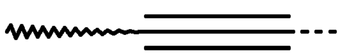

$X_1$

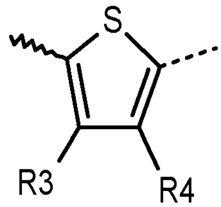

$X_2$

wherein

represents a wavy bond as the attachment position(s) of A in formula (I) and

R3 and R4 are the same or mutually different and represent a hydrogen atom, an alkyl group, an alkoxy group or an alkylthio group.

The present invention illustrates that introduction of planar aromatic systems in the backbone of conjugated polymers improve their electrical properties, preferably their charge carrier mobility property and as a consequence an improvement of the performance of organic solar cells or organic solar batteries is discovered.

For clarification, it should be noted that the scope of the invention encompasses all of the definitions, parameters, process steps and illustrations set forth above and below, either in general terms or within areas of preference or preferred embodiments, with one another, i.e., also any combinations between the particular areas and areas of preference.

## DETAILED DESCRIPTION OF THE INVENTION

In a preferred embodiment of the present invention R in the planar aromatic systems shown in the list above is selected from the group

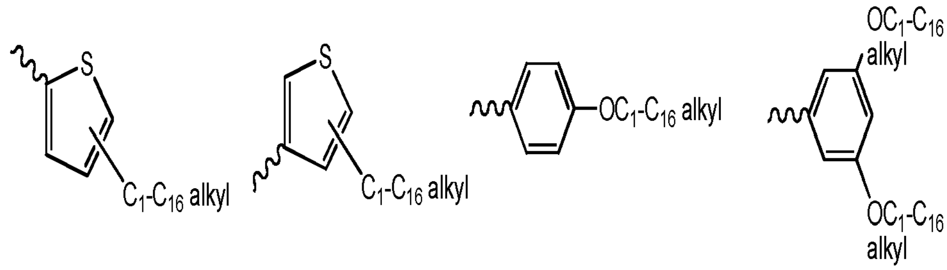

When X in formula (I) represents a divalent acetylene fragment $X_1$, the present invention provides polymers comprising a conjugated backbone represented by formula (II)

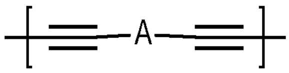

(II)

containing at least one planar aromatic system A selected from the list

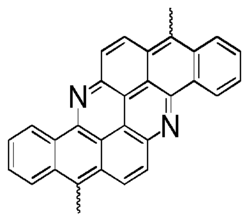
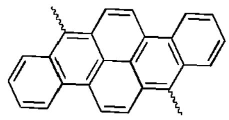
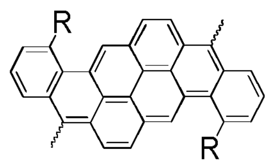
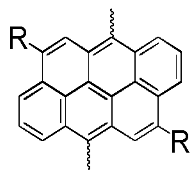
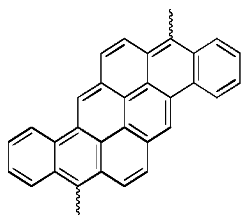
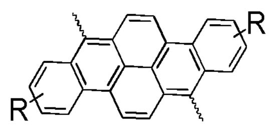
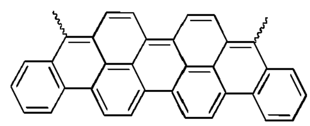
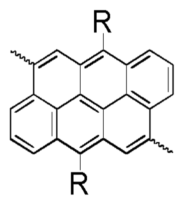
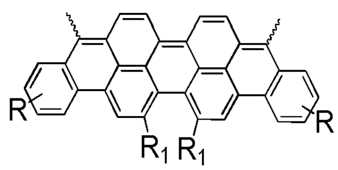
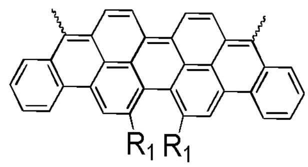
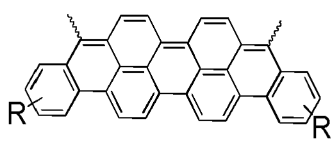
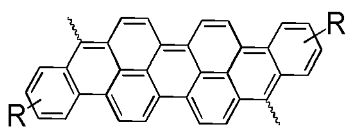
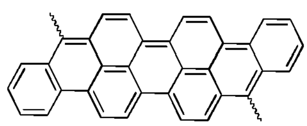
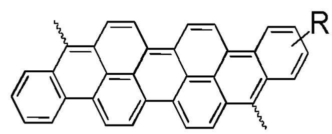
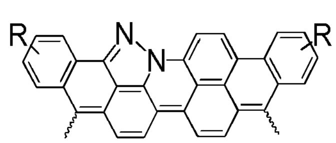
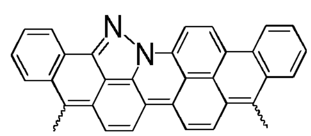

and

wavy bond 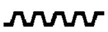 shows the attachment positions of the acetylene fragment in formula (II);

R represents an aryl or a heteroaryl group which is non-substituted or substituted with a solubilizing group selected from $C_1$-$C_{20}$ alkyl or $C_1$-$C_{20}$ alkoxy, and

$R_1$ represents a $C_1$-$C_{20}$ alkoxy group or a $C_1$-$C_{20}$ alkylthio group.

When X in formula (I) represents a thiophene unit $X_2$, the present invention provides polymers comprising a conjugated backbone represented by formula (III)

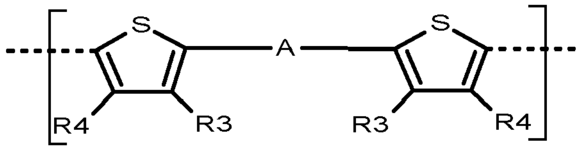

(III)

containing at least one planar aromatic system A selected from the list

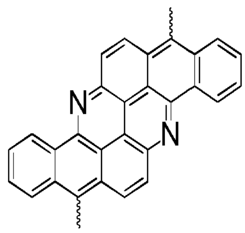
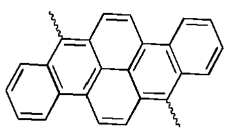
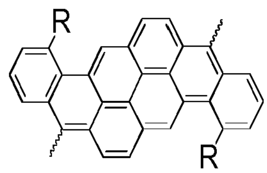
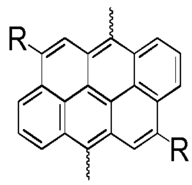
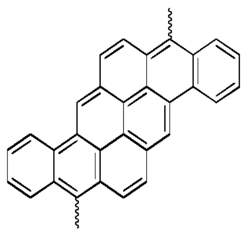
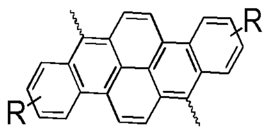
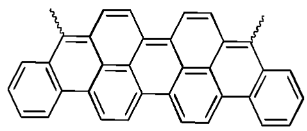
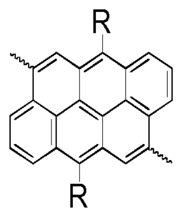
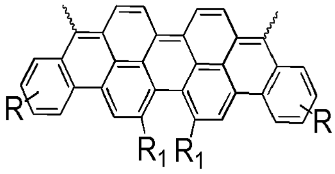
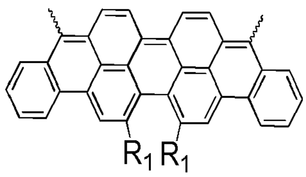
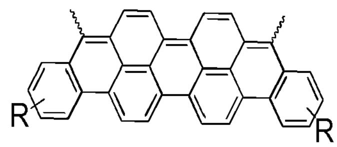
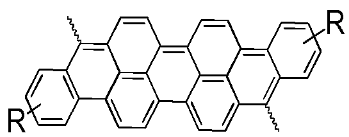
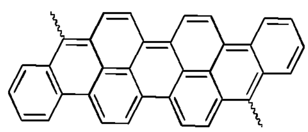
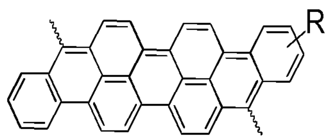
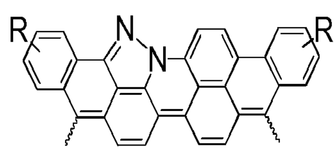
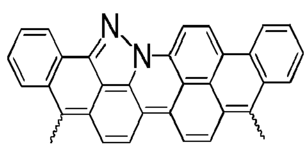

and

wavy bond 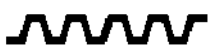 shows the attachment positions of the thiophene-blocks in formula (III);

| | |
|---|---|
| R | represents an aryl or a heteroaryl group which is non-substituted or substituted with a solubilizing group selected from $C_1$-$C_{20}$ alkyl or $C_1$-$C_{20}$ alkoxy, |
| $R_1$ | represents a $C_1$-$C_{20}$ alkoxy group or a $C_1$-$C_{20}$ alkylthio group, and |
| R3 and R4 | are the same or mutually different and represent independent from each other a hydrogen atom, an alkyl group, an alkoxy group or an alkylthio group. |

In an embodiment of the present invention the polymers are represented by formula (I')

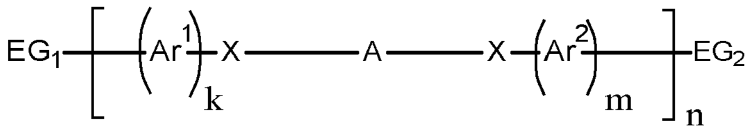

(I')

wherein

| | |
|---|---|
| A | represents a planar aromatic system selected from the list given above, |
| $Ar^1$ and $Ar^2$ | are the same or mutually different and independent from each other represent a divalent arylene group, a divalent heterocyclic group, or a divalent aromatic amine residue, |
| k | represents the number of $Ar^1$ units connected in series in the repeating unit of the conjugated polymer and is a number between 0 and 3, preferably from 1 to 3, |
| m | represents the number of $Ar^2$ units connected in series in the repeating unit of the conjugated polymer and is a number between 0 and 3, preferably from 1 to 3; |
| n | represents an integer from 2 to 2000, preferably from 2 to 200, |
| $EG_1$ and $EG_2$ | are the end groups of the polymer and independent from each other they represent a hydrogen, a halogen, a trialkylstannyl unit (-Sn(Alkyl)$_3$), a boronic acid unit (-B(OH)$_2$), a boronic ester unit (-B(OAlkyl)$_2$), an aryl unit or a heteroaryl unit and |
| X | represents in each case independent from each other a divalent acetylene fragment $X_1$ or a thiophene unit $X_2$ |

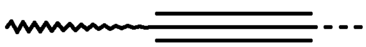

$X_1$

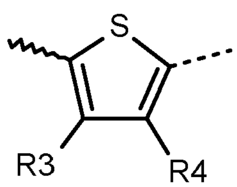

$X_2$

wherein

 represents a wavy bond as the attachment position(s) of A and

| | |
|---|---|
| R3 and R4 | are the same or mutually different and represent a hydrogen atom, an alkyl group, an alkoxy group or an alkylthio group. |

For clarification and in one embodiment of the present invention, when k = 0 the polymers (I') do not comprise an $Ar^1$ moiety. For clarification and in one embodiment of the present invention when m = 0, the polymers (I') do not comprise an $Ar^2$ moiety.

In one embodiment of the present invention formula (I'-1) is a conjugated polymer with k = 1 and m = 3:

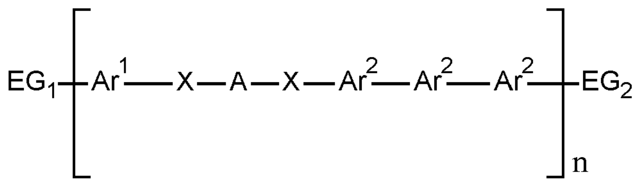

(I'-1)

wherein

| | |
|---|---|
| A | represents a planar aromatic system selected from the list given above, |
| $Ar^1$ and $Ar^2$ | are the same or mutually different and independent from each other represent a divalent arylene group, a divalent heterocyclic group, or a divalent aromatic amine residue, |
| n | represents an integer from 2 to 2000, preferably from 2 to 200, |
| $EG_1$ and $EG_2$ | are the end groups of the polymers and independent from each other they represent a hydrogen, a halogen, a trialkylstannyl unit ($-Sn(Alkyl)_3$), a boronic acid unit ($-B(OH)_2$), a boronic ester unit ($-B(OAlkyl)_2$), an aryl unit or a heteroaryl unit and |
| X | represents in each case independent from each other a divalent acetylene fragment $X_1$ or a thiophene unit $X_2$. |

In the context of the present invention the prefix "poly" is understood to mean that more than one identical or different repeating units of the general formula (I) are present in the polymers (I'). The polymers according to the present invention contain a total of n repeating units of the general formula (I) where n is an integer from 2 to 2000, preferably from 2 to 200. The repeating units of the general formula (I) may each be the same or different within a polymer according to the present invention. Preference is given to polymers containing identical repeating units of the general formula (I) in each case. Polymers according to the present invention preferably have hydrogen as end groups. In another embodiment polymers according to the present invention preferably have phenyl units as end groups.

In the light of the foregoing, the present invention provides polymers that can be used as organic semiconductor materials. Also provided are associated devices and related methods for the preparation and use of these polymers. The polymers according to the present invention can exhibit properties such as optimized optical absorption, good charge transport characteristics and chemical stability in ambient conditions, low-temperature processability, large solubility in common solvents, and processing versatility (e.g. via various solution processes). As a result, optoelectronic devices, preferably solar cells, that incorporate one or more of the polymers according to the present invention as a photoactive layer can exhibit high performance in ambient conditions, for example, demonstrating one or more of low band-gap, high fill factor, high open circuit voltage, and high power conversion efficiency, and preferably all of these criteria. Similarly, other organic semiconductor-based devices such as organic light emitting transistors (OLETs) can be fabricated efficiently using polymers according to the present invention as organic semiconductor materials.

The present invention also provides methods for preparing such polymers and organic semiconductor materials, as well as various compositions, composites, and optoelectronic devices that incorporate the polymers and semiconductor materials according to the present invention.

The foregoing as well as other features and advantages of the present invention will be more fully understood from the following figures, description, examples, and claims.

It should be understood that the drawings in the present specification are for illustration purposes only. The drawings are not necessarily to scale, with emphasis generally being placed upon illustrating the principles of the present invention. The drawings are not intended to limit the scope of the present invention in any way.

## FIGURES

**Fig. 1** shows dark and light-on I-V curves for a solar battery based on polymers according to the present invention, especially for polymer **P3** and [60]PCBM that have been used in test devices.

## CONTINUATION OF THE DETAILED DESCRIPTION OF THE INVETION

The present invention provides polymers of formula (I') comprising at least one planar aromatic system in the repeating unit, the backbone, of formula (I).

Polymers of the present invention show semiconductor behavior, preferably an optimized light absorption property, a charge separation property or a charge carrier mobility property in optoelectronic devices, preferably in batteries

or in photovoltaic devices, especially preferred when used in combination with at least one fullerene compound. The polymers according to the present invention further show charge transport/recombination/light emission in light-emitting devices and/or high carrier mobility and/or good current modulation characteristics in field-effect devices, especially preferred when used in combination with at least one fullerene compound. In addition, the polymers according to the present invention can show certain processing advantages such as solution-processability and/or good stability, preferably air stability, in ambient conditions, especially preferred when used in combination with at least one fullerene compound. The polymers of the present invention can be used to prepare either p-type (donor or hole-transporting), n-type (acceptor or electron-transporting), or ambipolar semiconductor materials, which in turn can be used to fabricate various organic or hybrid optoelectronic articles, structures and devices, including organic photovoltaic devices and organic light-emitting transistors, especially preferred when used in combination with at least one fullerene compound.

Throughout the present specification, where compositions are described as having, including, or comprising specific components, or where processes are described as having, including, or comprising specific process steps, it is contemplated that compositions of the present invention also consist essentially of, or consist of, the recited components, and that the processes of the present invention also consist of, the recited process steps.

In the present specification, where an element or component is said to be included in and/or selected from a list of recited elements or components, it should be understood that the element or component can be any one of the recited elements or components, or the element or component can be selected from a group consisting of two or more of the recited elements or components. Further, it should be understood that elements and/or features of a composition, an apparatus, or a method described herein can be combined in a variety of ways without departing from the spirit and scope of the present invention, whether explicit or implicit herein.

The use of the terms "include", "includes", "including", "have", "has", or "having" should be generally understood as open-ended and non-limiting unless specifically stated otherwise.

The use of the singular herein includes the plural (and vice versa) unless specifically stated otherwise. In addition, where the use of the term "about" is before a quantitative value, the present invention also includes the specific quantitative value itself, unless specifically stated otherwise. As used herein, the term "about" refers to $\pm$ 10% variation from the nominal value unless otherwise indicated or inferred.

It should be understood that the order of steps or order for performing certain actions is immaterial so long as the present invention remains operable. Moreover, two or more steps or actions may be conducted simultaneously.

As used herein, a "p-type semiconductor material" or a "donor material" refers to a semiconductor material, preferably an organic semiconductor material, having holes as the majority current or charge carriers. In some embodiments, when a p-type semiconductor material is deposited on a substrate, it can provide a hole mobility in excess of about $10^{-5}$ $cm^2/Vs$. In the case of field-effect devices, a p-type semiconductor can also exhibit a current on/off ratio of greater than about 10.

As used herein, an "n-type semiconductor material" or an "acceptor material" refers to a semiconductor material, for example, an organic semiconductor material, having electrons as the majority current or charge carriers. In some embodiments, when an n-type semiconductor material is deposited on a substrate, it can provide an electron mobility in excess of about $10^{-5}$ $cm^2/Vs$. In the case of field-effect devices, an n-type semiconductor also can exhibit a current on/off ratio of greater than about 10.

As used herein, "mobility" refers to a measure of the velocity with which charge carriers, for example, holes (or units of positive charge) in the case of a p-type semiconductor material and electrons (or units of negative charge) in the case of an n-type semiconductor material, move through the material under the influence of an electric field. This parameter, which depends on the device architecture, can be measured using a field-effect device or space-charge limited current measurements or some other techniques like transient photocurrent measurements, CELIV (current extracted by linearly increased voltage) measurements.

As used herein, the power conversion efficiency (PCE) of a solar cell is the percentage of power converted from absorbed light to electrical energy. The PCE of a solar cell can be calculated by dividing the maximum power point ($P_m$) by the input light irradiance (E, in $w/m^2$) under standard test conditions (STC) and the surface area of the solar cell ($A_c$, in $m^2$). STC typically refers to a temperature of 25°C and an irradiance of 1000 $w/m^2$ with an air mass 1.5 (AM 1.5) spectrum.

As used herein, a component (such as a thin film layer) can be considered "photoactive" if it contains one or more compounds that can absorb photons to produce excitons for the generation of a photocurrent.

As used herein, "solution-processible" refers to compounds, preferably polymers, materials, or compositions that can be used in various solution-phase processes including spin-coating, printing, preferably inkjet printing, gravure printing, offset printing and the like, spray coating, electrospray coating, drop casting, dip coating, and blade coating.

As used herein, a "polymeric compound" or "polymer" refers to a molecule including a plurality of one or more repeating units connected by covalent chemical bonds. A polymer can be represented by the general formula:

$$*\text{-}(\text{-}M\text{-})_n\text{-}*$$

wherein M is the repeating unit or monomer and n is an integer indicating the number of repeating units. The polymer can have only one type of repeating unit as well as two or more types of different repeating units depending on the integer n. When a polymer has only one type of repeating unit, it can be referred to as a homopolymer.

When a polymer has two or more types of different repeating units, the term "copolymer" or "copolymeric compound" can be used instead. For example, a copolymer can include repeating units

$$*\text{-}(\text{-}M^a\text{-})_n\text{-}* \text{ and } *\text{-}(\text{-}M^b\text{-})_n\text{-}*,$$

where $M^a$ and $M^b$ represent two different repeating units and n is an integer indicating the number of repeating units.

Unless specified otherwise, the assembly of the repeating units in the copolymer can be head-to-tail, head-to-head, or tail-to-tail. In addition, unless specified otherwise, the copolymer can be a random copolymer, an alternating copolymer, or a block copolymer. For example, the general formula $*\text{-}(\text{-}M^a{}_x\text{-}M^b{}_y\text{-})_n\text{-}*$, can be used to represent a copolymer of $M^a$ and $M^b$ having x mole fraction of $M^a$ and y mole fraction of $M^b$ in the copolymer, where the manner in which comonomers $M^a$ and $M^b$ is repeated can be alternating, random, regiorandom, regioregular, or in blocks and n is an integer indicating the number of repeating units.

Consequently and in addition to its composition, a polymer can be further characterized by its degree of polymerization (n) and molar mass (e.g., number average molecular weight ($M_n$) and/or weight average molecular weight ($M_w$) depending on the measuring technique(s)).

As used herein, "halo" or "halogen" refers preferably to fluoro, chloro, bromo, and iodo, more preferred to chloro or bromo, most preferred to chloro.

As used herein, "oxo" refers to a double-bonded oxygen (i.e. =O).

As used herein, "alkyl" refers to a straight-chain or branched saturated hydrocarbon group. Preferred alkyl groups include methyl (Me), ethyl (Et), propyl (e.g., n-propyl and iso-propyl), butyl (e.g., n-butyl, iso-butyl, sec-butyl, tert-butyl), pentyl groups (e.g., n-pentyl, iso-pentyl, neo-pentyl), hexyl groups, and the like. In preferred embodiments an alkyl group has 1 to 40 carbon atoms (i.e., $C_{1-40}$ alkyl group), more preferred 1-20 carbon atoms (i.e., $C_{1-20}$ alkyl group). In some embodiments, an alkyl group can have 1 to 6 carbon atoms, and can be referred to as a "lower alkyl group." Most preferred lower alkyl groups include methyl, ethyl, propyl (e.g., n-propyl and iso-propyl), and butyl groups (e.g., n-butyl, iso-butyl, sec-butyl, tert-butyl). In some embodiments, alkyl groups can be substituted as described herein, preferably with halogen to form a haloalkyl group. An alkyl group is generally not substituted with another alkyl group, an alkenyl group, or an alkynyl group.

As used herein, "haloalkyl" refers to an alkyl group having one or more halogen substituents. Preferably a haloalkyl group has 1 to 40 carbon atoms (i.e., $C_{1-40}$haloalkyl group), more preferred 1 to 20 carbon atoms (i.e., $C_{1-20}$ haloalkyl group). Most preferred haloalkyl groups include $CF_3$, $C_2F_5$, $CHF_2$, $CH_2F$, $CCl_3$, $CHCl_2$, $CH_2Cl$, $C_2Cl_5$, and the like. Perhaloalkyl groups, i.e., alkyl groups where all of the hydrogen atoms are replaced with halogen atoms (e.g., $CF_3$ and $C_2F_5$), are included within the definition of "haloalkyl." Preferably a $C_{1-40}$haloalkyl group can have the formula $-C_sH_{2s+1-t}X^0{}_t$, where $X^0$, at each occurrence, is F, Cl, Br or I, "s" is an integer in the range of 1 to 40, and "t" is an integer in the range of 1 to 81, provided that t is less than or equal to 2s+1. Haloalkyl groups that are not perhaloalkyl groups can be substituted as described herein.

As used herein, "alkoxy" refers to an -O-alkyl group. Preferably alkoxy groups include, but are not limited to, methoxy, ethoxy, n-propoxy, iso-propoxy, t-butoxy, n-butoxy, iso-butoxy, pentoxy, hexoxy groups, and the like. The alkyl group in the -O-alkyl group can be substituted as described herein.

As used herein, "alkylthio" refers to an -S-alkyl group. Preferably alkylthio groups include, but are not limited to, methylthio, ethylthio, n-propylthio, iso-propylthio, t-butylthio, n-butylthio, isobutylthio, pentylthio, hexylthio groups, and the like. The alkyl group in the -S-alkyl group can be substituted as described herein.

As used herein, "alkenyl" refers to a straight-chain or branched alkyl group having one or more carbon-carbon double bonds. Preferably alkenyl groups include ethenyl, propenyl, butenyl, pentenyl, hexenyl, butadienyl, pentadienyl, hexadienyl groups, and the like. The one or more carbon-carbon double bonds can be internal (such as in 2-butene) or terminal (such as in 1-butene). In preferred embodiments, an alkenyl group has 2 to 40 carbon atoms (i.e., $C_{2-40}$ alkenyl group), more preferred 2 to 20 carbon atoms (i.e., $C_{2-20}$ alkenyl group). In some embodiments, alkenyl groups can be substituted as described herein. An alkenyl group is generally not substituted with another alkenyl group, an alkyl group, or an alkynyl group.

As used herein, "alkynyl" refers to a straight-chain or branched alkyl group having one or more triple carbon-carbon bonds. Preferably alkynyl groups include ethynyl, propynyl, butynyl, pentynyl, hexynyl, and the like. The one or

more triple carbon-carbon bonds can be internal (such as in 2-butyne) or terminal (such as in 1-butyne). Preferably an alkynyl group has 2 to 40 carbon atoms (i.e., $C_{2-40}$ alkynyl group), more preferred 2 to 20 carbon atoms (i.e., $C_{2-20}$ alkynyl group). In some embodiments, alkynyl groups can be substituted as described herein. An alkynyl group is generally not substituted with another alkynyl group, an alkyl group, or an alkenyl group.

As used herein, a "cyclic moiety" can include one or more (e.g., 1-6) carbocyclic or heterocyclic rings. Preferably the cyclic moiety is a cycloalkyl group, a heterocycloalkyl group, an aryl group, or a heteroaryl group (i.e., can include only saturated bonds, or can include one or more unsaturated bonds regardless of aromaticity), each including, preferably 3-24 ring atoms and optionally can be substituted as described herein. In embodiments where the cyclic moiety is a "monocyclic moiety," the "monocyclic moiety" can include a 3-14 membered aromatic or non-aromatic, carbocyclic or heterocyclic ring. A monocyclic moiety can include, preferably, a phenyl group or a 5- or 6-membered heteroaryl group, each of which optionally can be substituted as described herein. In embodiments where the cyclic moiety is a "polycyclic moiety," the "polycyclic moiety" can include two or more rings fused to each other (i.e., sharing a common bond) and/or connected to each other via a spiro atom, or one or more bridged atoms. A polycyclic moiety can include an 8-24 membered aromatic or non-aromatic, carbocyclic or heterocyclic ring, such as a $C_{8-24}$ aryl group or an 8-24 membered heteroaryl group, each of which optionally can be substituted as described herein.

As used herein, "cycloalkyl" refers to a non-aromatic carbocyclic group including cyclized alkyl, alkenyl, and alkynyl groups. Preferably cycloalkyl groups have 3 to 24 carbon atoms, more preferred 3 to 20 carbon atoms (e.g., $C_{3-14}$ cycloalkyl group). A cycloalkyl group can be monocyclic (e.g., cyclohexyl) or polycyclic (e.g., containing fused, bridged, and/or spiro ring systems), where the carbon atoms are located inside or outside of the ring system. Any suitable ring position of the cycloalkyl group can be covalently linked to the defined chemical structure. Preferred cycloalkyl groups include cyclopropyl, cyclobutyl, cyclopentyl, cyclohexyl, cycloheptyl, cyclopentenyl, cyclohexenyl, cyclohexadienyl, cycloheptatrienyl, norbornyl, norpinyl, norcaryl, adamantyl, and spiro[4.5]decanyl groups, as well as their homologs, isomers, and the like. In some embodiments, cycloalkyl groups can be substituted as described herein.

As used herein, "heteroatom" refers to an atom of any element other than carbon or hydrogen and is preferably nitrogen, oxygen, silicon, sulfur, phosphorus, and selenium.

As used herein, "cycloheteroalkyl" refers to a non-aromatic cycloalkyl group that contains at least one ring heteroatom selected from O, S, Se, N, P, and Si (e.g., O, S, and N), and optionally contains one or more double or triple bonds. Preferably a cycloheteroalkyl group has 3 to 24 ring atoms, more preferred 3 to 20 ring atoms (e.g., 3-14 membered cycloheteroalkyl group). One or more N, P, S, or Se atoms (e.g., N or S) in a cycloheteroalkyl ring may be oxidized (e.g., morpholine N-oxide, thiomorpholine S-oxide, thiomorpholine S,S-dioxide). In some embodiments, nitrogen or phosphorus atoms of cycloheteroalkyl groups can bear a substituent, for example, a hydrogen atom, an alkyl group, or other substituents as described herein. Cycloheteroalkyl groups can also contain one or more oxo groups, such as oxopiperidyl, oxooxazolidyl, dioxo-(1H,3H)-pyrimidyl, oxo-2(1H)-pyridyl, and the like. Preferred cycloheteroalkyl groups include, among others, morpholinyl, thiomorpholinyl, pyranyl, imidazolidinyl, imidazolinyl, oxazolidinyl, pyrazolidinyl, pyrazolinyl, pyrrolidinyl, pyrrolinyl, tetrahydrofuranyl, tetrahydrothiophenyl, piperidinyl, piperazinyl, and the like. In some embodiments, cycloheteroalkyl groups can be substituted as described herein.

As used herein, "aryl" refers to an aromatic monocyclic hydrocarbon ring system or a polycyclic ring system in which two or more aromatic hydrocarbon rings are fused (i.e., having a bond in common with) together or at least one aromatic monocyclic hydrocarbon ring is fused to one or more cycloalkyl and/or cycloheteroalkyl rings. Preferably an aryl group has 6 to 24 carbon atoms in its ring system (e.g., $C_{6-20}$ aryl group), which can include multiple fused rings. In some embodiments, a polycyclic aryl group can have 8 to 24 carbon atoms. Any suitable ring position of the aryl group can be covalently linked to the defined chemical structure. Preferred aryl groups having only aromatic carbocyclic ring(s) include phenyl, 1-naphthyl (bicyclic), 2-naphthyl (bicyclic), anthracenyl (tricyclic), phenanthrenyl (tricyclic), pentacenyl (pentacyclic), and like groups. Preferred polycyclic ring systems in which at least one aromatic carbocyclic ring is fused to one or more cycloalkyl and/or cycloheteroalkyl rings include, among others, benzo derivatives of cyclopentane (i.e., an indanyl group, which is a 5,6-bicyclic cycloalkyl/aromatic ring system), cyclohexane (i.e., a tetrahydronaphthyl group, which is a 6,6-bicyclic cycloalkyl/aromatic ring system), imidazoline (i.e., a benzimidazolinyl group, which is a 5,6-bicyclic cycloheteroalkyl/aromatic ring system), and pyran (i.e., a chromenyl group, which is a 6,6-bicyclic cycloheteroalkyl/aromatic ring system). Other preferred aryl groups include benzodioxanyl, benzodioxolyl, chromanyl, indolinyl groups, and the like. In some embodiments, aryl groups can be substituted as described herein. In some embodiments, an aryl group can have one or more halogen substituents, and can be referred to as a "haloaryl" group. Perhaloaryl groups, i.e., aryl groups where all of the hydrogen atoms are replaced with halogen atoms (e.g., $-C_6F_5$), are included within the definition of "haloaryl." In certain embodiments, an aryl group is substituted with another aryl group and can be referred to as a biaryl group. Each of the aryl groups in the biaryl group can be substituted as disclosed herein.

A used herein "arylene" refers to a divalent aromatic monocyclic hydrocarbon ring system or a polycyclic ring system in which two or more aromatic hydrocarbon rings are fused (i.e., having a bond in common with) together or at least one aromatic monocyclic hydrocarbon ring is fused to one or more cycloalkyl and/or cycloheteroalkyl rings. Preferably an arylene group has 6 to 24 carbon atoms in its ring system (e.g., $C_{6-20}$ aryl group), which can include multiple

fused rings. In some embodiments, a polycyclic arylene group can have 8 to 24 carbon atoms. Any suitable ring position of the arylene group can be covalently linked to the defined chemical structure. Preferred divalent arylene groups having only aromatic carbocyclic ring(s) are listed in the "aryl" section of the present specification.

As used herein, "arylalkyl" refers to an -alkyl-aryl group, where the arylalkyl group is covalently linked to the defined chemical structure via the alkyl group. An arylalkyl group is within the definition of a -Y-$C_{6-14}$ aryl group, where Y is represented by $C_1$-$C_{10}$ aliphatic chain such as $-(CH_2)_n-$ , and n =1-10. A preferred arylalkyl group is a benzyl group ($-CH_2-C_6H_5$). An arylalkyl group can be optionally substituted, i.e., the aryl group and/or the alkyl group, can be substituted as disclosed herein.

As used herein, "heteroaryl" refers to an aromatic monocyclic ring system containing at least one ring heteroatom selected from oxygen (O), nitrogen (N), sulfur (S), silicon (Si), and selenium (Se) or a polycyclic ring system where at least one of the rings present in the ring system is aromatic and contains at least one ring heteroatom. Polycyclic heteroaryl groups include those having two or more heteroaryl rings fused together, as well as those having at least one monocyclic heteroaryl ring fused to one or more aromatic carbocyclic rings, non-aromatic carbocyclic rings, and/or non-aromatic cycloheteroalkyl rings. A heteroaryl group, as a whole, has preferably 5 to 24 ring atoms and contains 1-5 ring heteroatoms (i.e., 5-20 membered heteroaryl group). The heteroaryl group can be attached to the defined chemical structure at any heteroatom or carbon atom that results in a stable structure. Generally, heteroaryl rings do not contain O-O, S-S, or S-O bonds. However, one or more N or S atoms in a heteroaryl group can be oxidized (e.g., pyridine N-oxide, thiophene S-oxide, thiophene S,S-dioxide). Preferred heteroaryl groups include the 5- or 6-membered monocyclic and 5-6 bicyclic ring systems shown below:

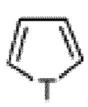 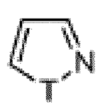 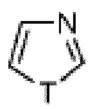 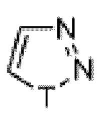 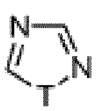 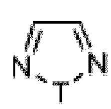 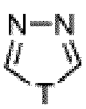 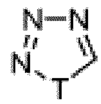

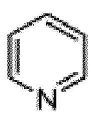 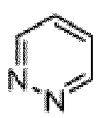 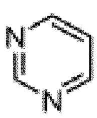 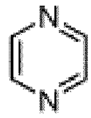 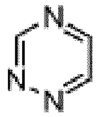 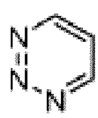

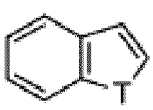 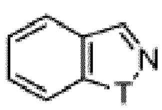 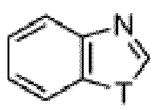 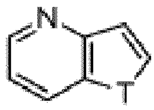 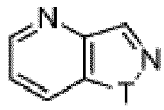 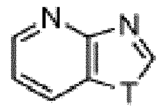

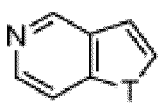 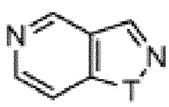 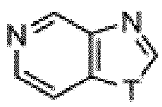 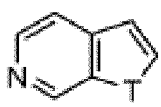 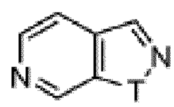 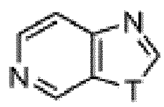

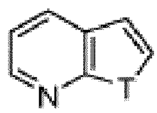 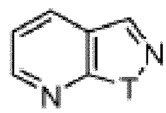 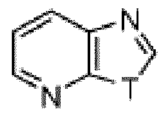

wherein T is O, S, NH, N-alkyl, N-aryl, N-(arylalkyl) (e.g., N-benzyl), $SiH_2$, SiH(alkyl), $Si(alkyl)_2$, SiH(arylalkyl), $Si(arylalkyl)_2$, or Si(alkyl)(arylalkyl). More preferred heteroaryl rings include pyrrolyl, furyl, thienyl, pyridyl, pyrimidyl, pyridazinyl, pyrazinyl, triazolyl, tetrazolyl, pyrazolyl, imidazolyl, isothiazolyl, thiazolyl, thiadiazolyl, isoxazolyl, oxazolyl, oxadiazolyl, indolyl, isoindolyl, benzofuryl, benzothienyl, quinolyl, 2-methylquinolyl, isoquinolyl, quinoxalyl, quinazolyl, benzotriazolyl, benzimidazolyl, benzothiazolyl, benzisothiazolyl, benzisoxazolyl, benzoxadiazolyl, benzoxazolyl, cinnolinyl, 1H-indazolyl, 2H-indazolyl, indolizinyl, isobenzofuryl, naphthyridinyl, phthalazinyl, pteridinyl, purinyl, oxazolopyridinyl, thiazolopyridinyl, imidazopyridinyl, furopyridinyl, thienopyridinyl, pyridopyrimidinyl, pyridopyrazinyl, pyridopyridazinyl, thienothiazolyl, thienoxazolyl, thienoimidazolyl groups, and the like. Further preferred heteroaryl groups include 4,5,6,7- tetrahydroindolyl, tetrahydroquinolinyl, benzothienopyridinyl, benzofuropyridinyl groups, and the like. In some embodiments, heteroaryl groups can be substituted as described herein.

In contrast to monovalent groups polymers of the present invention can include a "divalent group" defined herein as a linking group capable of forming a covalent bond with two other moieties. For example, polymers of the present invention can include a divalent $C_{1-20}$ alkyl group (e.g., a methylene group), a divalent $C_{2-20}$ alkenyl group (e.g., a vinylyl group), a divalent $C_{2-20}$ alkynyl group (e.g., an ethynylyl group). a divalent $C_{6-14}$ aryl group (e.g., a phenylyl

group); a divalent 3-14 membered cycloheteroalkyl group (e.g., a pyrrolidylyl), and/or a divalent 5-14 membered heteroaryl group (e.g., a thienylyl group). Generally, a chemical group (e.g., -Ar-) is understood to be divalent by the inclusion of the two bonds before and after the group.

The electron-donating or electron-withdrawing properties of several hundred of the most common substituents, reflecting all common classes of substituents having been determined, quantified, and published. The most common quantification of electron-donating and electron-withdrawing properties is in terms of Hammett $\sigma$ values. Hydrogen has a Hammett $\sigma$ value of zero, while other substituents have Hammett $\sigma$ values that increase positively or negatively in direct relation to their electron-withdrawing or electron-donating characteristics. Substituents with negative Hammett $\sigma$ values are considered electron donating, while those with positive Hammett $\sigma$ values are considered electron-withdrawing. See Lange's Handbook of Chemistry, 12th ed., McGraw Hill, 1979, Table 3-12, pp. 3-134 to 3-138, which lists Hammett $\sigma$ values for a large number of commonly encountered substituents and is incorporated by reference herein or see *http://de.wikipedia.org/wiki/Hammett-Gleichung.*

It should be understood that the term "electron-accepting group" can be used synonymously herein with "electron acceptor" and "electron-withdrawing group". In particular, an "electron-withdrawing group" ("EWG") or an "electron-accepting group" or an "electron-acceptor" refers to a functional group that draws electrons to itself more than a hydrogen atom would do if it occupies the same position in a molecule. Preferred electron withdrawing groups include, but are not limited to, halogen or halo (e.g., F, Cl, Br, I), $-NO_2$, -CN, -NC, $-S(R^0)_2^+$, $-N(R^0)_3^+$, $-SO_3H$, $-SO_2R^0$, $-SO_3R^0$, $-SO_2NHR^0$, $-SO_2N(R^0)_2$, -COOH, $-COR^0$, $-COOR^0$, $-CONHR^0$, $-CON(R^0)_2$, $C_{1-40}$ haloalkyl groups, $C_{6-14}$ aryl groups, and 5-14 membered electron-poor heteroaryl groups; where $R^0$ is a $C_{1-20}$alkyl group, a $C_{2-20}$ alkenyl group, a $C_{2-20}$ alkynyl group, a $C_{1-20}$ haloalkyl group, a $C_{1-20}$ alkoxy group, a $C_{6-14}$ aryl group, a $C_{3-14}$ cycloalkyl group, a 3-14 membered cycloheteroalkyl group, and a 5-14 membered heteroaryl group, each of which can be optionally substituted as described herein. For example, each of the $C_{1-20}$ alkyl group, the $C_{2-20}$ alkenyl group, the $C_{2-20}$ alkynyl group, the $C_{1-20}$ haloalkyl group, the $C_{1-20}$ alkoxy group, the $C_{6-14}$ aryl group, the $C_{3-14}$ cycloalkyl group, the 3-14 membered cycloheteroalkyl group, and the 5-14 membered heteroaryl group can be optionally substituted with 1-5 small electron-withdrawing groups such as F, Cl, Br, $-NO_2$, -CN, -NC, $-S(R^0)_2^+$, $-N(R^0)_3^+$, $-SO_3H$, $-SO_2R^0$, $-SO_3R^0$, $-SO_2NHR^0$, $-SO_2N(R^0)_2$, -COOH, $-COR^0$, $-COOR^0$,$-CONHR^0$, and $-CON(R°)_2$.

It should be understood that the term "electron-donating group" can be used synonymously herein with "electron donor". In particular, an "electron-donating group" or an "electron-donor" refers to a functional group that donates electrons to a neighboring atom more than a hydrogen atom would if it occupied the same position in a molecule. Preferred electron-donating groups include -OH, $-OR^0$, $-NH_2$, $-NHR^0$, $-N(R^0)_2$, and 5-14 membered electron-rich heteroaryl groups, where $R^0$ is a $C_{1-20}$ alkyl group, a $C_{2-20}$ alkenyl group, a $C_{2-20}$ alkynyl group, a $C_{6-14}$ aryl group, or a $C_{3-14}$ cycloalkyl group.

Various unsubstituted heteroaryl groups can be described as electron-rich (or $\pi$-excessive) or electron-poor (or $\pi$-deficient). Such classification is based on the average electron density on each ring atom as compared to that of a carbon atom in benzene. Examples of electron-rich systems include 5-membered heteroaryl groups having one heteroatom such as furan, pyrrole, and thiophene; and their benzofused counterparts such as benzofuran, benzopyrrole, and benzothiophene. Examples of electron-poor systems include 6-membered heteroaryl groups having one or more heteroatoms such as pyridine, pyrazine, pyridazine, and pyrimidine; as well as their benzofused counterparts such as quinoline, isoquinoline, quinoxaline, cinnoline, phthalazine, naphthyridine, quinazoline, phenanthridine, acridine, and purine. Mixed heteroaromatic rings can belong to either class depending on the type, number, and position of the one or more heteroatom(s) in the ring. *See* Katritzky, A.R and Lagowski, J.M., Heterocyclic Chemistry (John Wiley & Sons, New York, 1960).

At various places in the present specification, substituents are disclosed in groups or in ranges. It is specifically intended that the description includes each and every individual subcombination of the members of such groups and ranges. For example, the term "$C_{1-6}$ alkyl" is specifically intended to individually disclose $C_1$, $C_2$, $C_3$, $C_4$, $C_5$, $C_6$, $C_1$-$C_6$, $C_1$-$C_5$, $C_1$-$C_4$, $C_1$-$C_3$, $C_1$-$C_2$, $C_2$-$C_6$, $C_2$-$C_5$, $C_2$-$C_4$, $C_2$-$C_3$, $C_3$-$C_6$, $C_3$-$C_5$, $C_3$-$C_4$, $C_4$-$C_6$, $C_4$-$C_5$, and $C_5$-$C_6$ alkyl. By way of other examples, an integer in the range of 0 to 40 is specifically intended to individually disclose 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, and 40, and an integer in the range of 1 to 20 is specifically intended to individually disclose 1, 2, 3, 4, 5, 6, 7, 8, 9, 10, 11, 12, 13, 14, 15, 16, 17, 18, 19, and 20. The phrase "optionally substituted with 1-5 substituents" is specifically intended to individually disclose a chemical group that can include 0, 1, 2, 3, 4, 5, 0-5, 0-4, 0-3, 0-2, 0-1, 1-5, 1-4, 1-3, 1-2, 2-5, 2-4 ,2-3, 3-5, 3-4, and 4-5 substituents.

Polymers described herein can contain an asymmetric atom (also referred as a chiral center) and some of the polymers can contain two or more asymmetric atoms or centers, which can thus give rise to optical isomers (enantiomers) and geometric isomers (diastereomers). The present invention includes such optical and geometric isomers, including their respective resolved enantiomerically or diastereomerically pure isomers (e.g., (+) or (-) stereoisomer) and their racemic mixtures, as well as other mixtures of the enantiomers and diastereomers. In some embodiments, optical isomers can be obtained in enantiomerically enriched or pure form by standard procedures known to those skilled in the art, which include, for example, chiral separation, diastereomeric salt formation, kinetic resolution, and asymmetric synthesis.

The present invention also encompasses cis- and trans-isomers of polymers containing alkenyl moieties (e.g., alkenes, azo compounds, and imines). It also should be understood that the polymers of the present invention encompass all possible regioisomers in pure form and mixtures thereof. In some embodiments, the preparation of the present polymers can include separating such isomers using standard separation procedures known to those skilled in the art, for example, by using one or more of column chromatography, thin-layer chromatography, simulated moving-bed chromatography, and high-performance liquid chromatography. However, mixtures of regioisomers can be used similarly to the uses of each individual regioisomer of the present invention as described herein and/or known by a skilled artisan.

It is specifically contemplated that the depiction of one regioisomer includes any other regioisomers and any regioisomeric mixtures unless specifically stated otherwise.

Throughout the specification, structures may or may not be presented with chemical names. Where any question arises as to nomenclature, the structure prevails.

The present invention relates to polymers that can be used as organic semiconductor materials. The polymers according to the present invention can have good solubility in various common solvents and good stability in air. When incorporated into optical or optoelectronic devices including, but not limited to, photovoltaic cells or solar cells, light emitting diodes, and light emitting transistors, the polymers according to the present invention can confer various desirable performance properties. For example, when the polymers of formula (I') are used in a photoactive layer of a solar cell (e.g., bulk heterojunction devices), the solar cell can exhibit very high power conversion efficiency (e.g., about 3.0% or greater).

The present invention provides polymers of formula (I') having at least one repeating unit of formula (I) that includes a planar aromatic ring system that is substituted at least with two electron-withdrawing groups, thereby providing a strong acceptor moiety. In a preferred embodiment the electron-poor polycyclic heteroaryl group is a bicyclic heteroaryl group that includes one or more nitrogen atoms. In another preferred embodiment, the electron-poor polycyclic heteroaryl group is a benzo-fused bicyclic heteroaryl group that includes one or more nitrogen atoms. In another preferred embodiment, the electron-poor polycyclic heteroaryl group is a pyrido-fused bicyclic heteroaryl group that includes two or more nitrogen atoms. Preferred electron-withdrawing groups are selected from the substituents F, Cl, CN, an acyl group, or a haloalkyl group.

Preferably an alkyl group may be linear or branched, and may also be a cycloalkyl group. Preferably the alkyl group has a carbon atom number of usually 1 to 20. More preferred the alkyl group is selected from the group of a methyl group, an ethyl group, a n-propyl group, an i-propyl group, a n-butyl group, an i-butyl group, a t-butyl group, a s-butyl group, a 3-methylbutyl group, a n-pentyl group, a n-hexyl group, a 2-ethylhexyl group, a n-heptyl group, a n-octyl group, a n-nonyl group, a n-decyl group, a 3,7-dimethyloctyl group and a n-lauryl group. A hydrogen atom in the above-described alkyl group is optionally substituted by a fluorine atom. The alkyl group substituted by a fluorine atom is preferably a trifluoromethyl group, a pentafluoroethyl group, a perfluorobutyl group, a perfluorohexyl group, a perfluorooctyl group and the like.

Preferably an alkoxy group may be linear or branched, and may also be a cycloalkyloxy group. Preferably the alkoxy group has a carbon atom number of usually 1 to 20. More preferred the alkoxy group is selected from the group of a methoxy group, an ethoxy group, a propyloxy group, an i-propyloxy group, a n-butoxy group, an i-butoxy group, a s-butoxy group, a t-butoxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group or a n-lauryloxy group. A hydrogen atom in the above-described alkoxy group is optionally substituted by a fluorine atom. The alkoxy group substituted by a fluorine atom is preferably a trifluoromethoxy group, a pentafluoroethoxy group, a perfluorobutoxy group, a perfluorohexyloxy group, a perfluorooctyloxy group and the like.

Preferably an alkylthio group may be linear or branched, and may also be a cycloalkylthio group. Preferably the alkylthio group has a carbon atom number of usually 1 to 20. More preferred the alkylthio group is selected from the group of a methylthio group, an ethylthio group, a n-propylthio group, an isopropylthio group, a n-butylthio group, an isobutylthio group, a s-butylthio group, a t-butylthio group, a n-pentylthio group, a n-hexylthio group, a cyclohexylthio group, a n-heptylthio group, a n-octylthio group, a 2-ethylhexylthio group, a n-nonylthio group, a n-decylthio group, a 3,7-dimethyloctylthio group or a n-laurylthio group. A hydrogen atom in the above-described alkylthio group is optionally substituted by a fluorine atom. The alkylthio group substituted by a fluorine atom is preferably a trifluoromethylthio group and the like.

Preferably an aryl group means an atomic group obtained by removing one hydrogen atom from an aromatic hydrocarbon, and includes also those having a condensed ring, and those having two or more independent benzene rings or condensed rings or two or more of both the rings, bonded directly or via a vinylene group or the like. The aryl group preferably has a carbon atom number of usually 6 to 60, more preferably 6 to 48. The above-described aryl group optionally has a substituent. This substituent includes linear or branched alkyl groups having a carbon atom number of 1 to 20, cycloalkyl groups having a carbon atom number of 3 to 20, alkoxy groups containing the alkyl group or the cycloalkyl group in its structure, groups represented by the formula (IV), and the like,

$$-O-(CH_2)_{gl}-O(CH_2)_{hl}-CH_3 \qquad (IV)$$

wherein gl represents an integer of from 1 to 6, and hl represents an integer of from 0 to 5.

Preferred aryl groups are selected from the group of a phenyl group, $C_1$ to $C_{12}$ alkoxyphenyl groups ($C_1$ to $C_{12}$ means that the carbon atom number thereof is 1 to 12; the same shall apply hereinafter), $C_1$ to $C_{12}$ alkylphenyl groups, a 1-naphthyl group, a 2-naphthyl group, a 1-anthracenyl group, a 2-anthracenyl group, a 9-anthracenyl group, a pentafluorophenyl group and the like. More preferred are $C_1$ to $C_{12}$ alkoxyphenyl groups and $C_1$ to $C_{12}$ alkylphenyl groups. The $C_1$ to $C_{12}$ alkoxyphenyl group preferably includes a methoxyphenyl group, an ethoxyphenyl group, a n-propyloxyphenyl group, an isopropyloxyphenyl group, a n-butoxyphenyl group, an isobutoxyphenyl group, a s-butoxyphenyl group, a t-butoxyphenyl group, a n-pentyloxyphenyl group, a n-hexyloxyphenyl group, a cyclohexyloxyphenyl group, a n-heptyloxyphenyl group, a n-octyloxyphenyl group, a 2-ethylhexyloxyphenyl group, a n-nonyloxyphenyl group, a n-decyloxyphenyl group, a 3,7-dimethyloctyloxyphenyl group and a n-lauryloxyphenyl group. The $C_1$ to $C_{12}$ alkylphenyl group preferably includes a methylphenyl group, an ethylphenyl group, a dimethylphenyl group, a n-propylphenyl group, a mesityl group, a methylethylphenyl group, an isopropylphenyl group, a n-butylphenyl group, an isobutylphenyl group, a s-butylphenyl group, a t-butylphenyl group, a n-pentylphenyl group, an isoamylphenyl group, a n-hexylphenyl group, a n-heptylphenyl group, a n-octylphenyl group, a n-nonylphenyl group, a n-decylphenyl group, a n-dodecylphenyl group, and the like. A hydrogen atom in the above-described aryl group is optionally substituted by a fluorine atom.

Preferably an aryloxy group has a carbon atom number of 6 to 60, more preferably of 6 to 48. Preferred aryloxy groups are those selected from the group of a phenoxy group, $C_1$ to $C_{12}$ alkoxyphenoxy groups, $C_1$ to $C_{12}$ alkylphenoxy groups, a 1-naphthyloxy group, a 2-naphthyloxy group, a pentafluorophenyloxy group and the like. More preferred are $C_1$ to $C_{12}$ alkoxyphenoxy groups and $C_1$ to $C_{12}$ alkylphenoxy groups. The $C_1$ to $C_{12}$ alkoxy is preferably selected from the group of methoxy, ethoxy, n-propyloxy, isopropyloxy, n-butoxy, isobutoxy, s-butoxy, t-butoxy, n-pentyloxy, n-hexyloxy, cyclohexyloxy, n-heptyloxy, n-octyloxy, 2-ethylhexyloxy, n-nonyloxy, n-decyloxy, 3,7-dimethyloctyloxy and n-lauryloxy. The $C_1$ to $C_{12}$ alkylphenoxy group is preferably selected from the group of a methylphenoxy group, an ethylphenoxy group, a dimethylphenoxy group, a n-propylphenoxy group, a 1,3,5-trimethylphenoxy group, a methylethylphenoxy group, an isopropylphenoxy group, a n-butylphenoxy group, an isobutylphenoxy group, a s-butylphenoxy group, a t-butylphenoxy group, a n-pentylphenoxy group, an isoamylphenoxy group, a n-hexylphenoxy group, a n-heptylphenoxy group, a n-octylphenoxy group, a n-nonylphenoxy group, a n-decylphenoxy group, a n-dodecylphenoxy group and the like.

Preferably an arylthio group optionally has a substituent on an aromatic ring, and preferably has a carbon atom number of 6 to 60. The arylthio group is preferably selected from the group of a phenylthio group, $C_1$ to $C_{12}$ alkoxyphenylthio group, $C_1$ to $C_{12}$ alkylphenylthio group, a 1-naphthylthio group, a 2-naphthylthio group, a pentafluorophenylthio group, a pyridylthio group, a pyridazinylthio group, a pyrimidylthio group, a pyrazylthio group and a triazylthio group.

Preferably an arylalkyl group optionally has a substituent, and preferably has a carbon atom number of 7 to 60. The arylalkyl group is preferably selected from the group of phenyl-$C_1$ to $C_{12}$-alkyl groups, $C_1$ to $C_{12}$-alkoxyphenyl-$C_1$ to $C_{12}$ -alkyl groups, $C_1$ to $C_{12}$-alkylphenyl-$C_1$ to $C_{12}$-alkyl groups, 1-naphthyl-$C_1$ to $C_{12}$-alkyl groups and 2-naphthyl-$C_1$ to $C_{12}$-alkyl groups.

Preferably an arylalkoxy group optionally has a substituent, and preferably has a carbon atom number of 7 to 60. The aylalkoxy group is preferably selected from the group of phenyl-$C_1$ to $C_{12}$-alkoxy groups, $C_1$ to $C_{12}$-alkoxyphenyl-$C_1$ to $C_{12}$-alkoxy groups, $C_1$ to $C_{12}$-alkylphenyl-$C_1$ to $C_{12}$-alkoxy groups, 1-naphthyl-$C_1$ to $C_{12}$-alkoxy groups and 2-naphthyl-$C_1$ to $C_{12}$-alkoxy groups.

Preferably an arylalkylthio group optionally has a substituent, and preferably has a carbon atom number of 7 to 60. The arylalkylthio group is selected from the group of phenyl-$C_1$ to $C_{12}$-alkylthio groups, $C_1$ to $C_{12}$-alkoxyphenyl-$C_1$ to $C_{12}$-alkylthio groups, $C_1$ to $C_{12}$-alkylphenyl-$C_1$ to $C_{12}$-alkylthio groups, 1-naphthyl-$C_1$ to $C_{12}$-alkylthio groups and 2-naphthyl-$C_1$ to $C_{12}$-alkylthio groups.

Preferably an arylalkenyl group has a carbon atom number of 8 to 60. The arylalkenyl group is preferably selected from the group of phenyl-$C_2$ to $C_{12}$-alkenyl groups, $C_1$ to $C_{12}$-alkoxyphenyl-$C_2$ to $C_{12}$-alkenyl groups, $C_1$ to $C_{12}$-alkylphenyl-$C_2$ to $C_{12}$-alkenyl groups, 1-naphthyl-$C_2$ to $C_{12}$-alkenyl groups and 2-naphthyl-$C_2$ to $C_{12}$-alkenyl groups, and more preferred are $C_1$ to $C_{12}$-alkoxyphenyl-$C_2$ to $C_{12}$-alkenyl groups and $C_1$ to $C_{12}$-alkylphenyl-$C_2$ to $C_{12}$-alkenyl groups, 1-naphtyl-$C_2$ to $C_{12}$-alkenyl groups and 2-naphtyl-$C_2$ to $C_{12}$-alkenyl groups, and most preferred are $C_1$ to $C_{12}$-alkoxyphenyl-$C_2$ to $C_{12}$-alkenyl groups and $C_1$ to $C_{12}$-alkylphenyl-$C_2$ to $C_{12}$-alkenyl groups.

Preferably an arylalkynyl group has a carbon atom number of 8 to 60. The arylalkynyl group is preferably selected from the group of phenyl-$C_2$ to $C_{12}$-alkynyl groups, $C_1$ to $C_{12}$-alkoxyphenyl-$C_2$ to $C_{12}$-alkynyl groups, $C_1$ to $C_{12}$-alkylphenyl-$C_2$ to $C_{12}$-alkynyl groups, 1-naphthyl-$C_2$ to $C_{12}$-alkynyl groups and 2-naphthyl-$C_2$ to $C_{12}$-alkynyl groups, and more preferred are $C_{12}$ to $C_{12}$-alkoxyphenyl-$C_2$ to $C_{12}$-alkynyl groups and $C_1$ to $C_{12}$-alkylphenyl-$C_2$ to $C_{12}$-alkynyl groups.

Preferably a monovalent heterocyclic group means an atomic group remaining after removing one hydrogen atom from a heterocyclic compound. The monovalent heterocyclic group has preferably a carbon atom number of 4 to 60, more preferred of 4 to 20. The carbon atom number of the monovalent heterocyclic group does not include the carbon

atom number of the substituent. The above-described heterocyclic compound means an organic compound having a cyclic structure in which elements constituting the ring include not only a carbon atom, but also a hetero atom selected from the group of oxygen, sulfur, nitrogen, phosphorus, boron, silicon and the like contained in the ring. Preferred monovalent heterocyclic groups are selected from the group of a thienyl group, $C_1$ to $C_{12}$-alkylthienyl groups, a pyrrolyl group, a furyl group, a pyridyl group, $C_1$ to $C_{12}$-alkylpyridyl groups, a piperidyl group, a quinolyl group and an isoquinolyl group. More preferred are a thienyl group, a $C_1$ to $C_{12}$-aklthienyl group, a pyridyl group and a $C_1$ to $C_{12}$-alkylpyridyl group. Of the monovalent heterocyclic groups, monovalent aromatic heterocyclic groups are preferable. Preferably a heterocyclic thio group means a group obtained by substituting a hydrogen atom of a mercapto group by a monovalent heterocyclic group. The heterocyclic thio group includes hetero arylthio groups, preferably a pyridylthio group, a pyridazinylthio group, a pyrimidylthio group, a pyrazinylthio group, a triazinylthio group and the like.

Preferably an amide group has a carbon atom number of 2 to 20, more preferred of 2 to 18. Preferred amide groups are selected from the group of a formamide group, an acetamide group, a propionamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group and a dipentafluorobenzamide group.

Preferably an acid imide group includes residues obtained by removing from an acid imide one hydrogen atom connected to its nitrogen atom, and has a carbon atom number preferably of 4 to 20. Preferred acid imide groups are selected from the groups shown below:

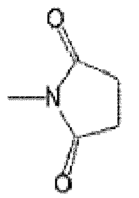
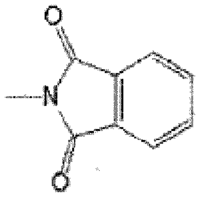
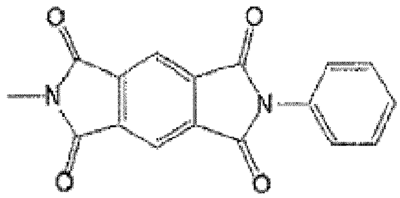

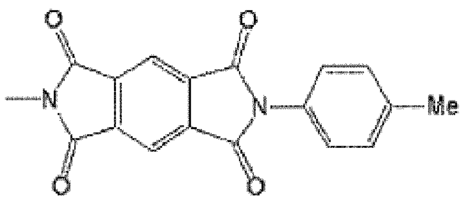
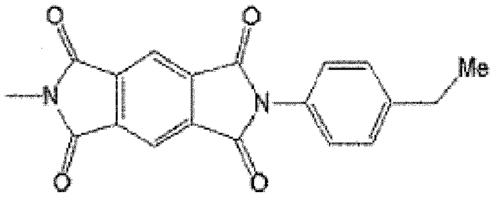

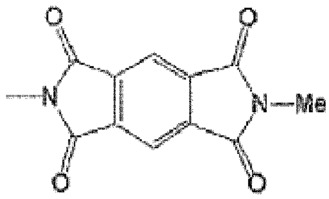
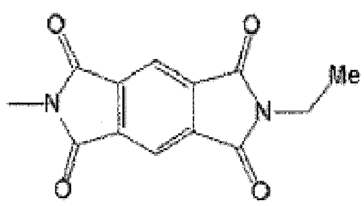
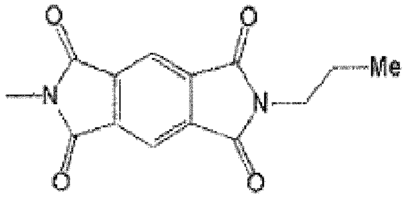

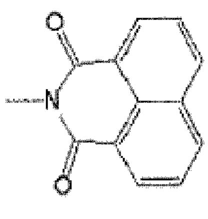
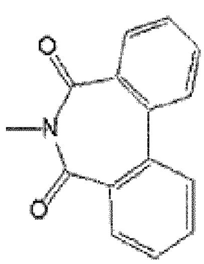

Preferably a substituted carboxyl group includes carboxyl groups substituted by an alkyl group, an aryl group, an arylalkyl group or a monovalent heterocyclic group. The above-described alkyl group, aryl group, arylalkyl group and monovalent heterocyclic group optionally have a substituent. The substituted carboxyl group has preferably a carbon atom number of 2 to 60, more preferred of 2 to 48. The carbon atom number of the substituted carboxyl group does not include the carbon atom number of the substituent. Preferred substituted carboxyl groups are selected from the group

of a methoxycarbonyl group, an ethoxycarbonyl group, a n-propoxycarbonyl group, an isopropoxycarbonyl group, a n-butoxycarbonyl group, an isobutoxycarbonyl group, a t-butoxycarbonyl group, a n-pentyloxycarbonyl group, a n-hexyloxycarbonyl group, a cyclohexyloxycarbonyl group, a n-heptyloxycarbonyl group, a n-octyloxycarbonyl group, a 2-ethylhexyloxycarbonyl group, a n-nonyloxycarbonyl group, a n-decyloxycarbonyl group, a 3,7-dimethyloctyloxycarbonyl group, a n-dodecyloxycarbonyl group, a trifluoromethoxycarbonyl group, a pentafluoroethoxycarbonyl group, a perfluorobutoxycarbonyl group, a per-fluorohexyloxycarbonyl group, a perfluorooctyloxycarbonyl group, a phenoxycarbonyl group, a naphthoxycarbonyl group and a pyridyloxycarbonyl group.

In a preferred embodiment the present invention refers to $Ar^1$ or $Ar^2$ in formula (I') wherein the divalent arylene units are those selected from the group

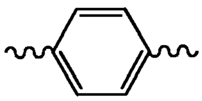
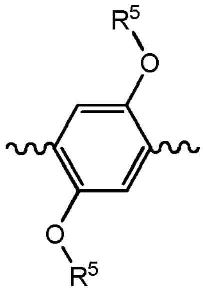
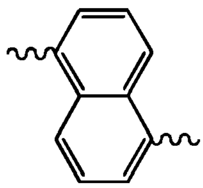
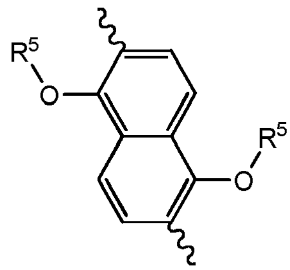
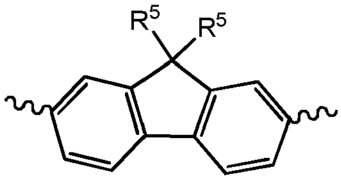
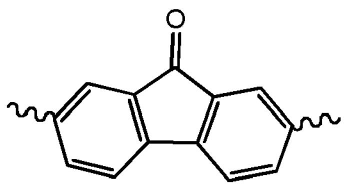
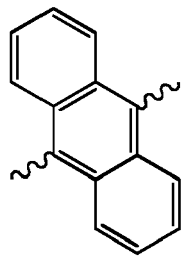
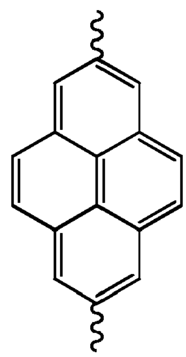
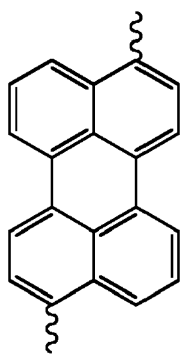

wherein $R^5$ represents a hydrogen atom or a $C_1$-$C_{20}$ alkyl chain.

In another preferred embodiment the present invention refers to $Ar^1$ or $Ar^2$ in formula (I') wherein the divalent heterocyclic groups are those selected from heterocycles from the group

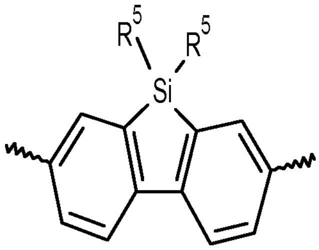
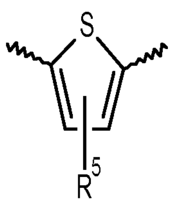
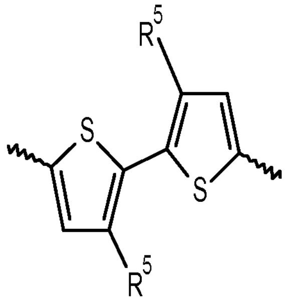
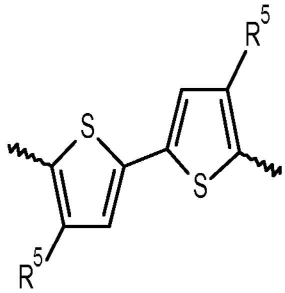

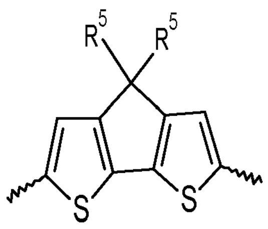

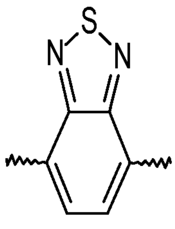

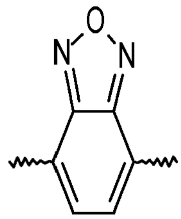

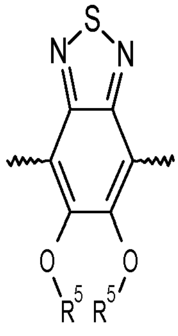

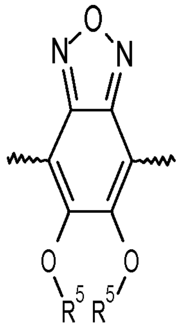

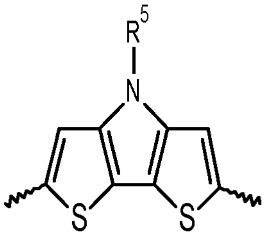

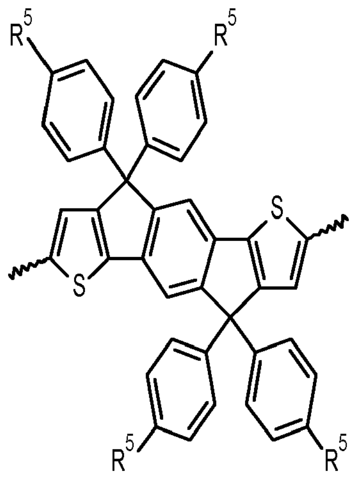

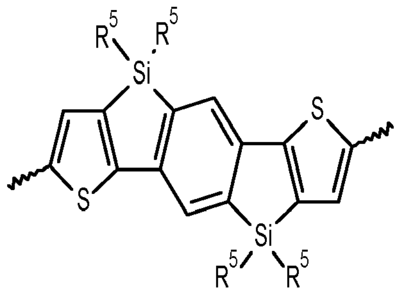

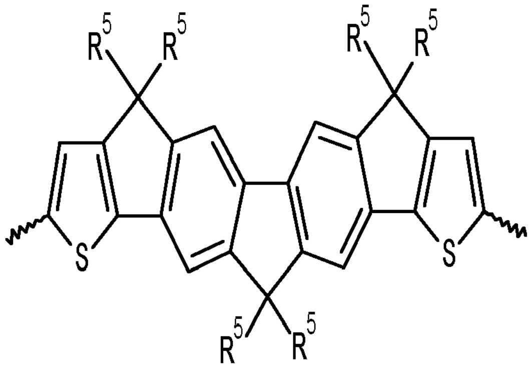

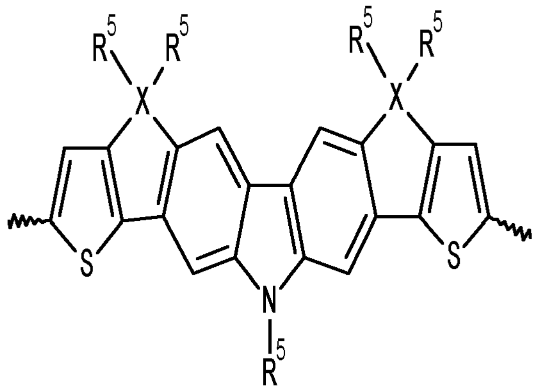

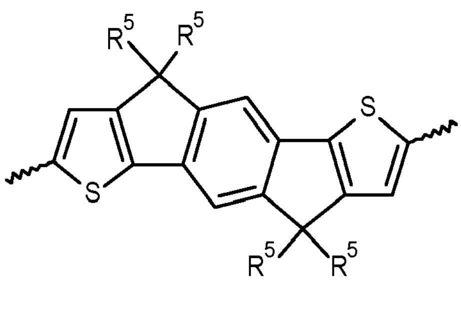

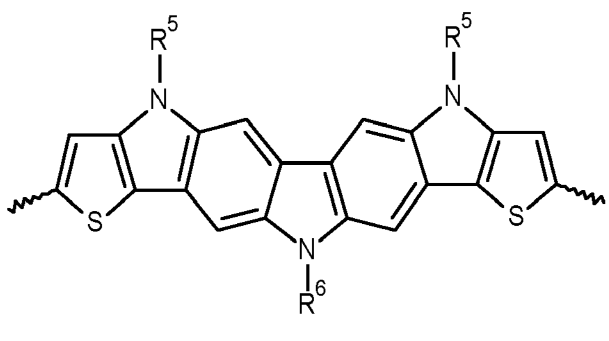

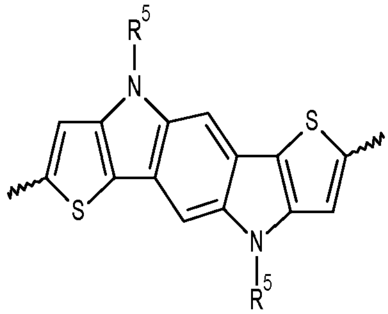

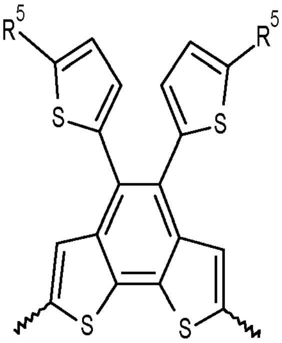

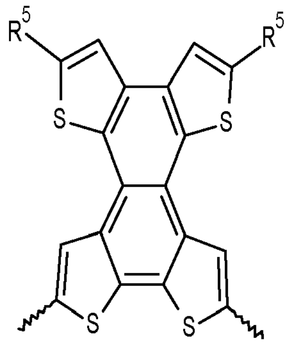

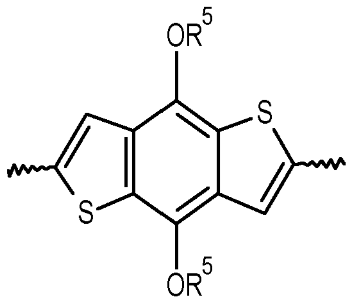

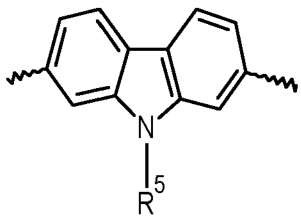

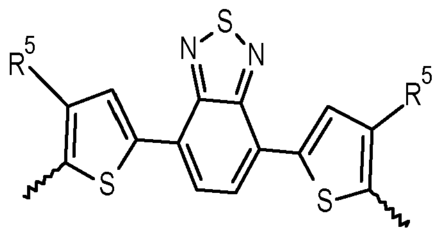

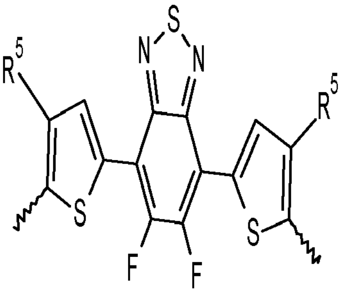

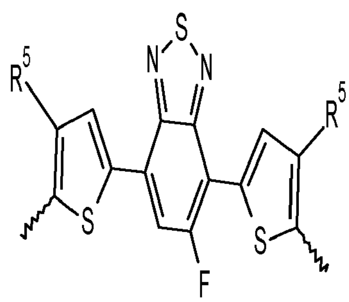

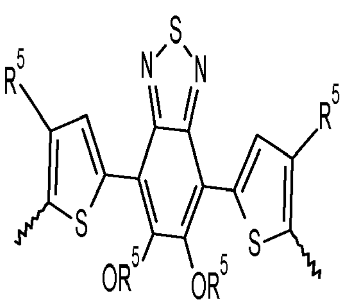

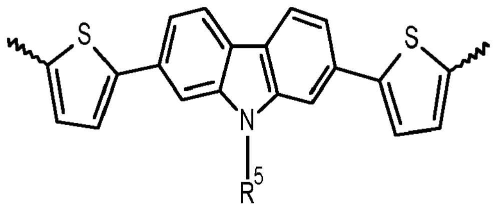

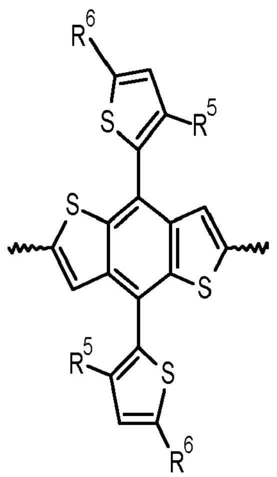

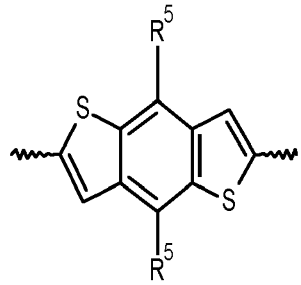

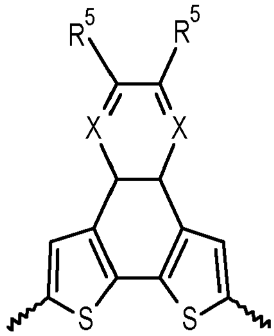

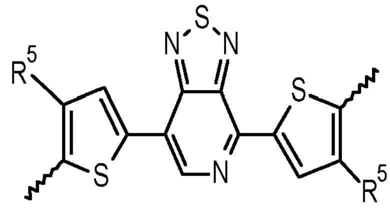

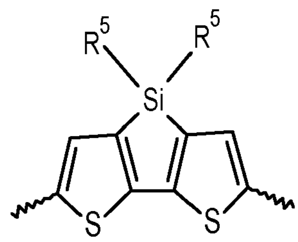

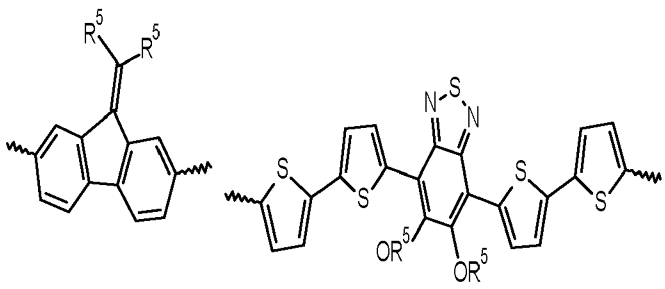

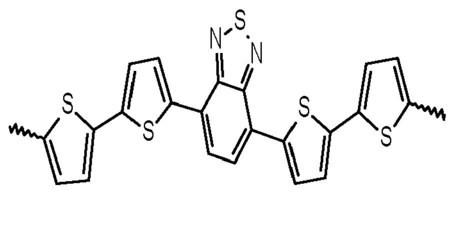

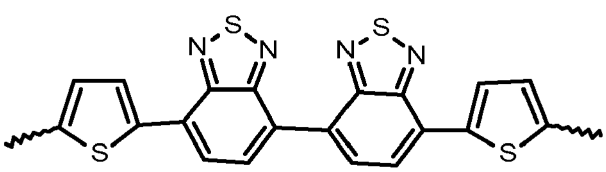

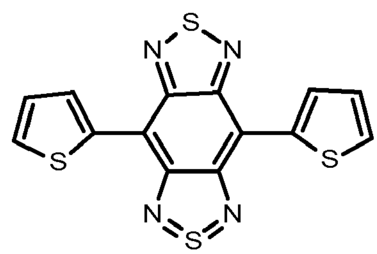

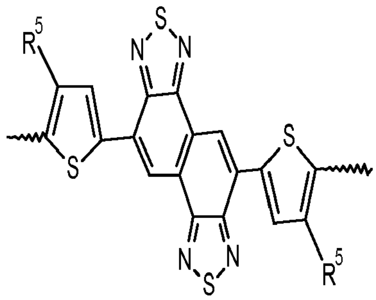

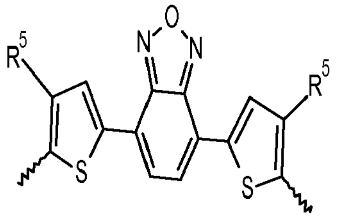

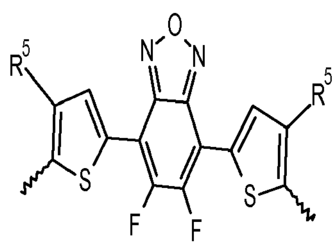

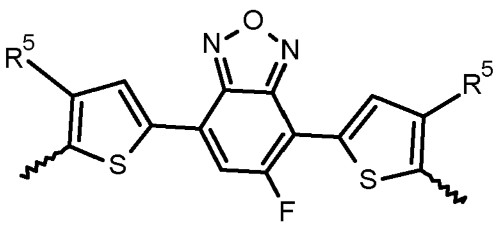

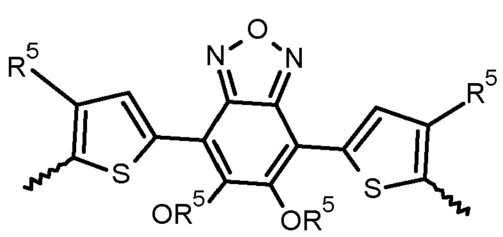

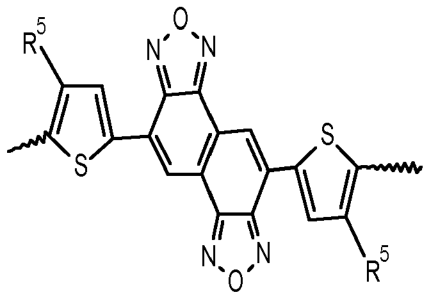

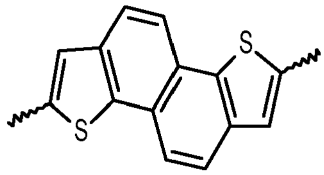

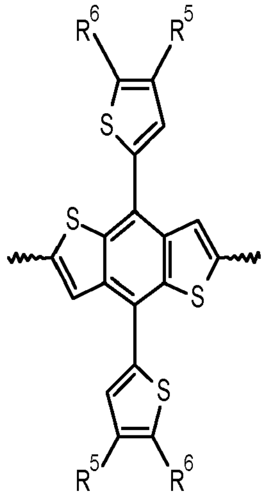

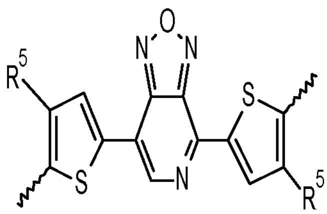

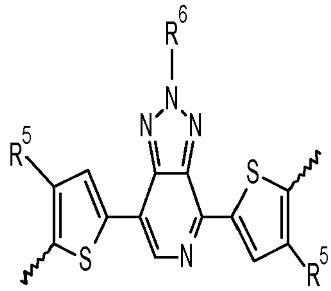

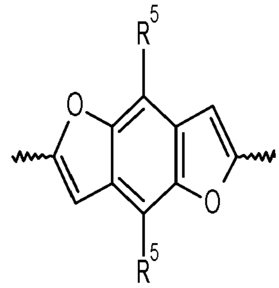

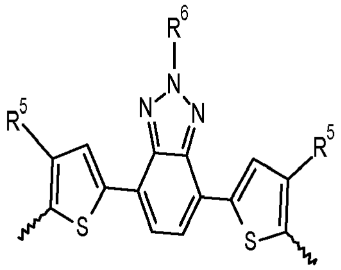

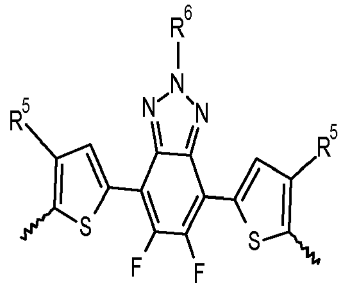

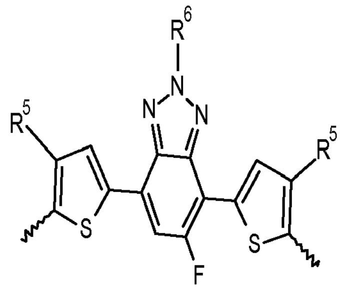

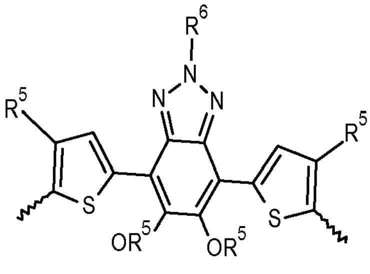

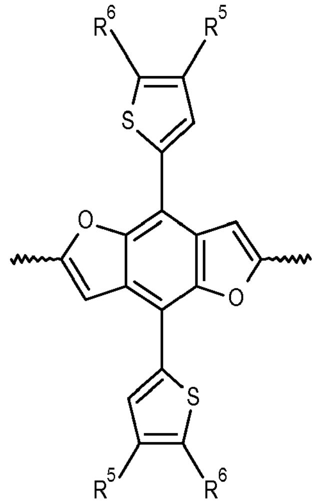

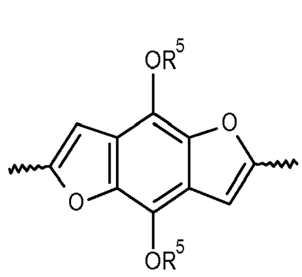

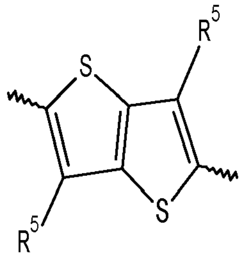

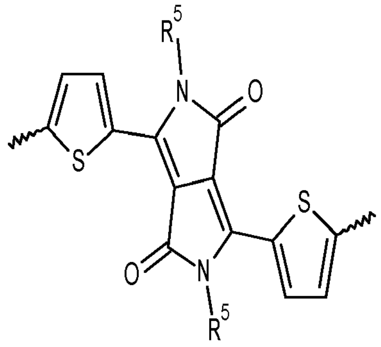

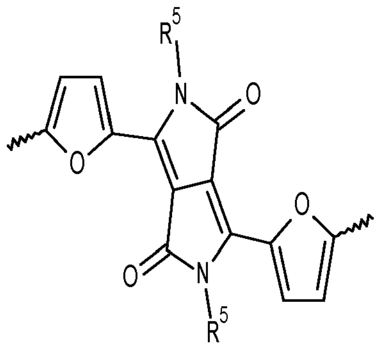

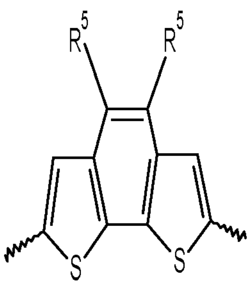

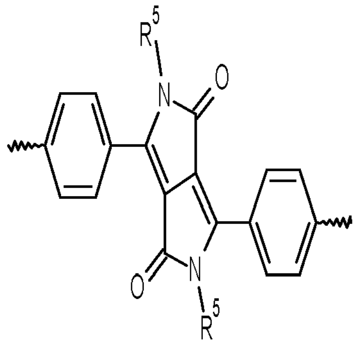

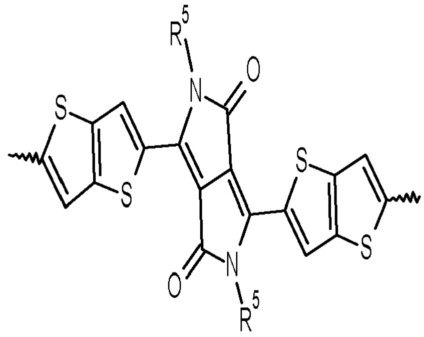

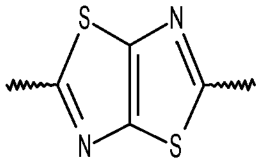

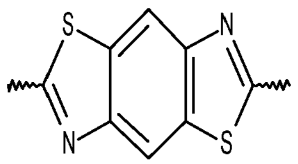

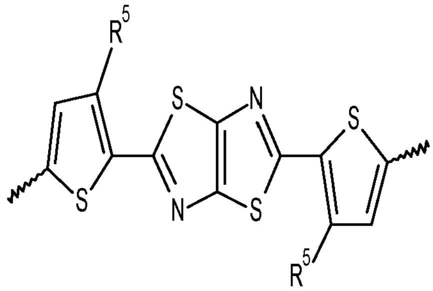

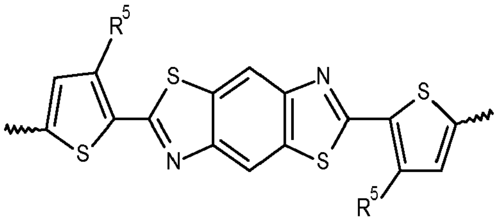

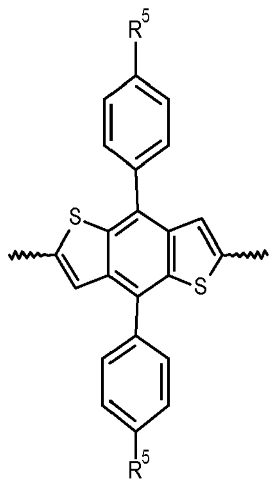

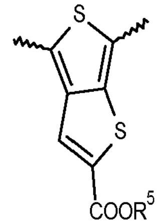

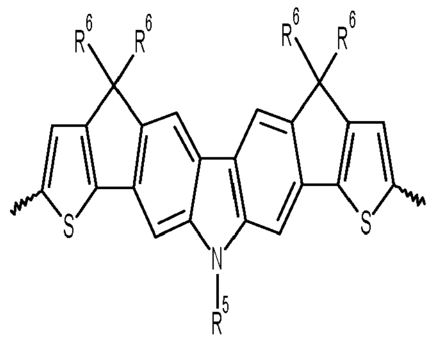
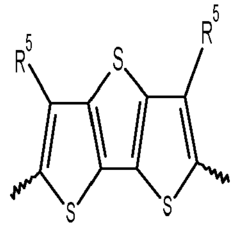
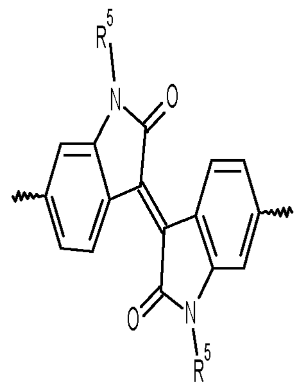

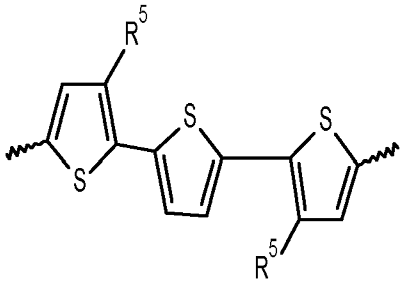
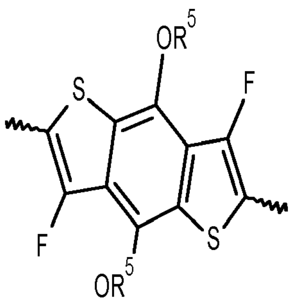
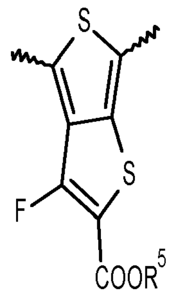

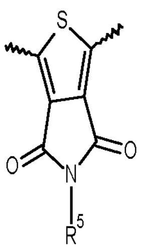
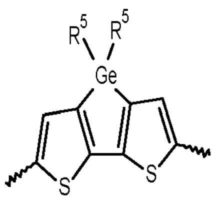
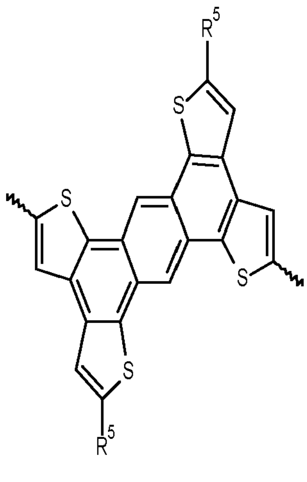
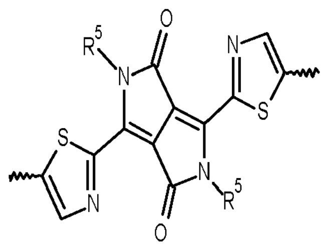

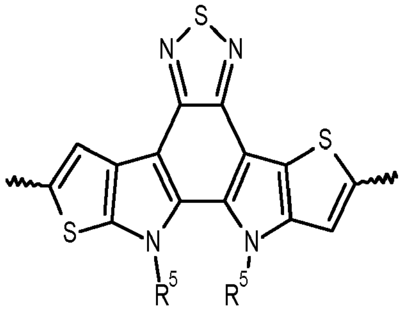
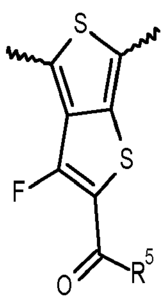
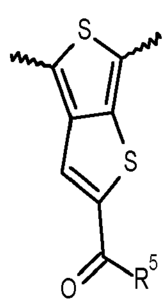

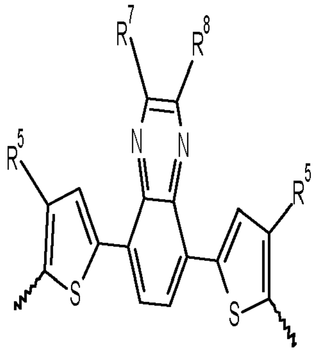
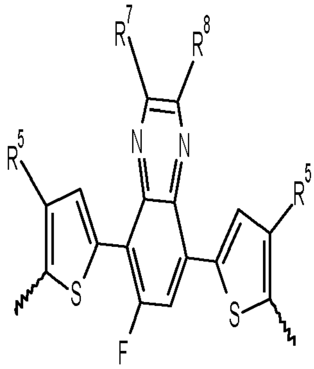
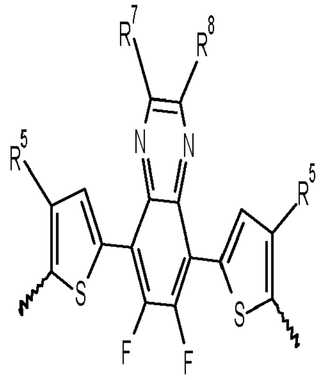

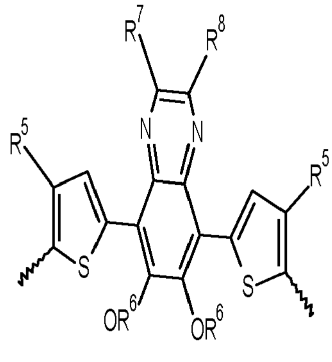
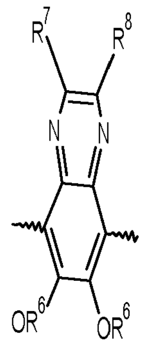
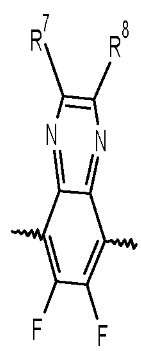
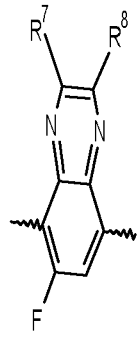
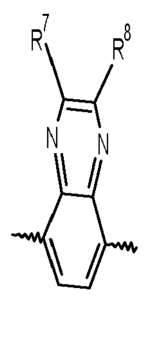

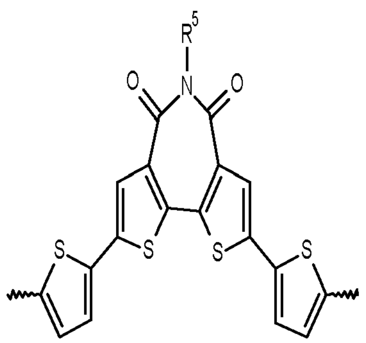
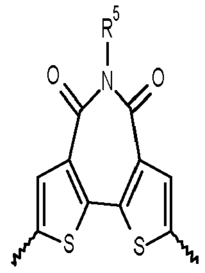
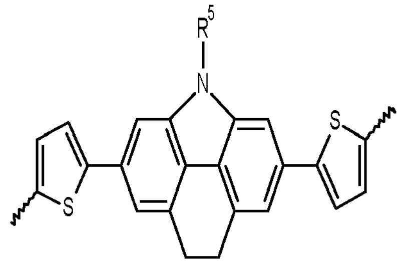

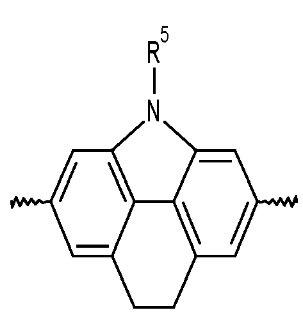
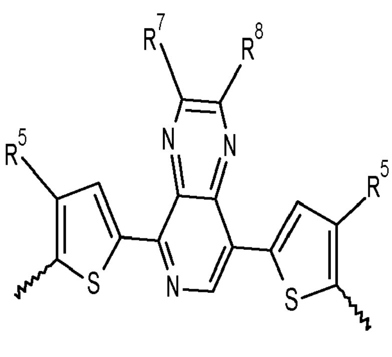
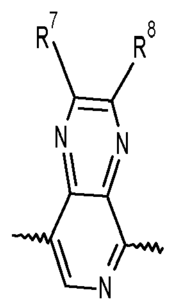

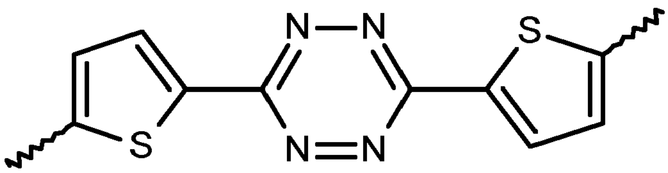

wherein $R^5$, $R^6$, $R^7$ and $R^8$ are the same or mutually different and represent in each case a hydrogen atom or a $C_1$-$C_{20}$ alkyl chain.

In another preferred embodiment the present invention refers to $Ar^1$ or $Ar^2$ in formula (I') wherein the divalent aromatic amine residue is selected from the group

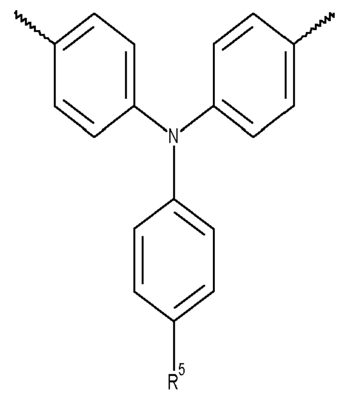
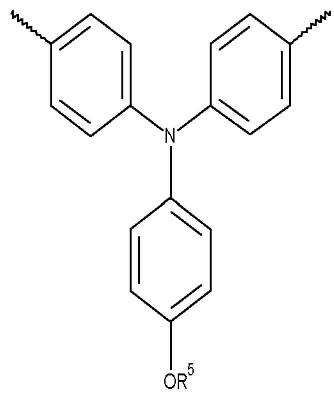
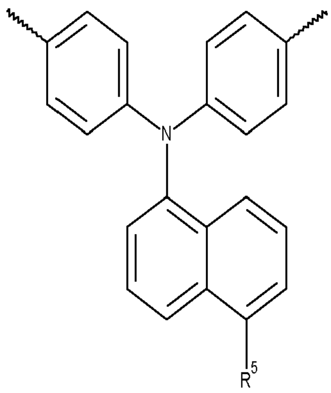

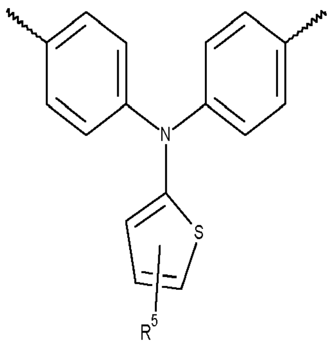
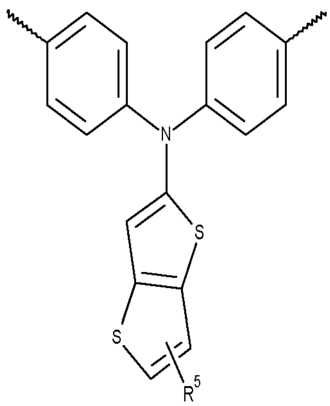
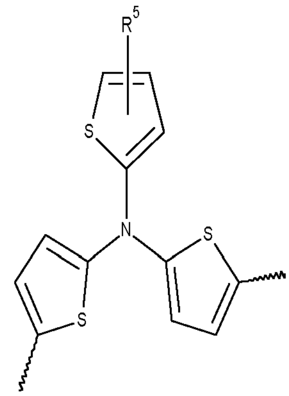

wherein $R^5$ represents a hydrogen atom or a $C_1$-$C_{20}$ alkyl chain.

In one of the most preferred embodiments the present invention is directed to polymers of formula (I') comprising in their repeating unit at least one planar aromatic ring system A represented by formulas (IIa), (IIb), (IIc) or (IId):

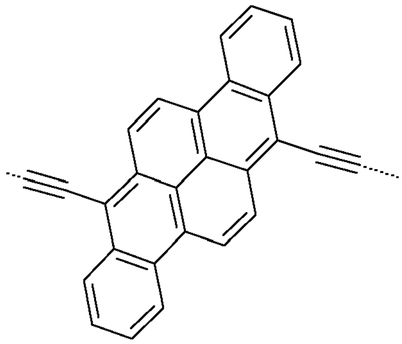

(IIa)

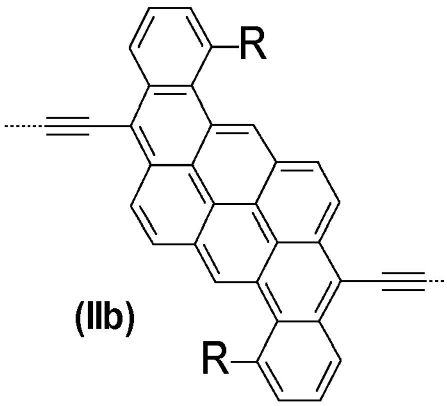

(IIb)

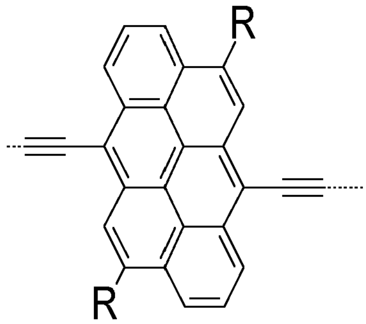

(IIc)

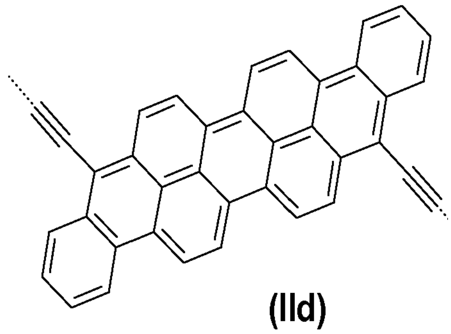

(IId)

wherein:

R represents an aryl or a heteroaryl group which is non-substituted or substituted with at least one solubilizing group selected from $C_1$-$C_{20}$ alkyl or $C_1$-$C_{20}$ alkoxy groups.

Preferably R in formulas (IIa), (IIb), (IIc) and (IId) represents an aryl group selected from the list:

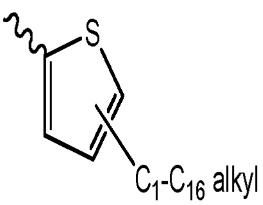

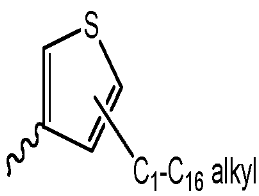

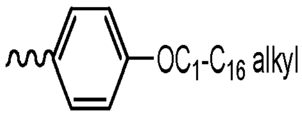

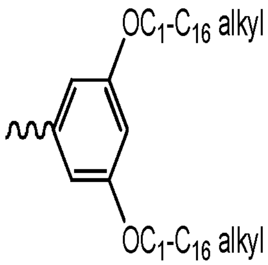

In a preferred embodiment the present invention refers to polymers represented by a formula of the group (II'a), (II'b), (II'c) or (II'd)

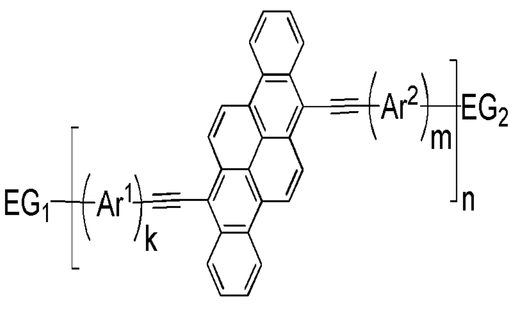

(II'a)

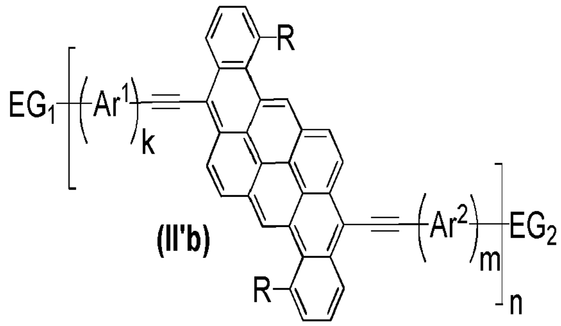

(II'b)

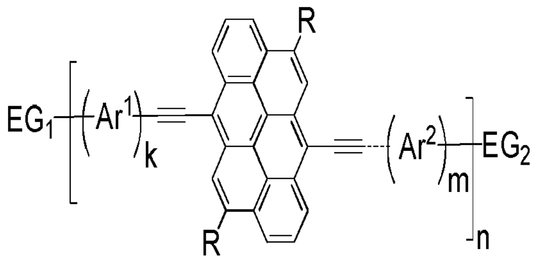

(II'c)

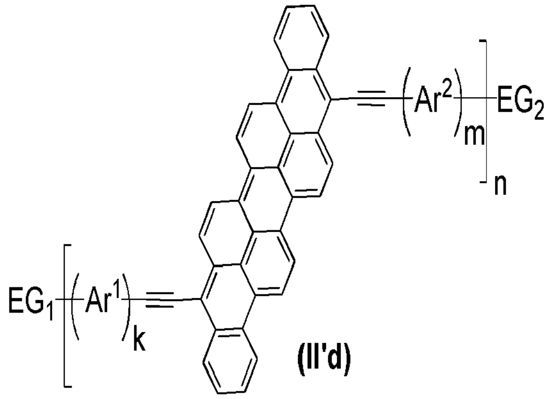

(II'd)

wherein
in each case $Ar^1$ and $Ar^2$ are the same or mutually different and independent from each other represent an arylene group, a divalent heterocyclic group, or a divalent aromatic amine residue,
k represents in each case a number of $Ar^1$ units connected in series in the repeating unit of the conjugated polymer, preferably k is an integer from the numbers 0, 1, 2 or 3; and when k = 0 the polymer does not comprise an $Ar^1$ moiety;
m represents in each case a number of $Ar^2$ units connected in series in the repeating unit of the conjugated polymer, preferably m is an integer from the numbers 0, 1, 2or 3; and when m = 0 the polymer does not comprise an $Ar^2$ moiety;
n is a number of repeating units, preferably an integer in the range from 2 to 2000, more preferred from 2 to 200,
$EG_1$ and $EG_2$ are the end groups of the respective polymer and in each case independent from each other those are selected from the group hydrogen, halogen, a trialkylstannyl group (-Sn(Alkyl)$_3$), a boronic acid group (-B(OH)$_2$), a boronic ester group (-B(OAlkyl)$_2$), an aryl unit or a heteroaryl unit.

In a preferred embodiment the present invention refers to polymers comprising in their repeating unit at least one planar aromatic ring system A represented by formulas (IIIa), (IIIb), (IIIc) or (IIId)

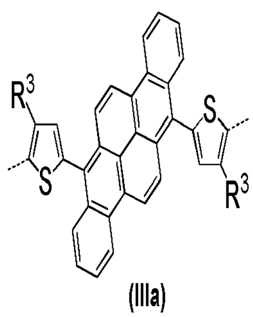

(IIIa)

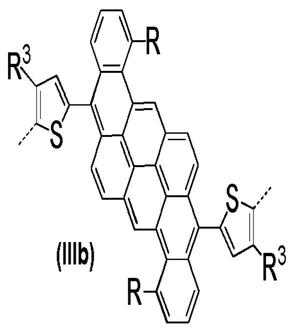

(IIIb)

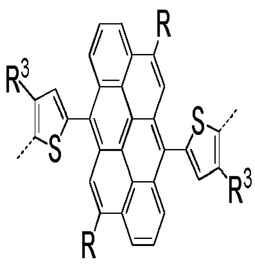

(IIIc)

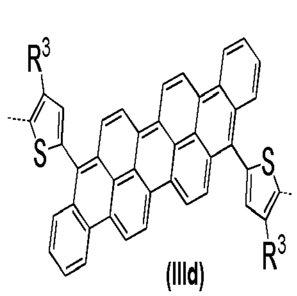

(IIId)

wherein in each case R represents an aryl or an heteroaryl group which is non-substituted or substituted with at least one solubilizing group selected from $C_1$-$C_{20}$ alkyl or $C_1$-$C_{20}$ alkoxy groups and

$R^3$ represents in each case a hydrogen atom, an alkyl group, an alkoxy group or an alkylthio group, preferably $R^3$ represents a $C_1$-$C_{20}$ alkyl or a $C_1$-$C_{20}$ alkoxy group.

In such case the polymer is represented by formulas (III'a), (III'b), (III'c) or (III'd)

n

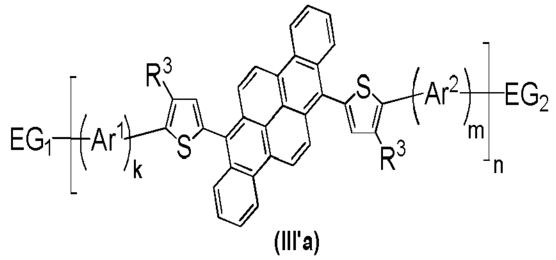

(III'a)

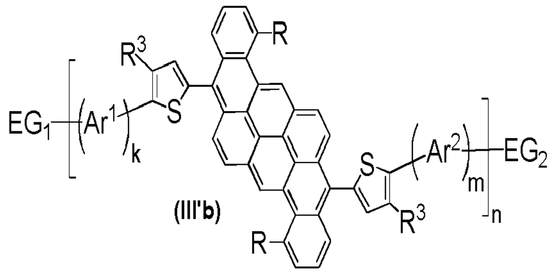

(III'b)

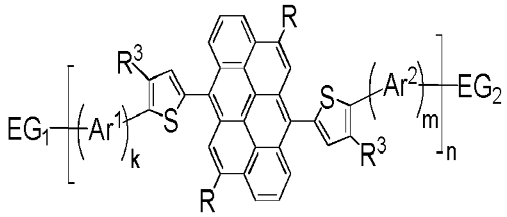

(III'c)

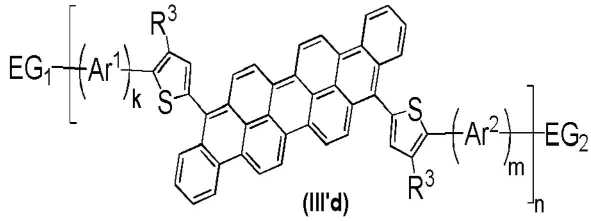

(III'd)

wherein

in each case $Ar^1$ and $Ar^2$ are the same or mutually different and represent independent from each other a divalent arylene group, a divalent heterocyclic group, or a divalent aromatic amine residue,

k represents in each case the number of $Ar^1$ units connected in series in the repeating unit of the conjugated polymer, preferably k is an integer from the numbers 0, 1, 2 or 3; and when k = 0 the polymer does not comprise an $Ar^1$ moiety; m represents in each case represents the number of $Ar^2$ units connected in series in the repeating unit of the conjugated polymer, preferably m is an integer from the numbers 0, 1, 2 or 3; and when m = 0 the polymer does not comprise an $Ar^2$ moiety; n in each case is the number of repeating units, preferably an integer in the range from 2 to 2000, more preferred an integer in the range from 2 to 200,

R in each case represents an aryl or a heteroaryl group which is non-substituted or substituted with at least one solubilizing group selected from $C_1$-$C_{20}$ alkyl or $C_1$-$C_{20}$ alkoxy groups and $R^3$ in each case represents a hydrogen atom, an alkyl group, an alkoxy group or an alkylthio group, preferably $R^3$ represents a $C_1$-$C_{20}$ alkyl or a $C_1$-$C_{20}$alkoxy group,

$EG_1$ and $EG_2$ in each case are the end groups of the polymer and independent from each other they represent hydrogen, halogen, a trialkylstannyl group (-Sn(Alkyl)$_3$), a boronic acid group (-B(OH)$_2$), a boronic ester group (-B(OAlkyl)$_2$), an aryl unit or a heteroaryl unit.

In the context of the present invention the prefix "poly" is understood to mean that more than one identical or different repeating units of the general formulas (IIa), (IIb), (IIc) or (IId) (hereinafter (IIa)-(IId)) or (IIIa), (IIIb), (IIIc) or (IIId) (hereinafter (IIIa)-(IIId)) are present in the polymer according to the present invention. The polymers according to the present invention preferably contain a total of n repeating units of the general formulas (IIa)-(IId) or (IIIa)-(IIId) where n is preferably an integer in the range from from 2 to 2000, more preferred in the range from 2 to 200. The repeating units of the general formulas (II'a)-(II'd) or (III'a)-(III'd) may each be the same or different within a polymer according to the present invention. Preference is given to a polymer having identical repeating units of the general formulas (II'a)-(II'd) or identical repeating units of the general formulas (III'a)-(III'd) in each case.

In each case a polymer according to the present invention preferably has independent from each other end groups $EG_1$ and $EG_2$ selected from the group of hydrogen, halogen, a trialkylstannyl group (-Sn(Alkyl)$_3$), a boronic acid group (-B(OH)$_2$), a boronic ester group (-B(OAlkyl)$_2$), an aryl unit or a heteroaryl unit.

A composition of the present invention is a composition comprising of at least one polymer according to formula (I') of the present invention, and additionally at least one further additive, a material selected from the group comprising a hole transporting material, an electron acceptor material, an electron transporting material, or a light absorbing material.

In another embodiment the present invention refers to a composition comprising at least two polymers of the present invention and additionally at least one further material selected from the group comprising a hole transporting

material, an electron acceptor material, an electron transporting material, or a light absorbing material.

A composition of the present invention is preferably a liquid composition, and is useful for fabrication of light absorbing devices, photovoltaic devices, preferably thin film organic solar cells or thin film organic solar batteries, and other electronic devices, preferably polymer light emitting diodes or organic field-effect transistors. The liquid composition according to the present invention comprises at least one of the polymers according to formula (I') with at least one solvent. In a preferred embodiment the present invention comprises at least one of the polymers according to formula (I') with at least one solvent and with at least one additive.

In this specification, "liquid composition" means a composition which is liquid during the device fabrication. Preferably a liquid composition according to the present invention is liquid at normal pressure at 1 atm (1 bar) and at 25°C. The liquid composition according to the present invention is, in general, referred to as ink, ink composition, solution or the like in some cases.

In a preferred embodiment the liquid composition contains in addition to the polymer(s) of formula (I') and the solvent(s) an additive selected from the group of additives with a boiling temperature below 450 °C affecting the structure of the thin films obtained after drying the liquid composition, low molecular weight fluorescent material, an electron acceptor material, a hole transporting material, an electron transporting material, additives for stabilizing, additives for adjusting viscosity and/or surface tension, additives as antioxidant and the like. These optional components may be used independent from each other in single form or in combination of two or more.

Preferred low molecular weight additives with a boiling temperature below 450 °C are selected from $C_8$-$C_{22}$ aliphatic hydrocarbons, halogenated alkanes, aliphatic thiols, acids and esters comprising thiol groups, aromatic ethers, ketones, aldehydes, aliphatic esters, or substituted aromatic hydrocarbons.

Preferred aliphatic hydrocarbons are tetradecane, hexadecane and alike. Preferred halogenated alkanes are 1,8-diiodooctane, perfluoro-1,8-diiodoctane, 1,8-dibromooctane, 1,6-dibromohexane, perfuorotetradecane and alike. Preferred aliphatic thiols are 1,8-octanedithiol, 1,6-octanedithiol, 1-dodecylthiol and alike. Preferred acids and esters comprising thiol groups are methyl 2-mercaptoacetate, n-butyl-2-mercaptoacetate, ethyl-3-mercaptopropionate, 3-mercaptopropionic acid, 11-mercaptoundecanoic acid and alike. Preferred aromatic ethers are diphenyl ether, methylphenyl ether and alike. Preferred ketones are acetophenone, valerophenone and alike. Preferred aldehydes are propional, perfuorooctanal and alike. Preferred aliphatic esters are butylacetate, methyl ester of perfluorohexanoic acid and alike. Preferred substituted aromatic hydrocarbons are 2-chloronaphthalene, 1-bromonaphthalene, benzyl alcohol, pentafluorobenzyl alcohol, 1,4-dibromobenzene, thiophenol and alike.

Preferred electron acceptor materials are selected from unmodified fullerenes, fullerene derivatives, n-type conjugated polymers, derivatives of naphthalene, perylene, nanocrystals of inorganic n-type semiconductors, and other types of organic compounds with LUMO energy (or inorganic compounds with their valence band) of -3.5 eV or lower (e.g. -3.6 eV, -3.8 eV and etc.) as estimated vs. vacuum level. (LUMO = Lowest Unoccupied Molecular Orbital).

Preferred low molecular weight fluorescent materials which may be contained in the liquid composition include low molecular weight fluorescent materials from the group of naphthalene derivatives, anthracene, anthracene derivatives, perylene, perylene derivatives, polymethine dyes, xanthene dyes, coumarine dyes, cyanine dyes; metal complexes having a metal complex of 8-hydroxyquinoline as a ligand; metal complexes having a 8-hydroxyquinoline derivative as a ligand; other fluorescent metal complexes, aromatic amines, tetraphenylcyclopentadiene, tetraphenylcyclopentadiene derivatives, tetraphenylcyclobutadiene, tetraphenylcyclobutadiene derivatives, stilbenes, silicon-containing aromatics, oxazoles, furoxanes, thiazoles, tetraarylmethanes, thiadiazoles, pyrazoles, metacyclophanes, acetylenes and the like. Specifically, low molecular weight fluorescent materials are described in, for example, EP 0 044 686 A1, EP 0 120 673 A2 and the like - herein enclosed by reference -.

Preferred hole transporting materials which may be contained in the liquid composition include polyvinylcarbazole and derivatives thereof, polysilane and derivatives thereof, polysiloxane derivatives having an aromatic amine on the side chain or the main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylenevinylene) and derivatives thereof, and poly(2,5-thienylenevinylene) and derivatives thereof.

Preferred electron transporting materials which may be contained in the liquid composition include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinoline derivatives; metal complexes of 8-hydroxyquinoline and derivatives thereof, polyquinoline and derivatives thereof, polyquinoxaline and derivatives thereof, and polyfluorene and derivatives thereof, fullerenes $C_{60}$ or fullerenes $C_{70}$ and derivatives thereof.

Preferred additives for adjusting viscosity and/or surface tension which may be contained in the liquid composition according to the present invention include a high molecular weight compound (thickening agent) and a "poor solvent" for increasing viscosity, a low molecular weight compound for decreasing viscosity, and a surfactant for lowering surface tension. The "poor solvent" means a solvent with which the weight of the polymer of the present invention dissolvable in 1 g of the solvent is 0.1 mg or less.

As the above-described high molecular weight compound for adjusting viscosity and/or surface tension, those not disturbing light adsorption and charge transportation may be permissible, and usually, those which are soluble in the solvent of the liquid composition are mentioned. As the high molecular weight compound, preferably, polystyrene of high molecular weight or polymethyl methacrylate of high molecular weight can be used. The above described high molecular weight compound for adjusting viscosity and/or surface tension has an average molecular weight of preferably 500000 or more, more preferred 1000000 or more.

When the liquid composition of the present invention contains a hole transporting material, the amount of the hole transporting material in the liquid composition is usually 1 to 80 parts by weight, preferably 5 to 60 parts by weight when the weight of all components excluding the solvent is 100 parts by weight. When the liquid composition of the present invention contains an electron transporting material, the amount of the electron transporting material in the liquid composition is usually 1 to 80 parts by weight, preferably 5 to 60 parts by weight when the weight of all components excluding the solvent is 100 parts by weight.

In the case of film formation using this liquid composition in fabricating a photovoltaic device, it may be advantageous to only remove a solvent by drying after application of the liquid composition, and also in the case of mixing of a charge transporting material and a light adsorbing material, the same means can be applied, that is, this method is extremely advantageous for production. Preferably drying is carried out by heating at a temperatures from about 50 to 150°C, alternatively, drying may be carried out under reduced pressure of about $10^{-3}$ Pa.

As the film formation method using the liquid composition, preferably application methods selected from the group of spin coat method, casting method, slot die coating method, micro gravure coating method, gravure coating method, bar coating method, roll coating method, wire bar coating method, dip coating method, spray coating method, screen printing method, flexo printing method, offset printing method, inkjet printing method and the like are used. Such methods are described in the prior art, e.g. F. C. Krebs, Solar Energy Materials & Solar Cells 93 (2009) 394-412.

The proportion of a solvent in the liquid composition is usually 1 wt% to 99.9 wt%, preferably 60 wt% to 99.9 wt%, further preferably 90 wt% to 99.8 wt% with respect to the total weight of the liquid composition. Though the viscosity of the liquid composition varies depending on the printing method, the viscosity at 25°C is preferably in the range of 0.5 to 500 mPa·s, and when a liquid composition passes through a discharge apparatus such as in an inkjet printing method and the like, the viscosity at 25°C is preferably in the range of 0.5 to 20 mPa·s, for preventing clogging and flying curving in discharging.

As the solvent contained in the liquid compositions according to the present invention, those capable of dissolving or dispersing components other than the solvent in the composition are preferable. Preferred solvents are selected from the group of chlorine-based solvents, ether solvents, aromatic hydrocarbon solvents, aliphatic hydrocarbon solvents, ketone solvents, ester solvents, polyhydric alcohols, alcohol solvents, sulfoxides solvents or amide solvents.

Preferred chlorine-based solvents are chloroform, methylene chloride, 1,2-dichloroethane, 1,1,2-trichloroethane, chlorobenzene, o-dichlorobenzene and the like. Preferred ether solvents are tetrahydrofuran, dioxane and the like. Preferred aromatic hydrocarbon solvents are toluene, xylene, trimethylbenzene, mesitylene and the like. Preferred aliphatic hydrocarbon solvents are cyclohexane, methylcyclohexane, n-pentane, n-hexane, n-heptane, n-octane, n-nonane, n-decane and the like. Preferred ketone solvents are acetone, methyl ethyl ketone, cyclohexanone and the like. Preferred ester solvents are ethyl acetate, butyl acetate, methyl benzoate, ethyl-cellosolve acetate and the like. Preferred polyhydric alcohols are ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexane diol and the like and derivatives thereof. Preferred alcohol solvents are methanol, ethanol, propanol, isopropanol, cyclohexanol and the like. Preferred sulfoxide solvents are dimethyl sulfoxide and the like. Preferred amide solvents are N-methyl-2-pyrrolidone, N,N-dimethylformamide, and the like. These solvents may be used singly or in combination of two or more. Among the above-described solvents, one or more organic solvents having a structure containing at least one benzene ring and having a melting point of 0°C or lower and a boiling point of 100°C or higher are preferably contained from the standpoint of viscosity, film formability and the like.

Regarding the kind of the solvent, aromatic hydrocarbon solvents, aliphatic hydrocarbon solvents, ester solvents and ketone solvents are preferred from the standpoint of solubility of components other than the solvent in the liquid composition into the solvent, uniformity in film formation, viscosity property and the like, and more preferable are toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone, dicyclohexyl ketone and bicyclohexylmethyl benzoate, and particularly preferable are xylene, anisole, mesitylene, cyclohexylbenzene and bicyclohexylmethyl benzoate.

Most preferred chlorinated solvents are selected from the group 1,2-dichlorobenzene, chlorobenzene, 1,2,4-trichlorobenzene, 1-chloronaphthalene, chloroform, methylene chloride and 1,2-dichlorethane, most preferred chlorinated solvent is 1,2-dichlorobenzene.

The number of the solvents to be contained in the liquid composition is preferably 2 or more, more preferably 2 to 3, and most preferred 2, from the standpoint of film formability and from the standpoint of device properties, and the like.

When two solvents are contained in the liquid composition, one of them may be solid at 25°C. From the standpoint of film formability, it is preferable that one solvent has a boiling point of 180°C or higher and another solvent has a boiling point of lower than 180°C, and it is more preferable that one solvent has a boiling point of 200°C or higher and another solvent has a boiling point of lower than 180°C.

When three solvents are contained in the liquid composition, one or two of them may be solid at 25°C. From the standpoint of film formability, it is preferable that at least one of three solvents has a boiling point of 180°C or higher and at least one solvent has a boiling point of 180°C or lower, and it is more preferable that at least one of three solvents has a boiling point of 200°C or higher and 300°C or lower and at least one solvent has a boiling point of 180°C or lower.

When two or more solvents are contained in the liquid composition, the content of a solvent having the highest boiling point is preferably 40 to 90 wt%, more preferably 50 to 90 wt%, and further preferably 65 to 85 wt% with respect to the weight of all solvents contained in the liquid composition, from the standpoint of viscosity and film formability.

The polymers of formula (I') of the present invention can be used as photovoltaic material, as a light emitting material, but also as a film material, as an organic semiconductor material, as an organic transistor material, as an optical material, as a solar battery material, or as a conductive material, preferably by doping.

Preferably the polymers of formula (I') of the present invention are used in an optoelectronic devices, more preferred in photovoltaic conversion devices, even called photovoltaic devices or solar cells.

A photovoltaic device according to the present invention can be used preferably for applications as a solar cell, solar battery, solar module, as an optical sensor and the like. Here, a solar battery as a preferred embodiment of the photoelectric conversion devices, will be further explained.

In a preferred embodiment the polymers of formula (I') of the present invention are used as photovoltaic material of a solar battery, preferably as an organic semiconductor layer of a Schottky Barrier type device utilizing an interface between an organic semiconductor and a metal, or as a hybrid semiconductor layer of a p-n heterojunction type device utilizing an interface between an organic semiconductor and an inorganic semiconductor, or as an organic semiconductor layer of a p-n heterojunction type device utilizing an interface between at least two organic semiconductors.

In a further preferred embodiment the polymers of formula (I') of the present invention are used as electron donating polymers or as electron accepting polymers in a bulk heterojunction type device in which the donor-acceptor contact area is increased, or as electron donating conjugated polymers (dispersion supporting body) in a solar battery using a high molecular weight-low molecular weight composite system, more preferred a bulk heterojunction type organic photoelectric conversion device in which a fullerene derivative is dispersed as an electron acceptor. If the polymers of formula (I') are used in a solar battery, high conversion efficiency can be obtained.

As mentioned above the polymers of the general formula (I') are preferably used in combinations with electron acceptor materials, preferably selected from unmodified fullerenes or fullerene derivatives. In a preferred embodiment the present invention therefore refers to the combination of at least one polymer of formula (I') as an electron donor and at least one fullerene compound as an electron acceptor and the use of such combination as photovoltaic material, as a light emitting material, as a film material, as an organic semiconductor material, as an organic transistor material, as an optical material, as a solar battery material, or as a conductive material, preferably by doping.

In a more preferred embodiment the present invention refers to a bulk heterojunction type organic photoelectric conversion device, preferably an organic thin film solar battery, wherein at least one polymer of formula (I') is used in combination with at least one fullerene compound in a photoactive blend solution, preferably with at least one $C_{60}$ fullerene compound or $C_{70}$ fullerene compound or their derivatives, more preferred with at least one $C_{60}$ fullerene compound or its derivatives, most preferred with [60]PCBM and the use of such combinations as photoactive layer compositions. For clarification in the present invention "[60]" represents a $C_{60}$ fullerene and "[70]" represents a $C_{70}$ fullerene.

Consequently the present invention is even directed to combinations of at least one polymer represented by formula (I')

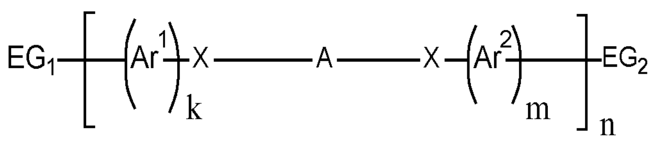

(I')

wherein

A represents a planar aromatic system selected from the list given above,

$Ar^1$ and $Ar^2$ are the same or mutually different and independent from each other represent a divalent arylene group, a divalent heterocyclic group, or a divalent aromatic amine residue,

k represents the number of $Ar^1$ units connected in series in the repeating unit of the conjugated polymer and is a number between 0 and 3, preferably from 1 to 3,

m represents a number of $Ar^2$ units connected in series in the repeating unit of the conjugated polymer and is a number between 0 and 3, preferably from 1 to 3;

n represents an integer from 2 to 2000, preferably from 2 to 200,

$EG_1$ and $EG_2$ are the end groups of the polymer and independent from each other they represent a hydrogen, a halogen, a trialkylstannyl unit (-Sn(Alkyl)$_3$), a boronic acid unit(-B(OH)$_2$), a boronic ester unit (-B(OAlkyl)$_2$), an aryl unit or a heteroaryl unit and

X represents in each case independent from each other a divalent acetylene fragment $X_1$ or a thiophene unit $X_2$,

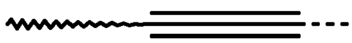

$X_1$

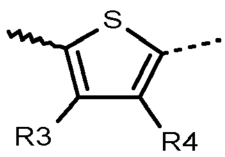

$X_2$

with at least one fullerene compound, preferably with at least one $C_{60}$ fullerene compound or at least one $C_{70}$ fullerene compound or their derivatives, more preferred with at least one $C_{60}$ fullerene compound or its derivatives, most preferred with [60]PCBM.

In a preferred embodiment such combinations of polymer of formula (I') with fullerenes are applied in solvents selected from the group 1,2-dichlorobenzene, chlorobenzene, 1,2,4-trichlorobenzene, 1-chloronaphthalene, chloroform, methylene chloride and 1,2-dichlorethane, most preferred chlorinated solvent is 1,2-dichlorobenzene.

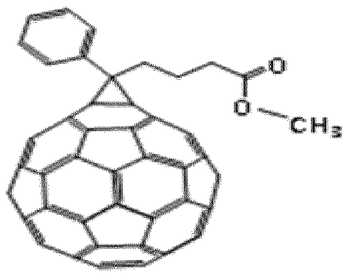

**[60]PCBM**

The present invention is even directed to combinations of polymers comprising a conjugated backbone with repeating units represented by the formula (I)

-[-X-A-X-]- (I)

containing at least one planar aromatic system A selected from the list

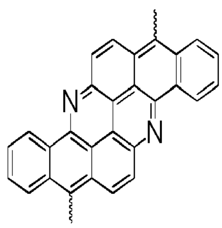
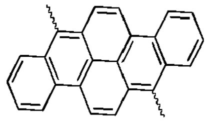
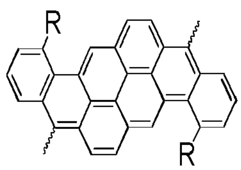
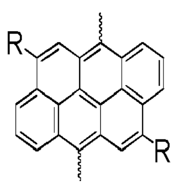

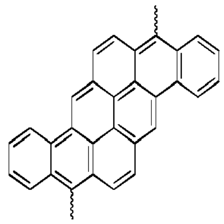 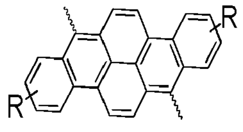 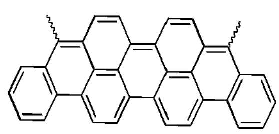 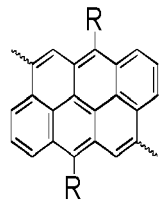

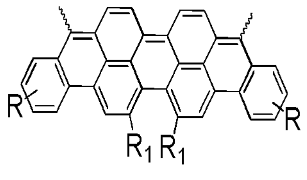 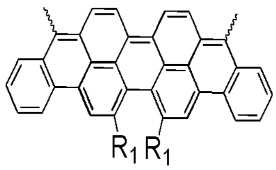 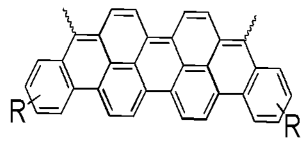

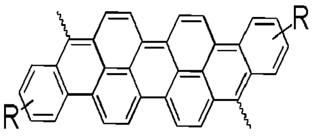 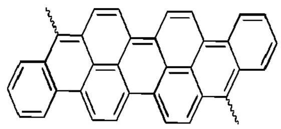 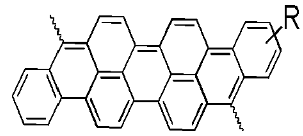

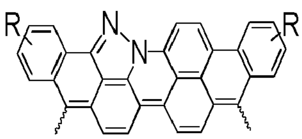 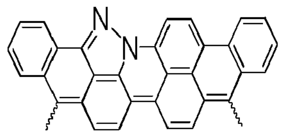

wherein
wavy bond 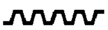 shows the attachment positions of X-blocks in formula (I);

R represents an aryl or a heteroaryl group which is non-substituted or substituted with a solubilizing group selected from $C_1$-$C_{20}$ alkyl or $C_1$-$C_{20}$ alkoxy,

$R_1$ represents a $C_1$-$C_{20}$ alkoxy group or a $C_1$-$C_{20}$ alkylthio group,

X in each case independent from each other represents a divalent acetylene fragment $X_1$ or a thiophene unit $X_2$

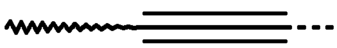

$X_1$

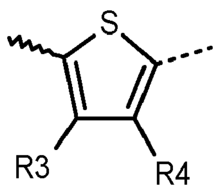

$X_2$

wherein
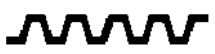 represents a wavy bond as the attachment position(s) of A in formula (I) and
R3[3] and R4[4] are the same or mutually different and represent a hydrogen atom, an alkyl group, an alkoxy group or an alkylthio group, with fullerene compounds, preferably with $C_{60}$ fullerene compounds or $C_{70}$ fullerene compounds or their derivatives, more preferred with $C_{60}$ fullerene compounds or their derivatives, most preferred with [60]PCBM.

In a preferred embodiment the present invention is directed to combinations of polymers comprising a conjugated backbone with repeating units represented by the formula (II)

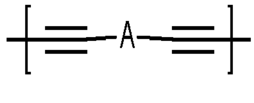 (II)

containing at least one planar aromatic system A selected from the list given above, with at least one fullerene compound, preferably with at least one $C_{60}$ fullerene compound or $C_{70}$ fullerene compound or their derivatives, more preferred with at least one $C_{60}$ fullerene compound or its derivatives, most preferred with [60]PCBM.

In a preferred embodiment the present invention is directed to combinations of polymers comprising a conjugated backbone with repeating units represented by the formula (III)

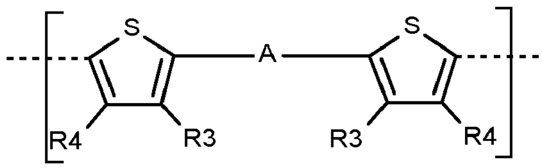

(III)

Containing at least one planar aromatic system A selected from the list given above, and R3 and R4 are the same or mutually different and represent independent from each other a hydrogen atom, an alkyl group, an alkoxy group or an alkylthio group, with at least one fullerene compound, preferably with at least one $C_{60}$ fullerene compound or $C_{70}$ fullerene compound or their derivatives, more preferred with at least one $C_{60}$ fullerene compound or its derivatives, most preferred with [60]PCBM.

With respect to the structure of such a solar battery, in the case of, for example, a p-n heterojunction type device, it is advantageous that a p-type semiconductor layer is formed on an ohmic electrode, for example, on ITO (indium-tin-oxide), further, an n-type semiconductor layer is laminated, and an ohmic electrode is provided thereon.

A solar battery according to the present invention is usually formed on a supporting substrate. The supporting substrate is preferably one which does not disturb the property of an organic photoelectric conversion device, and more preferred glass substrates and flexible film substrates and plastic substrates are used.

A solar battery according to the present invention can be produced by known methods, for example, a method described in Synth. Met., 102, 982 (1999), and a method described in Science, 270, 1789 (1995).

The present invention is even directed to a process for the manufacture of polymers of general formula (I') characterized in that Suzuki or Stille polycondensation reaction is involved to link the monomers together thus forming a conjugated polymer.

The present invention is even directed to a process for the manufacture of polymers of general formulas (II'a)-(II'd) characterized in that Suzuki or Stille polycondensation reaction is involved to link the monomers together thus forming a conjugated polymer.

The present invention is even directed to a process for the manufacture of polymers of general formulas (III'a)-(III'b) characterized in that Suzuki or Stille polycondensation reaction is involved to link the monomers together thus forming a conjugated polymer.

The polymers of general formula (I') are preferably produced using Stille or Suzuki polycondensation reactions as illustrated in **Schemes 1-3** for copolymer (III'b) and **Scheme 4** for copolymer (III'c):

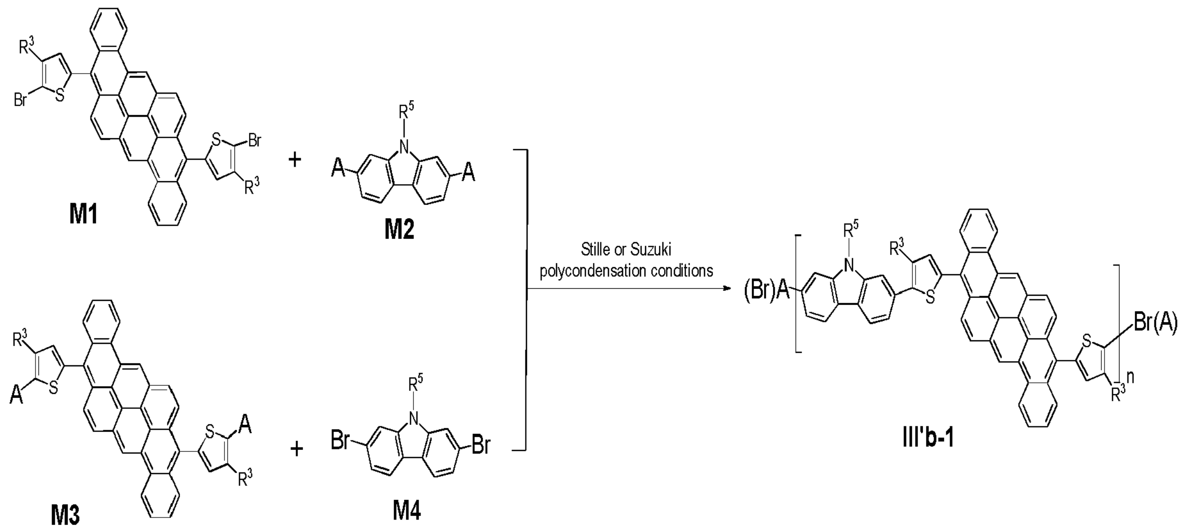


M1 + M2

M3 + M4

III'b-1

Scheme 1

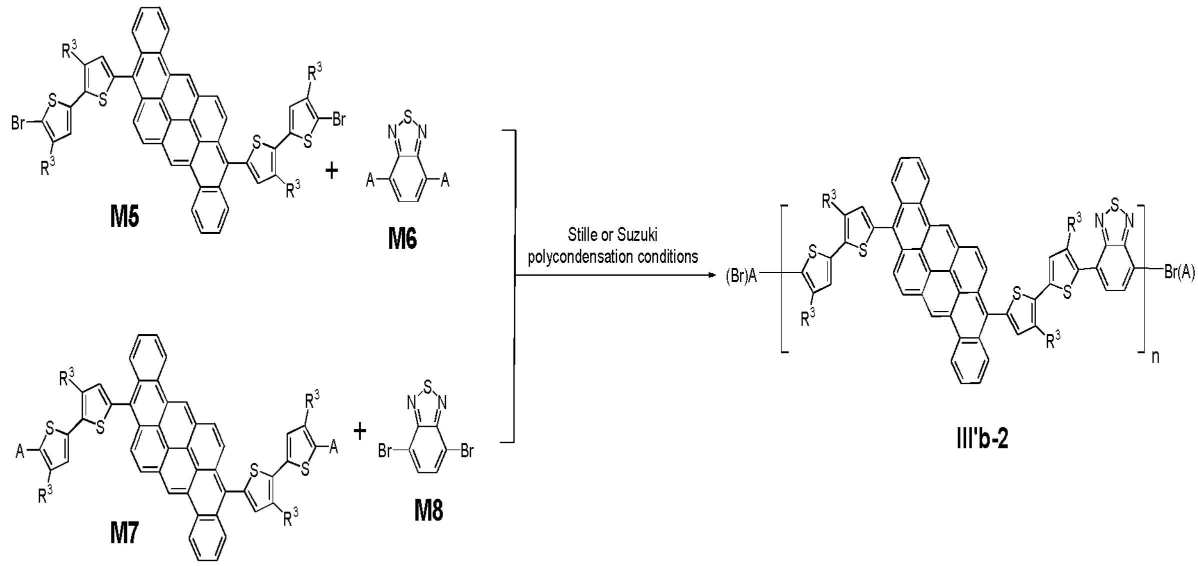


M5 + M6

M7 + M8

III'b-2

Scheme 2

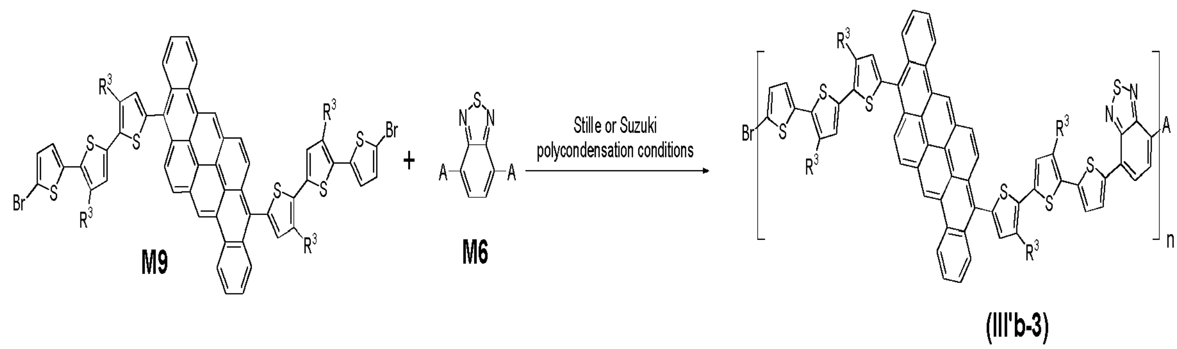


M9 + M6

(III'b-3)

Scheme 3

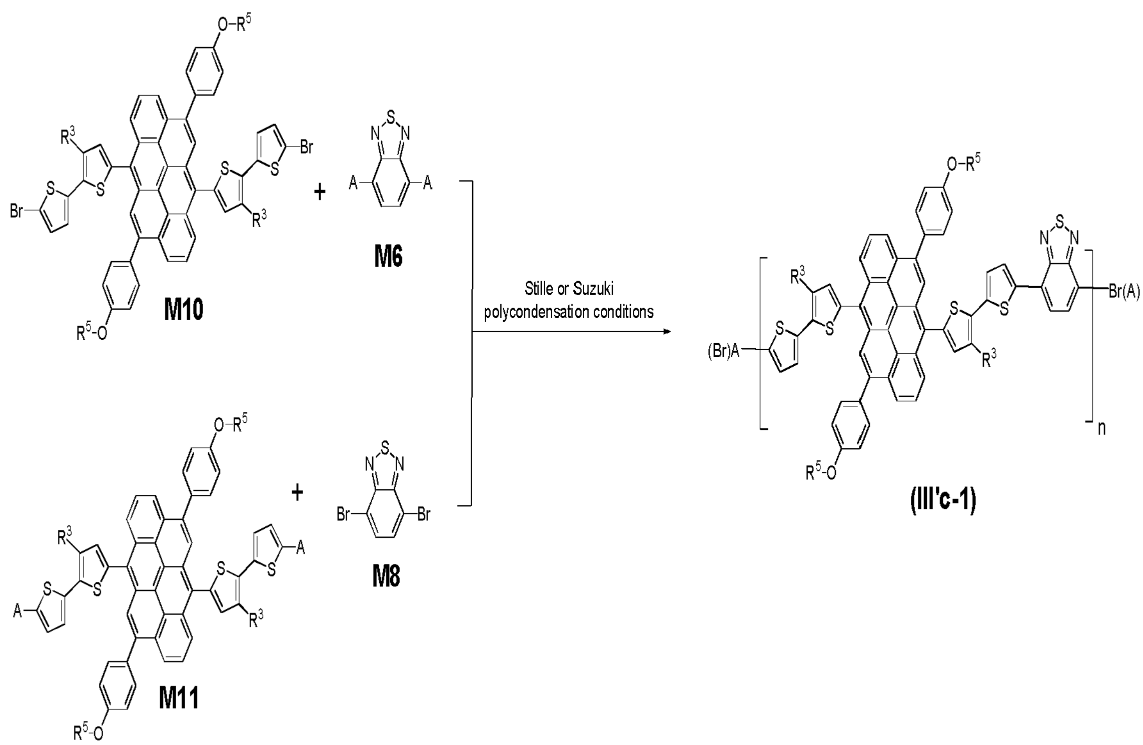


M10

M6

M11

M8

(III'c-1)

**Scheme 4**

In the case of Stille polycondensation reactions substituent A in **M2** or **M6** is represented by stannyl residues $R_3Sn$-, preferably trialkylstannyl $(Alkyl)_3Sn$-, especially preferred trimethylstannyl $Me_3Sn$.

In the case of Suzuki polycondensation reaction substituent A in **M2** and in **M6** is represented by boronic acid residue $-B(OH)_2$, boronic acid ester residue $-B(OR)_2$, preferably boronic alkyl esters $-B(OAlkyl)_2$, especially preferred boronic acid ester residues selected from the list:

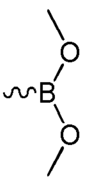
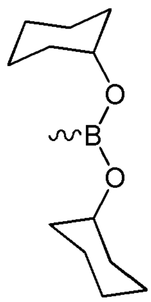
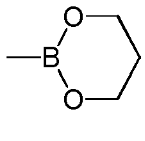
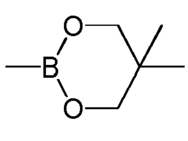
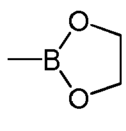
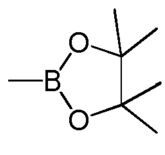

Alternatively, substituent A in **M2** and **M6** in the case of Suzuki polycondensation reaction can be represented by $-BF_3K$, $-BF_3Na$, $-BF_3Rb$ or $-BF_3Cs$ residues. $R^3$ and $R^5$ in **M2** and **M6** are the same or mutually different and represent in each case a hydrogen atom or a $C_1$-$C_{20}$ alkyl chain and n represents an integer from 2 to 2000, preferably from 2 to 200.

The end groups of the polymer chain formed according to **Schemes 1-4** can be further modified using a sequence of the reactions illustrated for (III'c-1) in **Scheme 5:**

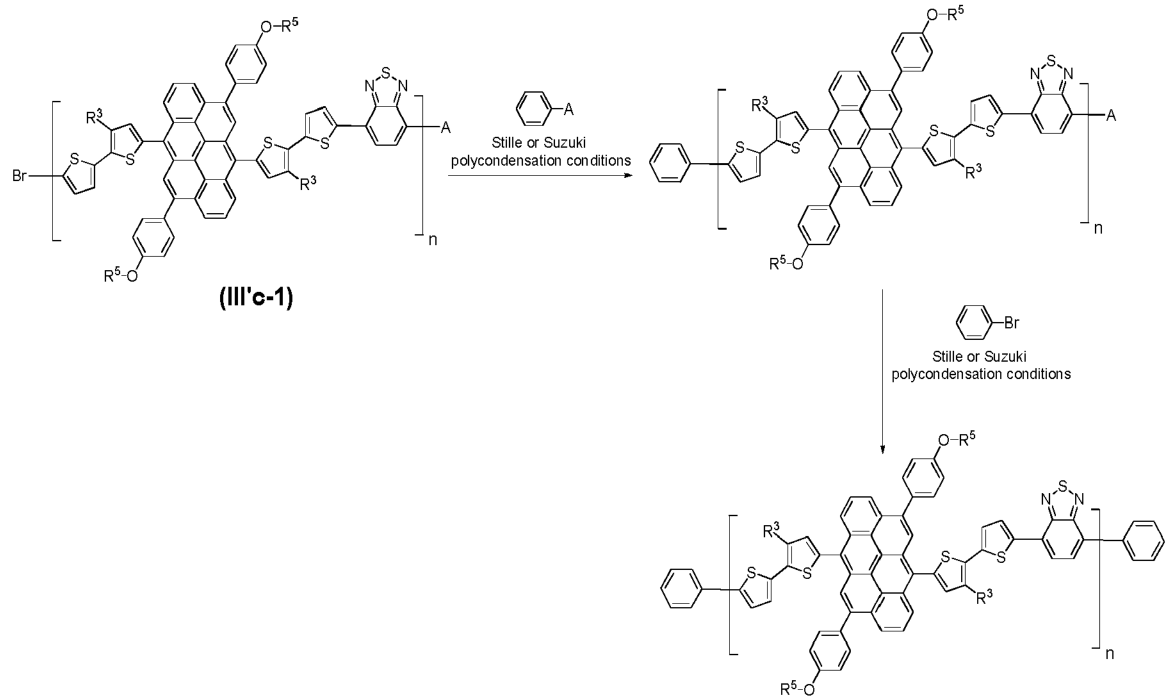


(III'c-1)

**Scheme 5**

wherein $R^3$, $R^5$, n and A have the above given meanings as described for **M2** or **M6.**

The conditions of Stille polycondensation reaction are known to a technician having ordinary skills in the art of polycondensation reactions. Generally, 0.0001-20 mole % of Pd(0) or Pd(II) catalyst is introduced to a solution of two monomers (for example, **M1** and **M2** according to Scheme 1) taken in 1:1 molar ratio. Organic liquids which are not reactive towards monomers or palladium catalyst can be used as solvents. Preferably, toluene or xylenes or THF or DMF or their mixtures with other solvents are used to perform Stille polycondensation reactions. Mixtures of toluene with more polar solvents such as DMF (N,N-dimethylformamide) or NMP (N-methylpyrrolidinone) are the most preferred. The reaction mixture preferably should be deaerated before initiation of the reaction. The reaction can be initiated using conventional heating or using microwaves. Using microwaves is most preferred in some cases (see Microwave Methods in Organic Synthesis, M. Larhed, K. Olofsson, (Eds.), Topics in Current Chemistry, Vol. 266, 2006, XII, p. 103-144 for more details).

The reaction temperature is preferably set in the range from 20 °C to 200 °C, more preferred in the range from 30 °C to 150 °C, most preferred in the range from 50 °C to 130 °C, especially preferred in the range from 60 °C to 120 °C and especially most preferred in the range from 90 °C to 110 °C. The Stille polycondensation reaction is preferably performed at normal (ambient, e.g. 760 mm Hg or 1.01325 bar) pressure. In some variations the reaction can be performed under reduced pressure, preferably 0.1 bar to 0.9 bar, more preferred 0.2 bar to 0.9 bar, most preferred 0.6 bar to 0.9 bar or the reaction is performed under elevated pressure, preferably 1.1 bar to 10 bar, more preferred 1.5 bar to 10 bar, most preferred 2 bar to 10 bar, especially preferred 5 bar to 10 bar.

The Stille polycondensation reaction is preferably carried out in sealed tubes or autoclaves when reduced or elevated pressures are required. The preferred pressure range is from 0.01 to 100 bar, more preferred from 0.1 to 10 bar.

The conditions of Suzuki polycondensation reaction are also known to a technician having ordinary skills in the art of polycondensation. With respect to **Scheme 1,** generally, 0.0001-20 mole % of Pd(0) or Pd(II) catalyst is introduced to a solution of **M1** and **M2** taken into 1:1 molar ratio. Organic liquids which are not reactive towards **M1** and/or **M2** or which are not reactive towards a palladium catalyst can be used as solvents. Preferably, toluene or xylenes or THF or DMF or their mixtures with other solvents are used to perform Suzuki polycondensation reactions. Optionally, an appropriate base and phase transfer catalyst can be introduced into the reaction. Preferred bases are aqueous or alcoholic solutions of alkali metal carbonates, preferably $K_2CO_3$, alkali metal hydroxides, preferably KOH, NaOH, organic bases, preferably tertiary amines, more preferred $Et_3N$ or Hunig base, or tetraalkylammonium hydroxides, preferably $Et_4NOH$, $Bu_4NOH$, and alkali metal salts, preferably $K_3PO_4$, CsF, $Rb_3PO_4$ and etc. More details can be found in the literature, e.g. Design and Synthesis of Conjugated Polymers, M. Leclerc and J. F. Morin Eds., Wiley InterScience (2010), p. 45-98 or A. Suzuki, Acc. Chem. Res. 1982, 15, 178-184.

The reaction temperature might be set in the range from 20 °C to 200 °C, preferably in the range from 30 °C to 150 °C, more preferably in the range from 50 °C to 130 °C, even more preferably in the range from 60 °C to 120 °C

and the most preferably in the range from 90 °C to 110 °C. The Suzuki polycondensation reaction is preferably performed at normal (ambient, e.g. 760 mm Hg or 1.01325 bar) pressure. In some variations the reaction can be performed under reduced (e.g. 0.1 bar, 0.2 bar, 0.6 bar or 0.9 bar and etc) or elevated pressure (e.g. 1.1 bar, 1.5 bar, 2 bar, 5 bar, 10 bar). The Suzuki polycondensation reaction might be carried out in sealed tubes or in an autoclave when reduced or elevated pressures are required. Preferably a pressure range from 0.01 to 100 bar, more preferred from 0.1 to 10 bar is applied.

Some starting compounds are generally commercially available. For example, compounds of general formula **M2** can be represented by 9-(9-Heptadecanyl)-9H-carbazole-2,7-diboronic acid bis(pinacol) ester (CAS 958261-51-3, Debye Scientific Co., Limited) and 9-(eicosan-11-yl)-2,7-bis(4,4,5,5-tetramethyl-1,3,2-dioxaborolan-2-yl)-9H-carbazole (CAS 1185885-88-4, Santai Labs, Inc). The compound of general formula **M4** can be represented by 2,7-dibromo-9-(heptadecan-9-yl)-9H-carbazole (CAS 955964-73-5, Lumtec). Compounds **M8** (4,7-Dibromobenzo[c]-1,2,5-thiadiazole, CAS 15155-41-6) and **M6** (2,1,3-Benzothiadiazole-4,7-bis(boronic acid pinacol ester, CAS 934365-16-9) are available from Sigma-Aldrich.

Starting compound of general formula **M1** can be synthesized according to the chemical routes shown in **Scheme 6** below.

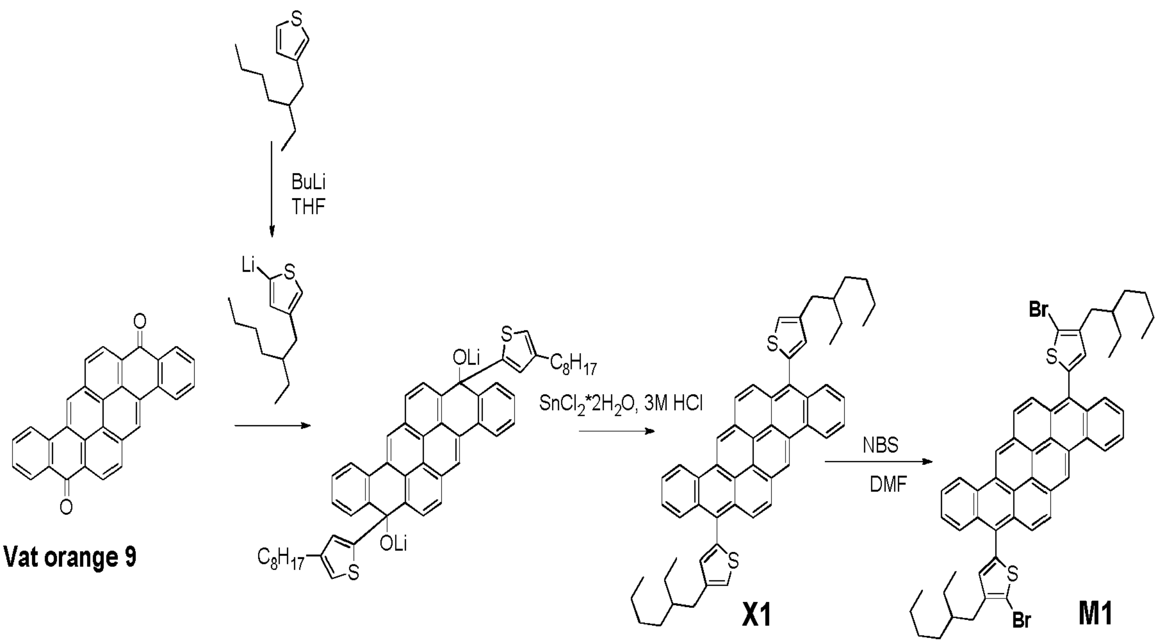

Vat orange 9
X1
M1

**Scheme 6**

Readily available dye vat orange 9 (CAS 128-70-1) was treated with 3 mole equivalents of (4-(2-ethylhexyl)thiophen-2-yl)lithium in THF which resulted in the formation of a soluble intermediate which was quenched with tin (II) chloride to yield bright red powder of **X1.** The bromination of **X1** was easily accomplished using stoichiometric amounts of N-bromosuccinimide (CAS 128-08-05) thus resulting in monomer **M1.**

Monomer **M3** was obtained from **M1** following the procedure shown in **Scheme 7.** The solution of **M1** in THF was cooled down to -78 °C and then 1.2 eq. of butyllithium was added. The reaction mixture was stirred for 2 hrs and then a solution of 1.3 eq. of $Me_3SnCl$ was introduced via syringe. The mixture was stirred for 1 hr at -78 °C and then was allowed to warm up to the room temperature. Standard workup produced **M3** as a red solid.

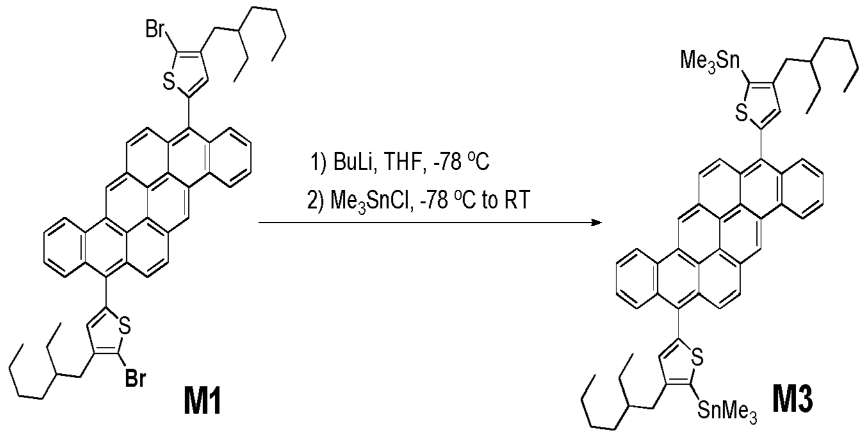


M1 M3

**Scheme 7**

Monomer **M5** was synthesized from **M1** in two steps as it is shown in **Scheme 8.** The monomer **M1** (0.1 mole) was treated with 0.17 moles of 4-(2-Ethylhexyl)-2-tributylstannylthiophene (CAS 886746-54-9) under typical Stille cross-coupling conditions (identical to the Stille polycondensation reaction conditions described above) to yield **X2.** The intermediate product **X2** was purified by column chromatography on silica using toluene/hexanes mixtures as eluent. The bromination of **X2** by stoichiometric amount of NBS in DMF afforded title compound **M5** (NBS = N-bromosuccinimide; DMF = dimethyl formamide; THF = tetrahydrofurane).

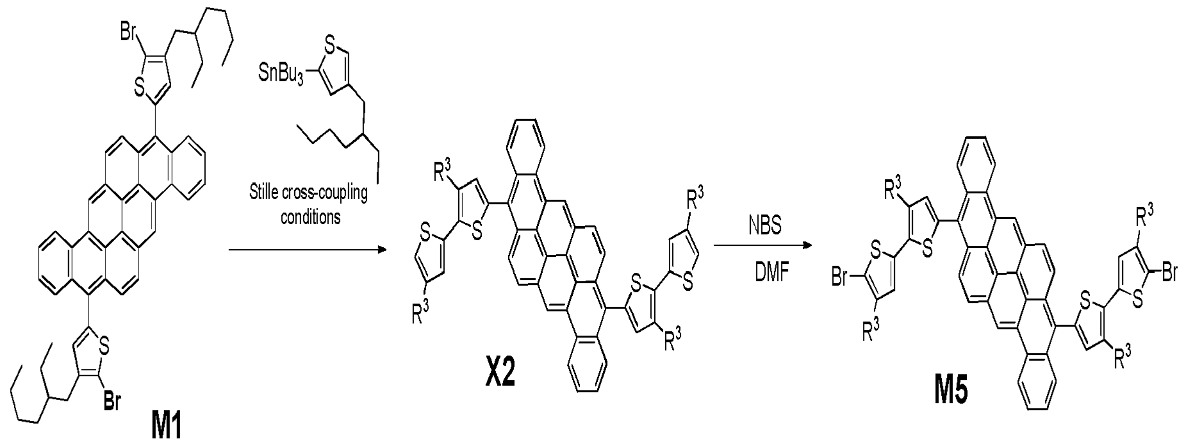


M1 X2 M5

**Scheme 8**

Monomer **M7** (A=$Me_3Sn$) has been synthesized from **M5** using the procedure described above for conversion of **M1** to **M3 (Scheme 7).**

Monomer **M9** was synthesized from **M5** according to the **Scheme 9. M5** (0.1 mole) was treated with 0.2 mole of 2-thienylboronic acid (CAS 6165-68-0) in 50-60 mL of toluene under typical Suzuki cross-coupling conditions (see above Suzuki polycondensation reaction conditions) to yield intermediate product **X3** which was purified using preparative GPC (gel permeation chromatography). Bromination of **X3** by NBS (1.0 eq.) in DMF resulted in compound **M9.**

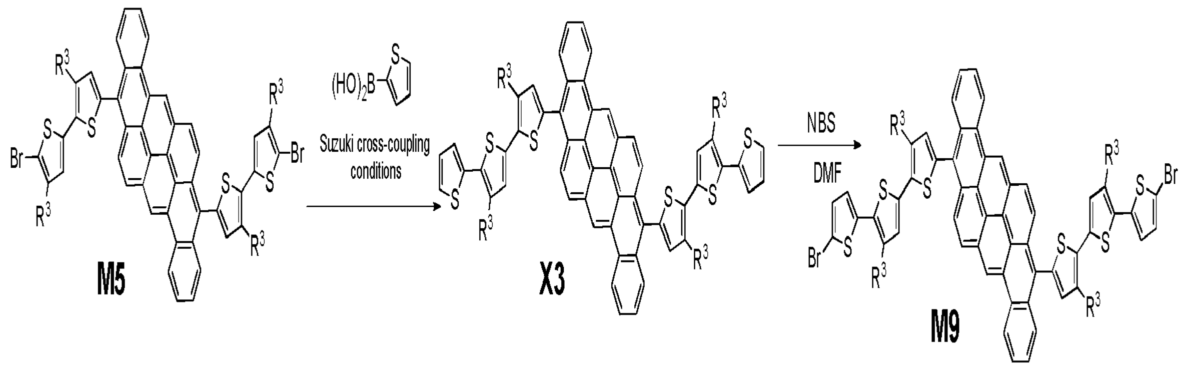

M5 X3 M9

Scheme 9

Monomer **M10** was synthesized from commercially available dye vat orange 3 using a sequence of the reactions shown in **Scheme 10.** At the first step the vat orange 3 dye was treated with 1.7 eq. of 2-(4-((2-ethylhexyl)oxy)phenyl)-4,4,5,5-tetramethyl-1,3,2-dioxaborolane (CAS 251566-01-5) in toluene under Suzuki cross-coupling conditions (see above). The product **X4** was easily isolated using column chromatography on silica. The next step was reductive coupling of **X4** with (4-(2-ethylhexyl)thiophen-2-yl)lithium in THF followed by quenching with aqueous $SnCl_2$. The resulting product **X5** was brominated using stoichiometric amount of NBS in chloroform to afford **X6**. The next step was Suzuki cross coupling of dibromide **X6** with 2-thienylboronic acid (CAS 6165-68-0) (50% excess of the reagent was used to achieve good yield of the product **X7**). Finally, **X7** was brominated with NBS in chloroform to produce the title monomer **M10.**

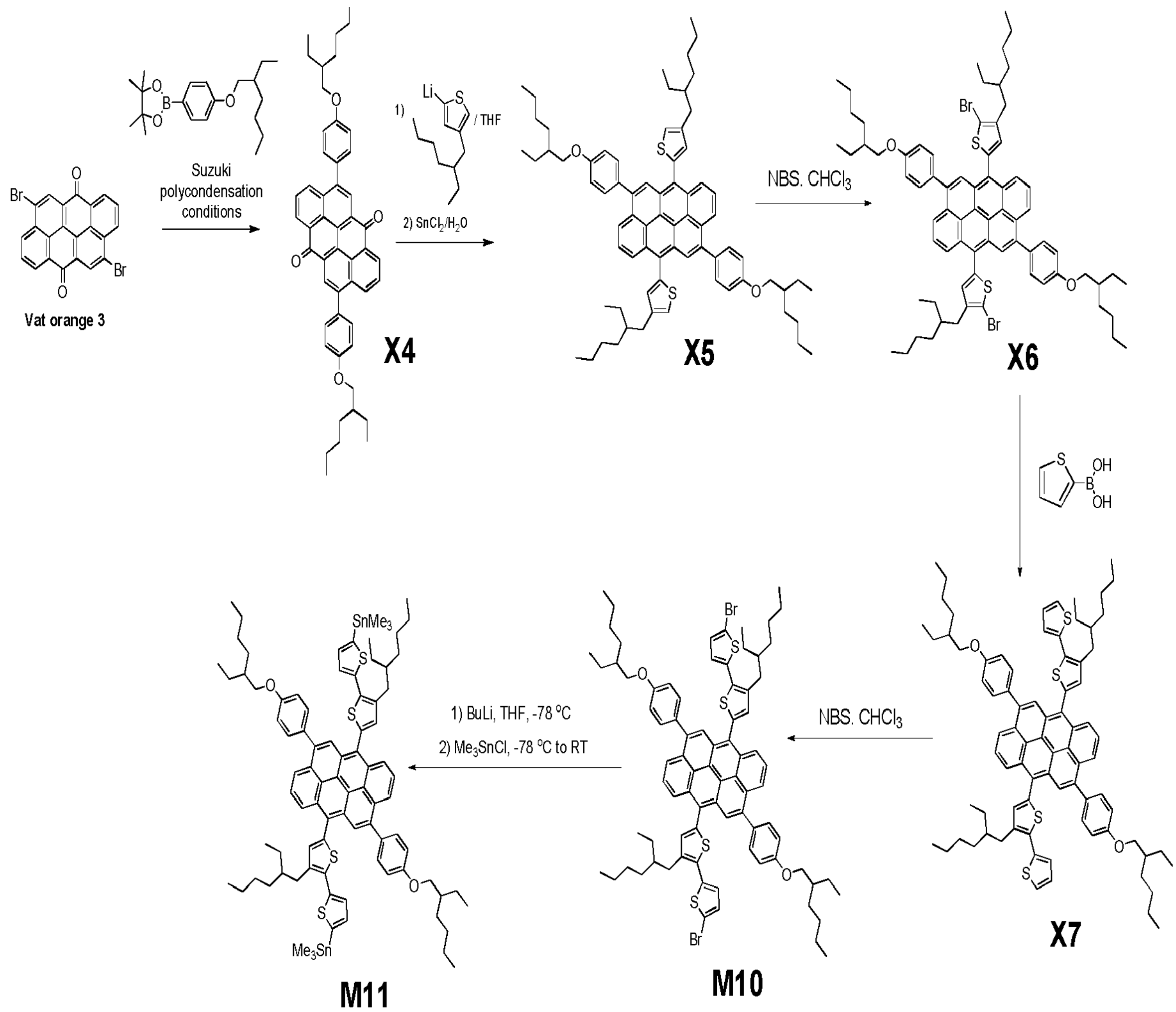

Vat orange 3 X4 X5 X6 X7 M10 M11

Scheme 10

Monomer **M11** (A=SnMe3) can be obtained from **M10** using the procedure described above for conversion of **M1** to **M3 (Scheme 7).**

It will be understood that the specification and examples are illustrative but not limitative of the present invention and that other embodiments within the spirit and scope of the invention will suggest themselves to those skilled in the art.

## EXAMPLES

Examples will be shown below for illustrating the present invention further in detail, but the present invention is not limited to them.

The polystyrene-equivalent number average molecular weight and weight average molecular weight were measured by using size exclusion chromatography (SEC) (LC-20AD manufactured by Shimadzu Corporation).

Analysis conditions

A polymer of formula (I') to be measured (1 mg) was dissolved in small amount of 1,2-dichlorbenzene (0.2-0.5 mL) and the resulting solution was diluted with 5-10 mL of tetrahydrofuran. The prepared solution was injected in an amount of 20 μL into SES (LC-20AD GPC instrument). Tetrahydrofuran was used as a mobile phase of SEC, the flow rate was 0.3 ml/min. Phenomenex 300x7.8 mm column filled with Phenogel particles ($10^4$ Å) was used for analysis. The column was pre-calibrated against a series of polystyrene standards (1000-750000 g/mol, Fluka).

**Example 1** (Synthesis of polymer **P1**)

The conjugated polymer **P1** was synthesized according to the following reaction:

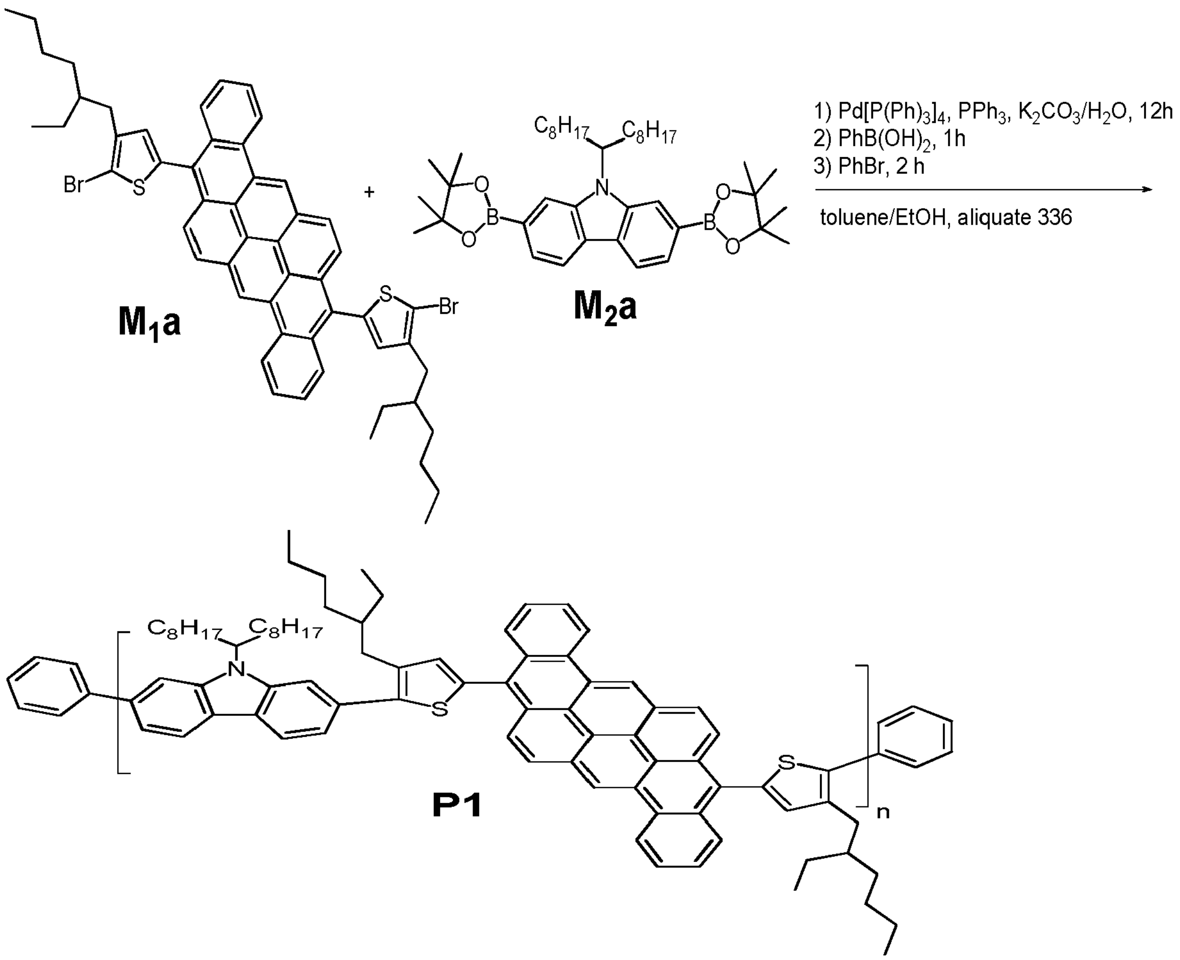


M1a + M2a

P1

Monomers **M1a** (922 mg, 1.0 mmol) and **M2a** (657.6 mg, 1.0 mmol) were introduced into a 50 mL round-bottom three necked flask equipped with a thermometer and reversed condenser. Toluene (25 mL), 2molar aqueous solution

of $K_2CO_3$ (2 mL), anhydrous ethanol (5 mL), aliquat 336 (1 drop, ca. 80 mg) and tetrakis(triphenylphosphine)palladium(0) (10 mg) were added in the here listed sequence. The reaction mixture was deaerated using repeating cycles of freezing in liquid nitrogen, evacuation, filling with argon, and heating up to room temperature. The reaction flask with the deaerated mixture of reagents was immersed into an oil bath and heated at reflux for 12-24 hours. The molecular weight characteristics of the formed product were controlled every 30 min. The reaction was stopped when the weight average molecular weight $M_w$ showed no increase within 3 hrs. The mixture was cooled down to the room temperature, the polymer was extracted with 500 mL of toluene, the resulting solution was washed 3 times with deionised water (250 mL), dried and concentrated in vacuum (rotary evaporator) to 40 mL. Addition of 150 mL of methanol precipitated the crude polymer. Subsequent purification was achieved using several additional dissolving/precipitation cycles. Finally, the precipitated polymer flakes were filtered out and dried in vacuum. The yield of the purified polymer **P1** varied between 70% and 80% depending on the applied number of dissolving/precipitation cycles. The prepared sample of **P1** showed the following molecular weight characteristics: $M_w$=9000 g/mol, $M_n$=5300 g/mol.

<u>**Example 2** (Synthesis of polymer **P2**)</u>

The conjugated polymer **P2** was synthesized according to the following reaction:

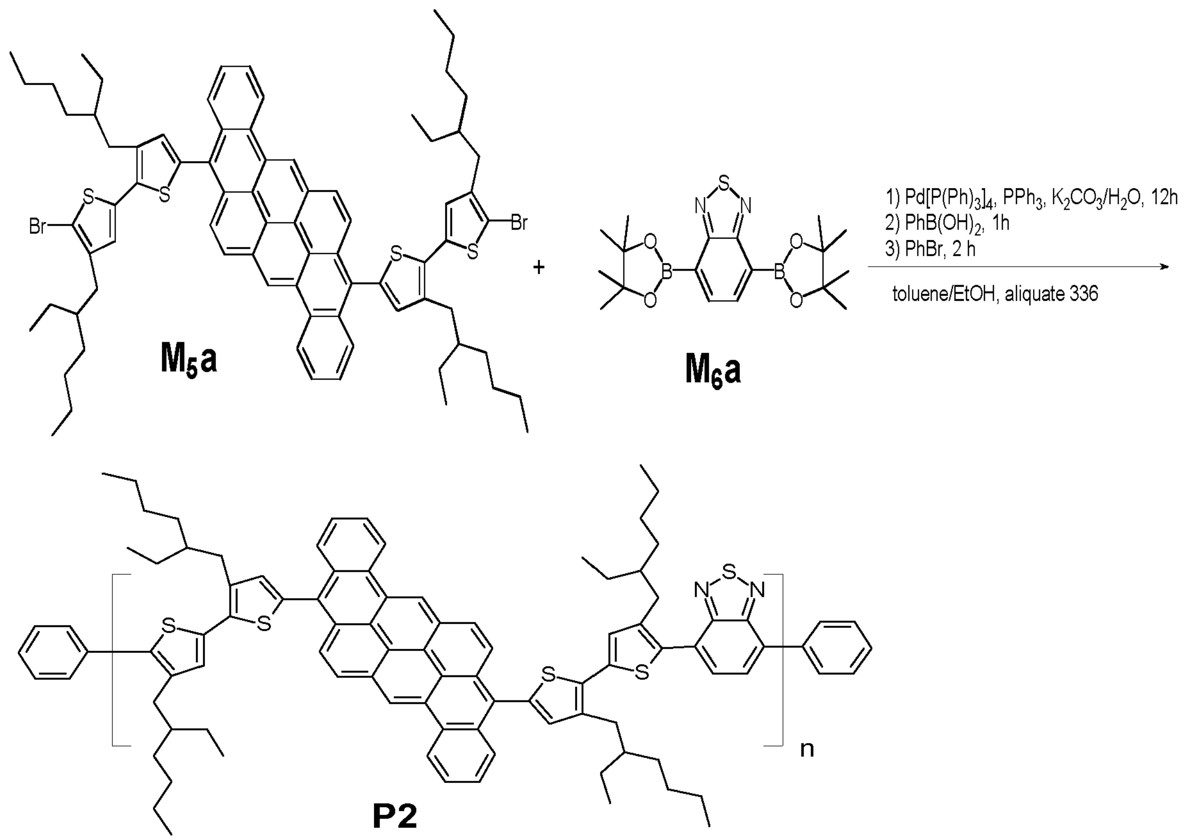


$M_5a$ $M_6a$

P2

The polymer **P2** was synthesized starting from 0.1 mmol of **M5a** (1.311 g) and 0.1 mmol (388 mg) of **M6a.** The experimental procedure used for preparation and isolation of the polymer **P2** is completely identical to the one described in Example 1 for **P1.** The prepared sample of polymer **P2** showed the following molecular weight characteristics: $M_w$=40300 g/mol, $M_n$=24600 g/mol.

<u>**Example 3** (Synthesis of polymer **P3**)</u>

The conjugated polymer **P3** was synthesized according to the following reaction:

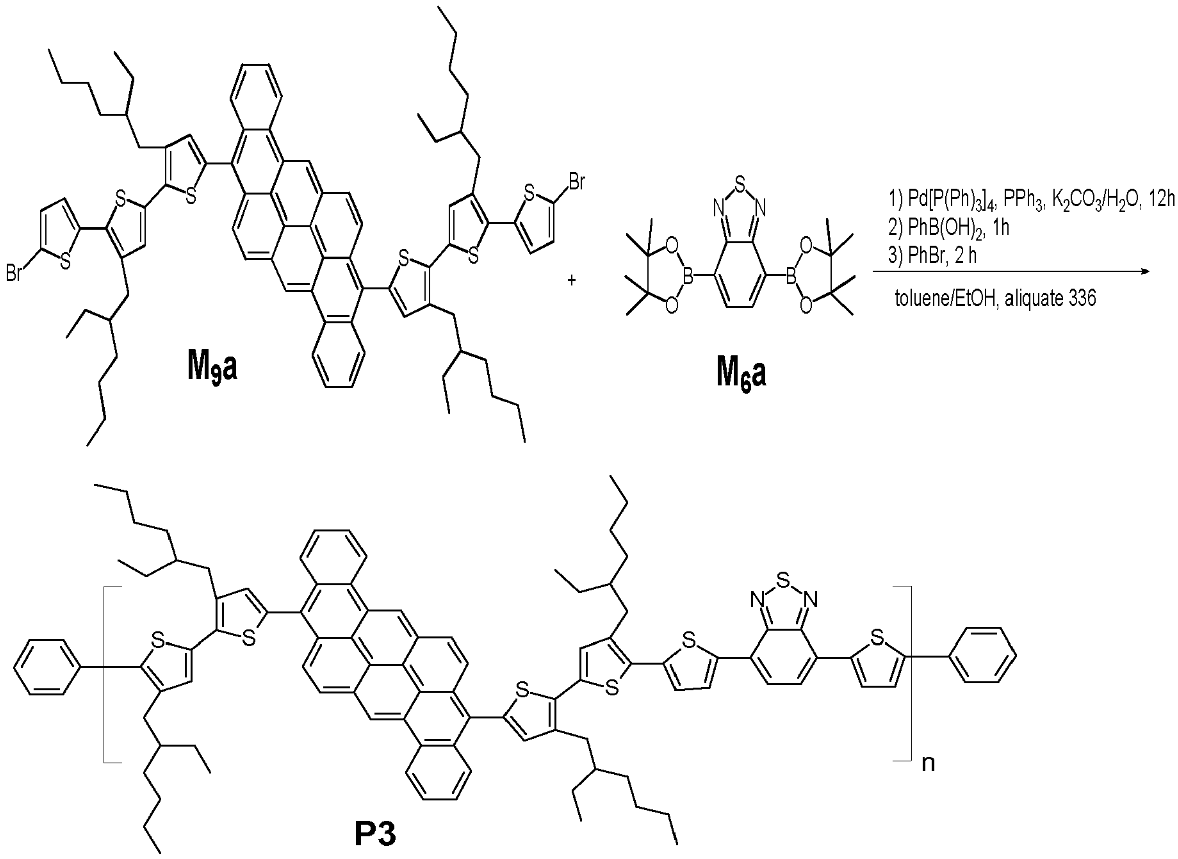


M9a M6a

P3

The polymer **P3** was synthesized starting from 0.1 mmol of **M9a** (1.489 g) and 0.1 mmol (388 mg) of **M6a.** The experimental procedure used for preparation and isolation of the polymer **P3** is completely identical to the one described in Example 1 for **P1.** The prepared sample of **P3** showed the following molecular weight characteristics: $M_w$=30000 g/mol, $M_n$=17100 g/mol.

<u>**Example 4** (Synthesis of polymer **P4**)</u>

The conjugated polymer **P4** was synthesized according to the following reaction:

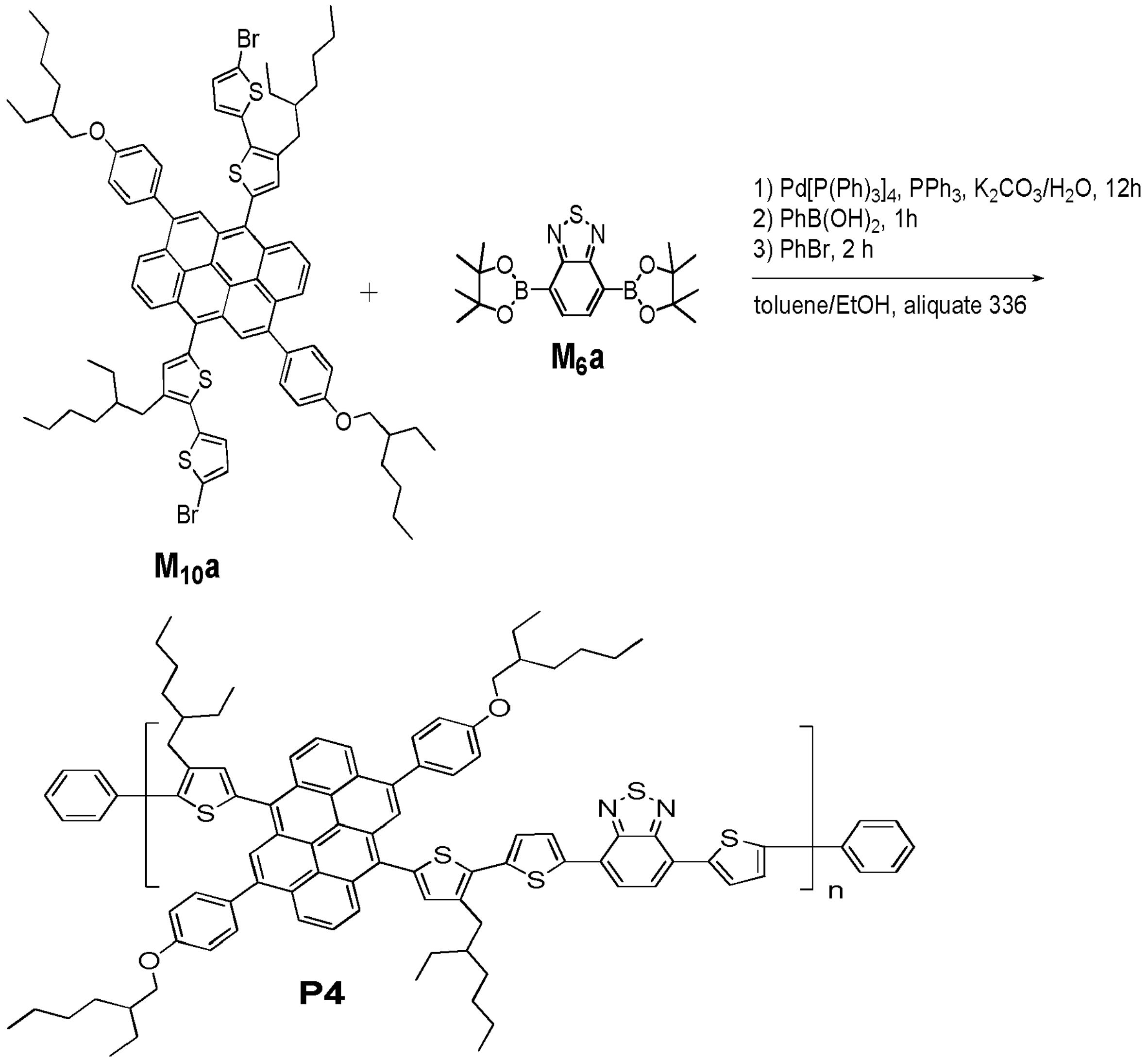


$M_{10}a$ $M_6a$ P4

The polymer P4 was synthesized starting from 0.1 mmol of M10a (1.3957 g) and 0.1 mmol (388 mg) of **M6a.** The experimental procedure used for preparation and isolation of the polymer **P4** is completely identical to the one described in Example 1 for **P1.** The prepared sample of **P4** showed the following molecular weight characteristics: $M_w$=12200 g/mol, $M_n$=6500 g/mol.

<u>**Example 5**</u> <u>(Fabrication and evaluation of organic thin film solar battery)</u>

A photovoltaic cell, according to the present invention, was constructed in the following way. The patterned ITO-coated glass substrates (25 x 25 mm) were sonicated consecutively with acetone, isopropyl alcohol, and deionized water for 10 min. Subsequently, PEDOT:PSS (Clevios HTL Solar) was spin-coated on the ITO-coated glass substrates at 3000 rpm. The resulting films were dried in air at 180 °C for 15 min. Then the substrates were cooled down to 70 °C (or to the room temperature) and a photoactive blend comprising one of the polymers **P1-P4** and fullerene derivative [60]PCBM was deposited on top.

PEDOT:PSS or poly(3,4-ethylenedioxythiophene) : poly(styrenesulfonate) is a polymer mixture of two ionomers. One component in this mixture is made up of sodium polystyrene sulfonate which is a sulfonated polystyrene. Part of the sulfonyl groups are deprotonated and carry a negative charge. The other component poly(3,4-ethylenedioxythiophene) or PEDOT is a conjugated polymer and carries positive charges and is based on polythiophene. Together the charged macromolecules form a macromolecular salt.

The photoactive blend solution was prepared as follows. In each case 9 mg of one of the polymers **P1, P2, P3** and **P4** and fullerene derivative [60]PCBM (9, 18, 27 or 36 mg) were dissolved together in 1,2-dichlorobenzene (DCB). The blend solution was stirred for 36 hrs at 45 °C. The resulting polymer/fullerene solution was filtered through a PTFE syringe (0.4 μm) (PTFE = polytetrafluoroethylene) and spin-coated at 900-1100 rpm for 70 sec. on ITO/PEDOT:PSS

substrates. The dried samples were subsequently annealed at 90°C for 5 min in an argon glovebox. The top electrode comprising 20 nm of Ca and 100 nm of Ag was deposited by thermal evaporation in the vacuum of $10^{-6}$ mbar.

The current-voltage (I-V) characteristics of the devices were obtained in dark and under the simulated 100 mW/cm$^2$ AM1.5 solar irradiation provided by a KHS Steuernagel solar simulator obtainable from K.H.Steuernagel Lichttechnik GmbH, Mörfelden-Walldorf, Germany. The intensity of the illumination was checked every time before the measurements using a calibrated silicon diode with known spectral response. The photocurrent spectra were measured with a SR 830 lock-in amplifier ( SRS Inc., Stanford Research Systems, Sunnyvale, California) using the monochromated light from a 150W Xe lamp as excitation. Integration of the experimental IPCE spectra over real AM1.5 irradiation spectrum was used to check the short circuit current densities obtained from the I-V curves (IPCE =Incident photon-to-current efficiency).

The parameters of the best photovoltaic cells calculated from the current-voltage (I-V) curves are listed in Table 1. It is seen from the table that the best solar cells comprising polymer **P3** and [60]PCBM provided $J_{SC}$ (short circuit current density) of 5.5 mA/cm$^2$, $V_{OC}$ (open circuit voltage) of 0.737 V, FF (fill factor) of 34%, and photoelectric conversion efficiency ($\eta$) of 1.4%. The I-V curves for the best devices are presented in **Fig. 1** showing dark and light-on I-V curves for a solar battery based on polymer **P3** and [60]PCBM.

Table 1 Parameters of solar batteries comprising polymers **P1-P4**

| Photoactive layer composition | $V_{OC}$, mV | $J_{SC}$, mA/cm$^2$ | FF, % | $\eta$, % |
|---|---|---|---|---|
| **P1**+[60]PCBM, 1:3 w/w | 690 | 3.8 | 37 | 1.0 |
| **P2**+[60]PCBM, 1:4 w/w | 720 | 3.9 | 35 | 1.0 |
| **P3**+[60]PCBM, 1:3 w/w | 737 | 5.5 | 34 | 1.4 |
| **P4**+[60]PCBM, 1:2 w/w | 660 | 2.7 | 36 | 0.6 |

## Claims

**1.** A polymer comprising a conjugated backbone with repeating units represented by formula (I)

-[-X-A-X-]- (I)

containing at least one planar aromatic system A selected from the list

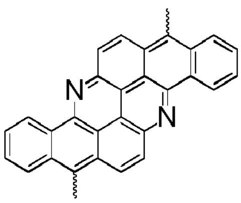
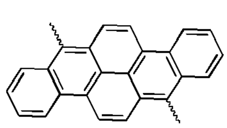
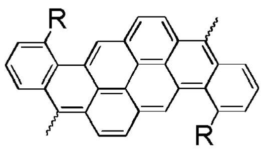
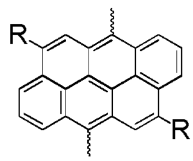
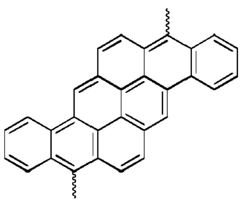
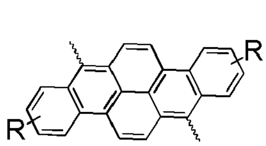
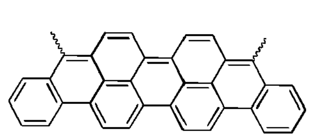
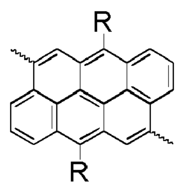
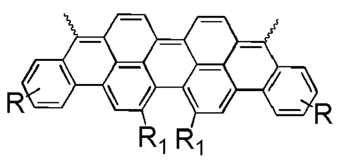
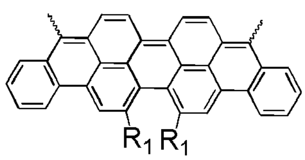
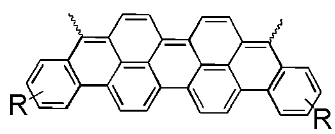

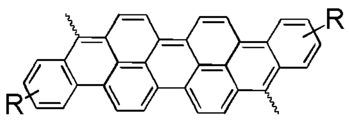

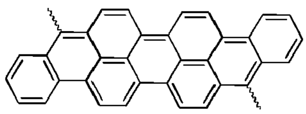

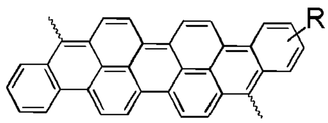

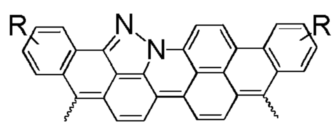

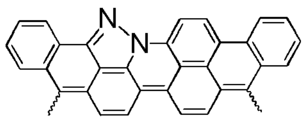

wherein

wavy bond 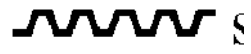 shows the attachment positions of X-blocks in formula (I);

R represents an aryl or a heteroaryl group which is non-substituted or substituted with a solubilizing group selected from $C_1$-$C_{20}$ alkyl or $C_1$-$C_{20}$ alkoxy,
$R_1$ represents a $C_1$-$C_{20}$ alkoxy group or a $C_1$-$C_{20}$ alkylthio group,
X in each case independent from each other represents a divalent acetylene fragment $X_1$ or a thiophene unit $X_2$

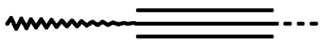

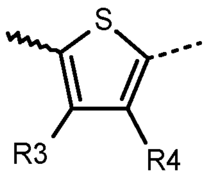

$X_1$ $X_2$

wherein
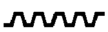 represents a wavy bond as the attachment position(s) of A in formula (I) and
R3 and R4 are the same or mutually different and represent a hydrogen atom, an alkyl group, an alkoxy group or an alkylthio group.

**2.** A polymer according to Claim 1 **characterized in that** the repeating unit is represented by formula (II)

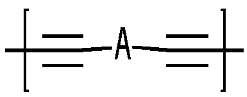 (II)

wherein A represents a planar aromatic system selected from the list

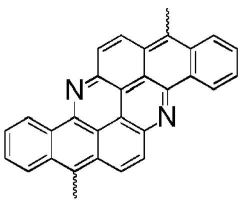

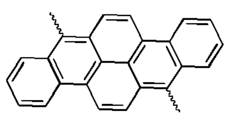

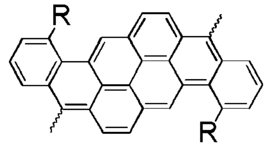

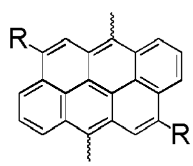

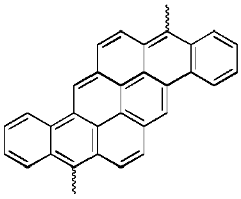 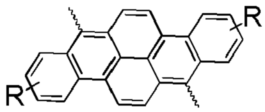 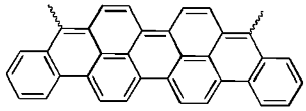 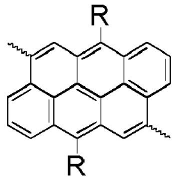

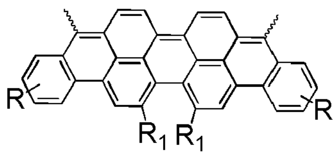 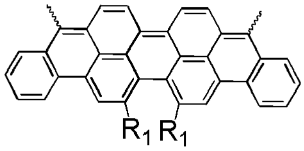 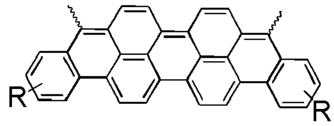

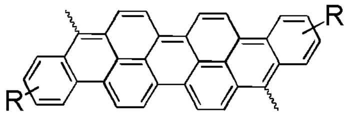 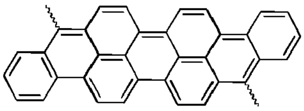 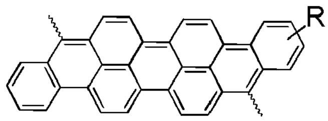

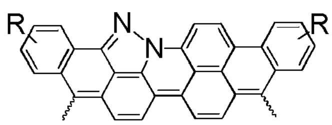 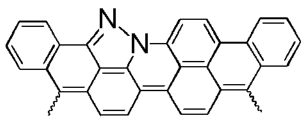

and

wavy bond 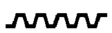 shows the attachment positions of the acetylene fragment in formula (II);

R represents an aryl or a heteroaryl group which is non-substituted or substituted with a solubilizing group selected from $C_1$-$C_{20}$ alkyl or $C_1$-$C_{20}$ alkoxy, and

$R_1$ represents a $C_1$-$C_{20}$ alkoxy group or a $C_1$-$C_{20}$ alkylthio group.

**3.** A polymer according to Claim 1 **characterized in that** the repeating unit is represented by formula (III)

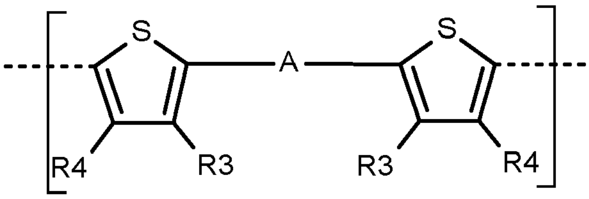

(III)

wherein A represents a planar aromatic system selected from the list

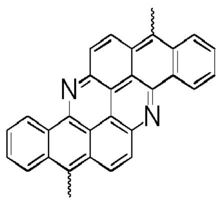 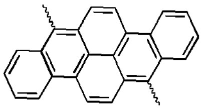 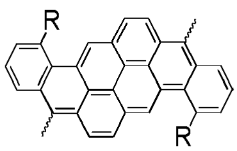 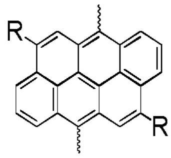

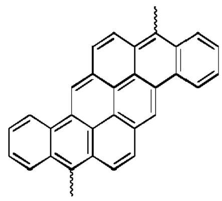
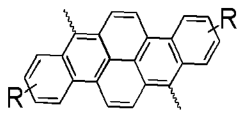
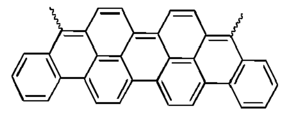
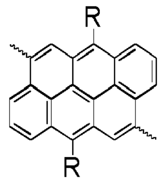

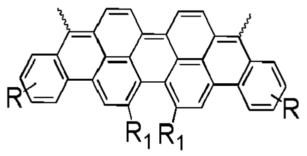
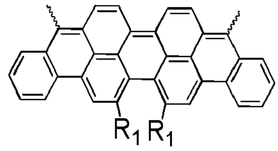
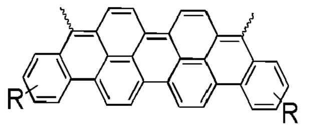

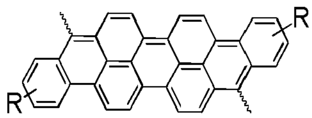
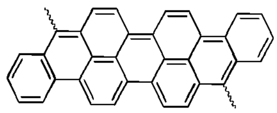
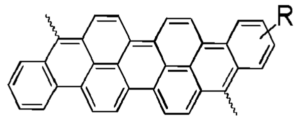

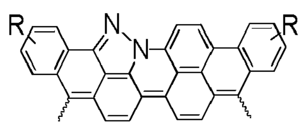
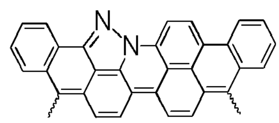

and wavy bond 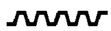 shows the attachment positions of the thiophene-blocks in formula (III);

R represents an aryl or a heteroaryl group which is non-substituted or substituted with a solubilizing group selected from $C_1$-$C_{20}$ alkyl or $C_1$-$C_{20}$ alkoxy,
$R_1$ represents a $C_1$-$C_{20}$ alkoxy group or a $C_1$-$C_{20}$ alkylthio group, and
R3 and R4 are the same or mutually different and represent independent from each other a hydrogen atom, an alkyl group, an alkoxy group or an alkylthio group.

**4.** A polymer represented by formula (I')

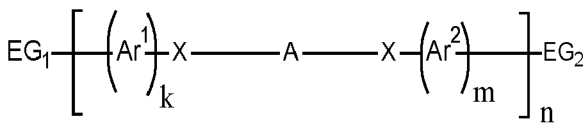

(I')

wherein

A represents a planar aromatic system selected from the list

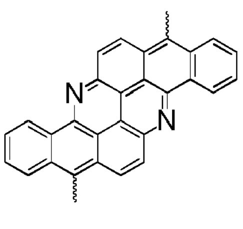
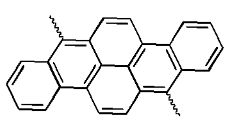
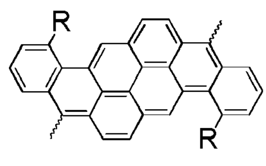
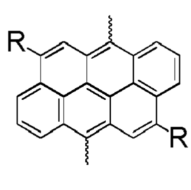

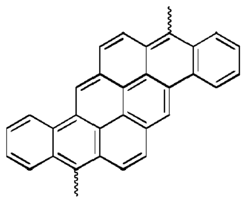 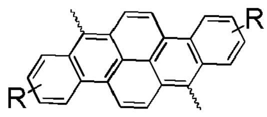 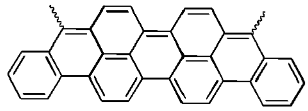 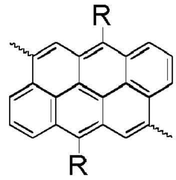

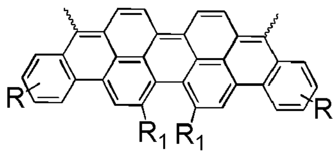 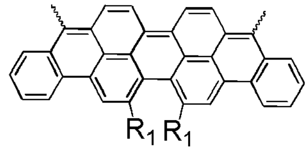 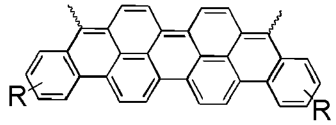

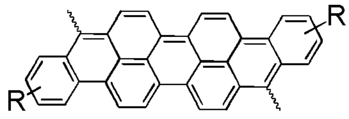 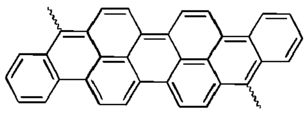 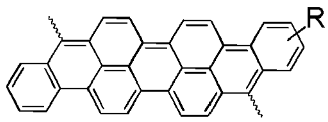

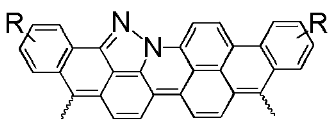 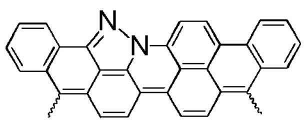

and

wavy bond shows the attachment positions of the X-blocks in formula (I');

R represents an aryl or a heteroaryl group which is non-substituted or substituted with a solubilizing group selected from $C_1$-$C_{20}$ alkyl or $C_1$-$C_{20}$ alkoxy,

$R_1$ represents a $C_1$-$C_{20}$ alkoxy group or a $C_1$-$C_{20}$ alkylthio group,

$Ar^1$ and $Ar^2$ are the same or mutually different and independent from each other represent A divalent arylene group, a divalent heterocyclic group, or a divalent aromatic amine residue,

k represents the number of $Ar^1$ units connected in series in the repeating unit of the conjugated polymer and is a number between 0 and 3, preferably from 1 to 3,

m represents a number of $Ar^2$ units connected in series in the repeating unit of the conjugated polymer and is a number between 0 and 3, preferably from 1 to 3;

n represents an integer from 2 to 2000, preferably from 2 to 200,

$EG_1$ and $EG_2$ are the end groups of the polymer and independent from each other they represent a hydrogen, a halogen, a trialkylstannyl unit (-Sn(Alkyl)$_3$), a boronic acid unit(-B(OH)$_2$), a boronic ester unit (-B(OAlkyl)$_2$), an aryl unit or a heteroaryl unit and

X represents in each case independent from each other a divalent acetylene fragment $X_1$ or a thiophene unit $X_2$

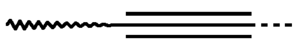

$X_1$

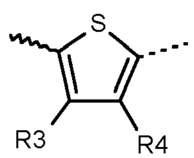

$X_2$

wherein

represents a wavy bond as the attachment position(s) of and

R3 and R4 are the same or mutually different and represent a hydrogen atom, an alkyl group, an alkoxy group

or an alkylthio group.

**5.** A polymer according to Claim 4, **characterized in that** $Ar^1$ or $Ar^2$ in formula (I'), the divalent arylene group, is selected from the group

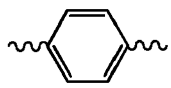
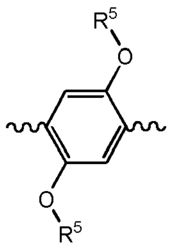
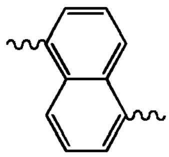
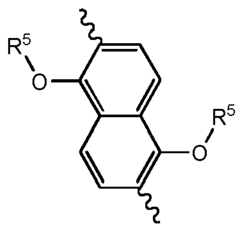
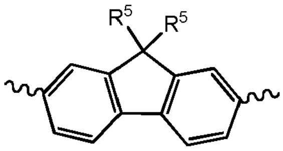
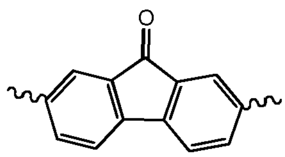
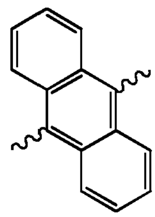
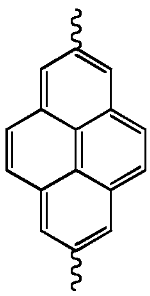
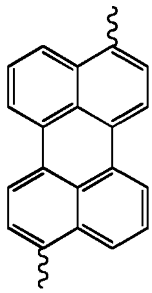

wherein $R^5$ represents a hydrogen atom or a $C_1$-$C_{20}$ alkyl chain.

**6.** A polymer according to Claim 4, **characterized in that** $Ar^1$ or $Ar^2$ in formula (I'), the divalent heterocyclic group, is selected from heterocycles from the group

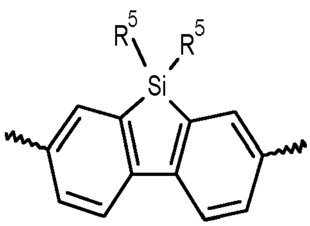
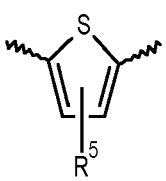
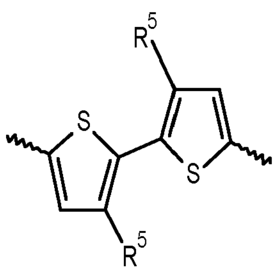
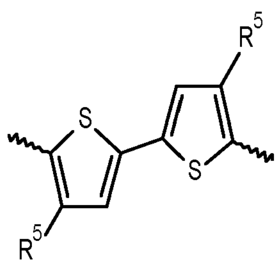

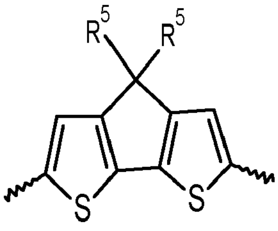
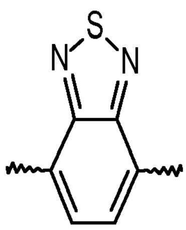
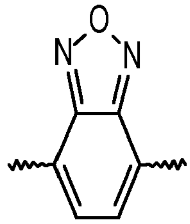
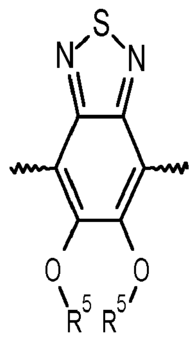
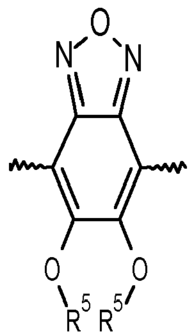

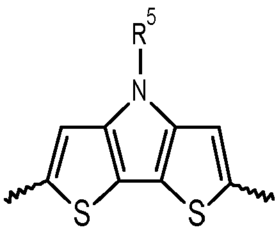
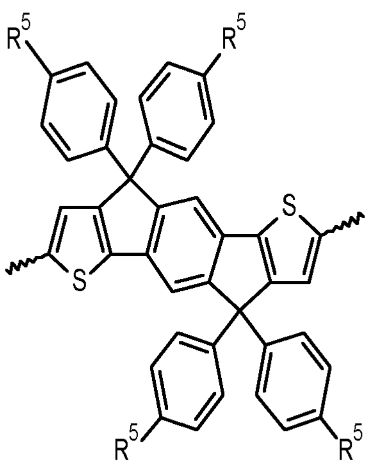
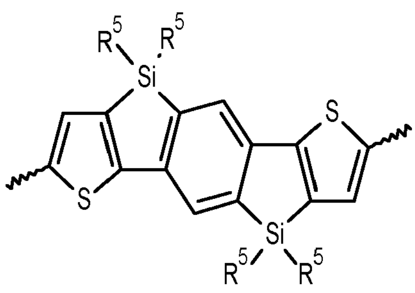

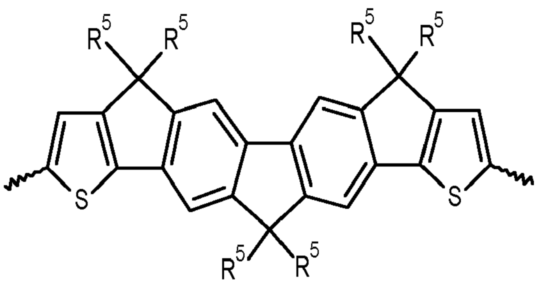
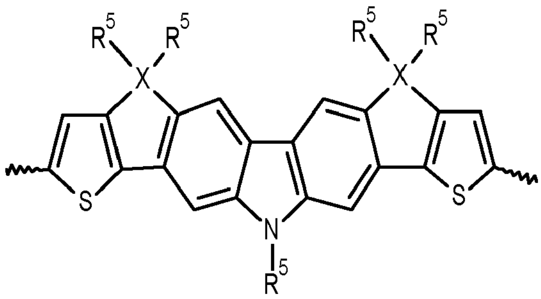

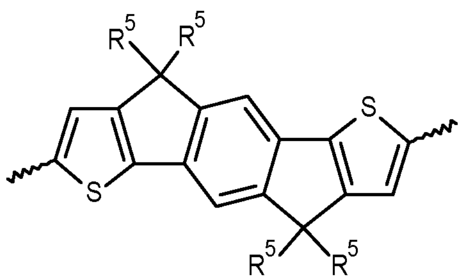
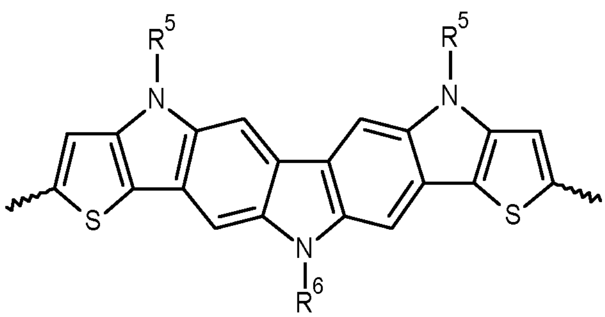

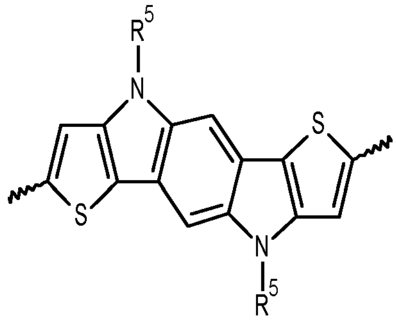
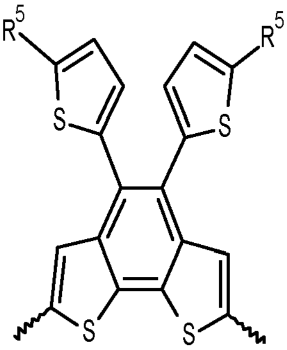
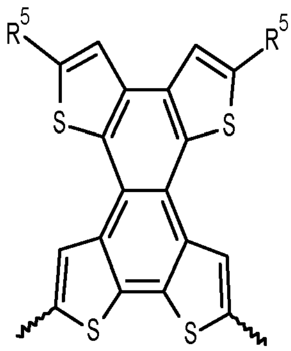

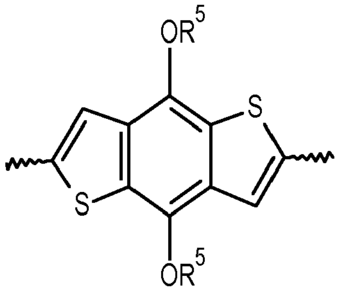
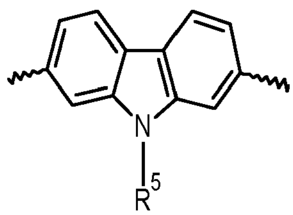
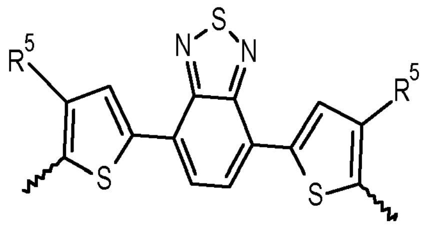

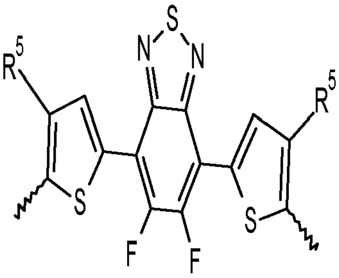
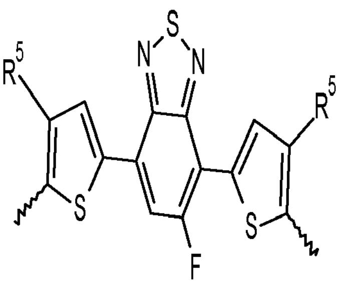
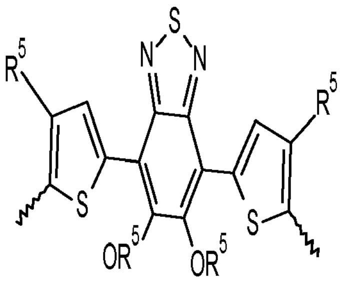

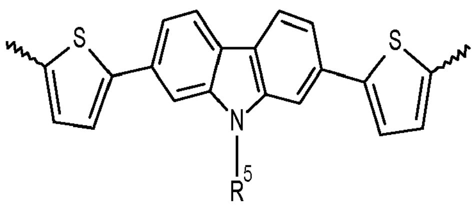
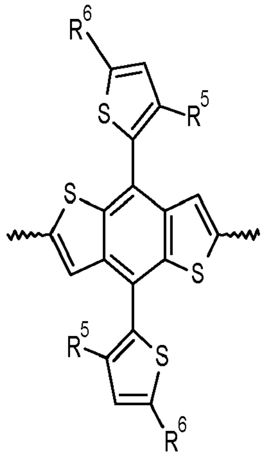
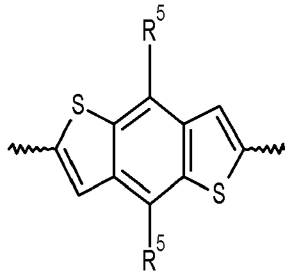

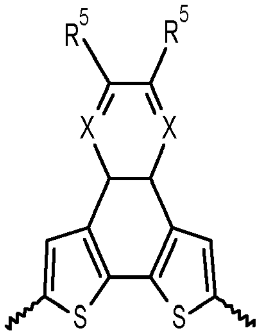

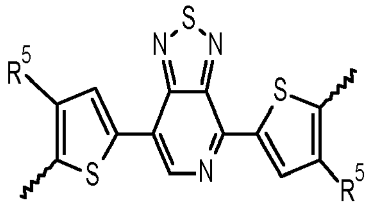

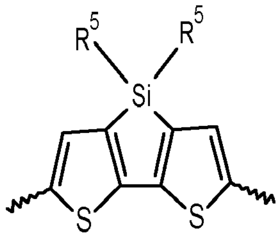

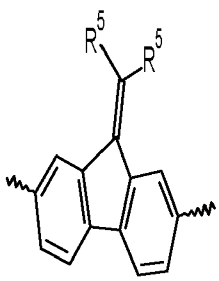

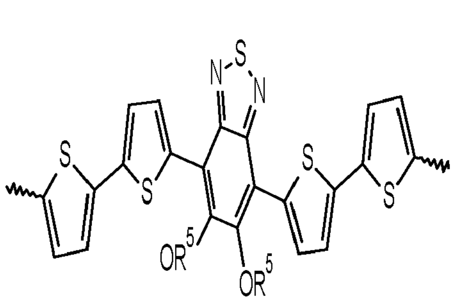

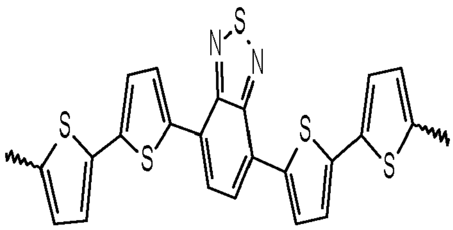

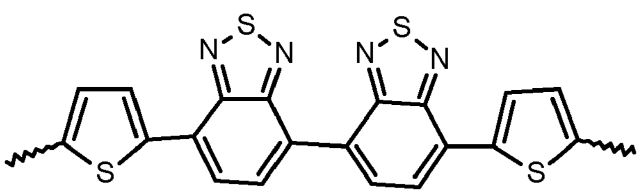

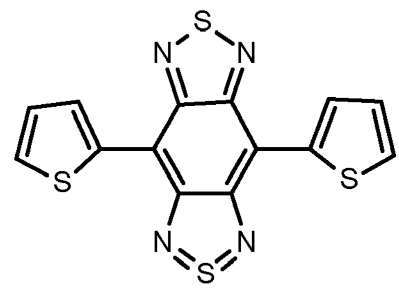

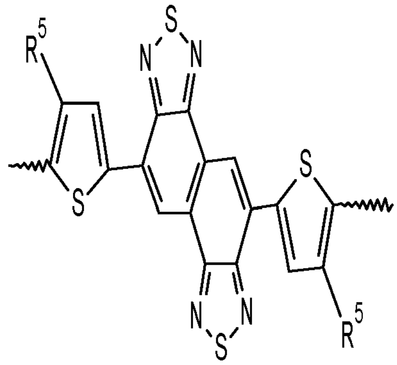

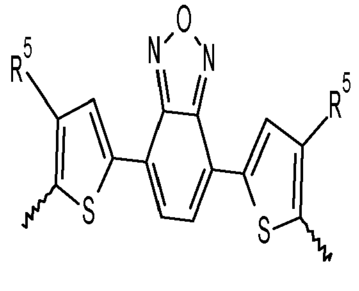

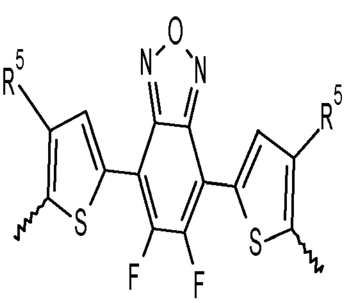

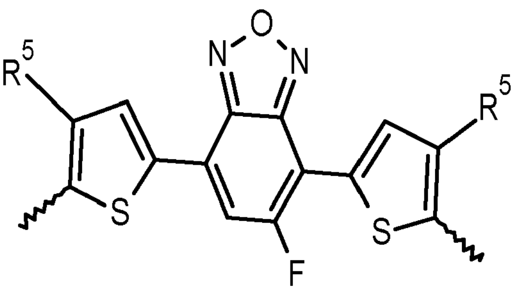

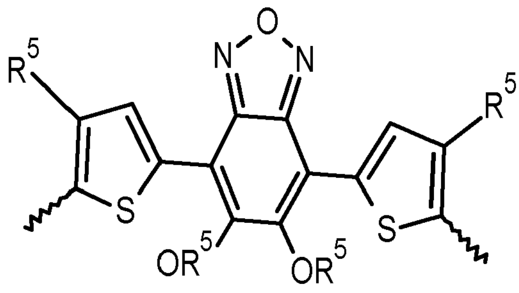

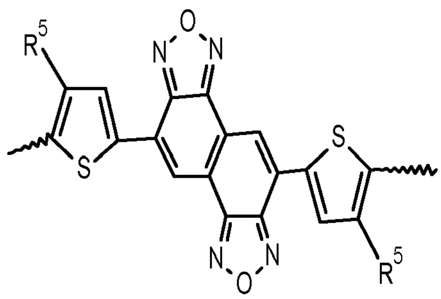

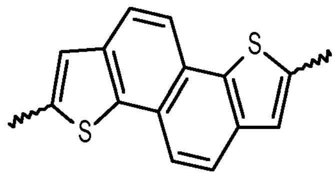

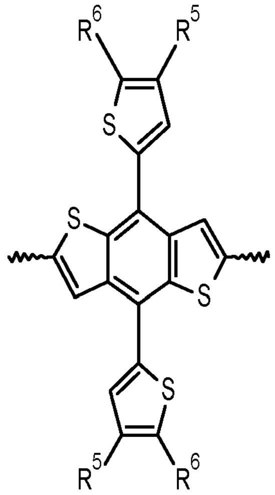

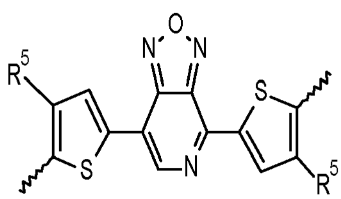

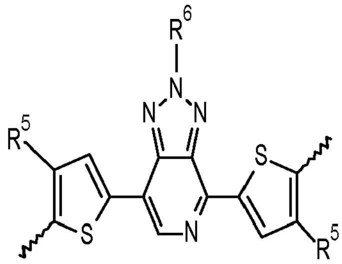

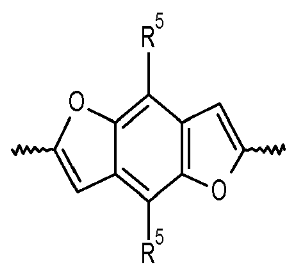

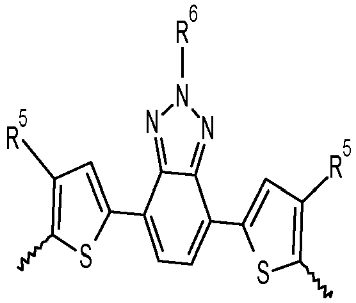

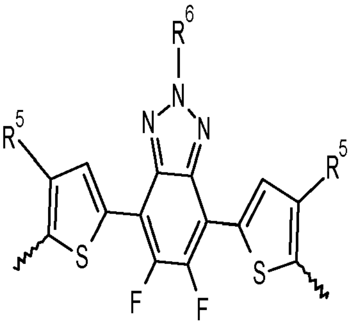

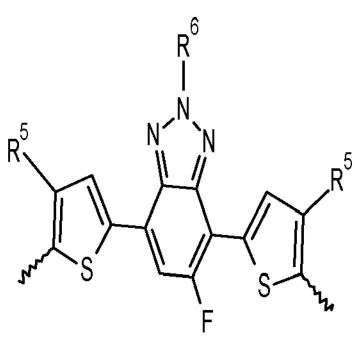

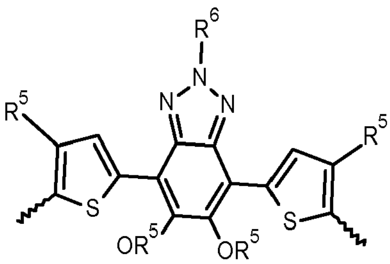
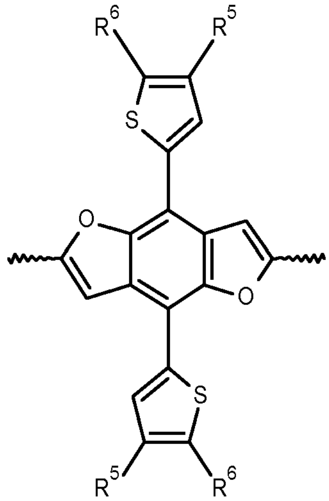
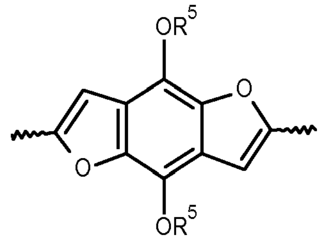

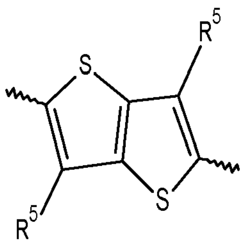
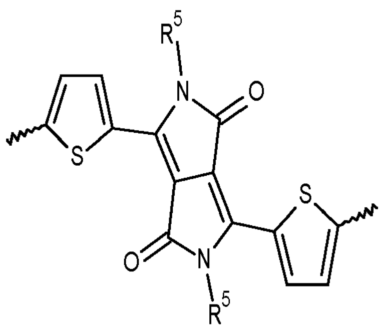
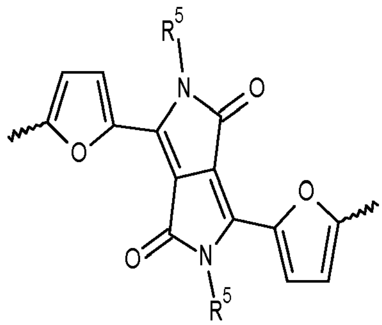

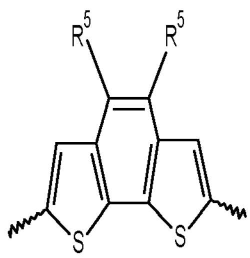
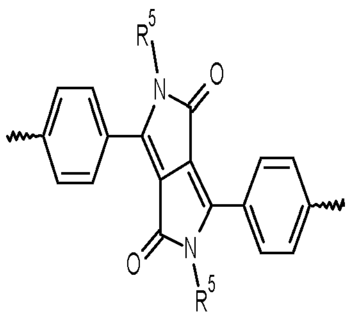
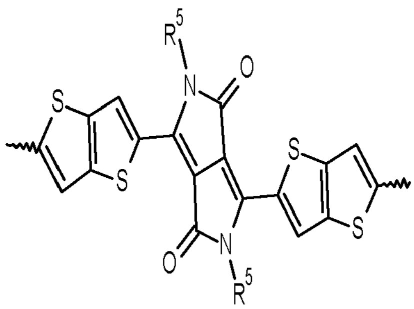

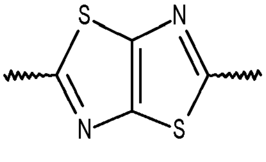
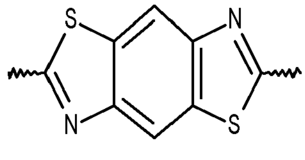
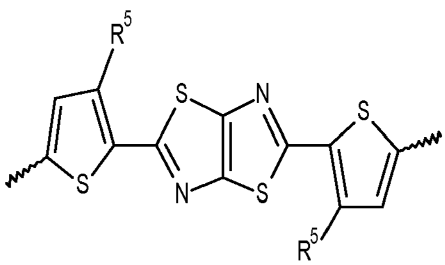

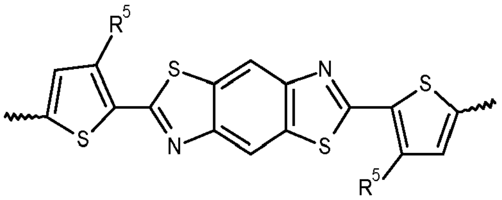

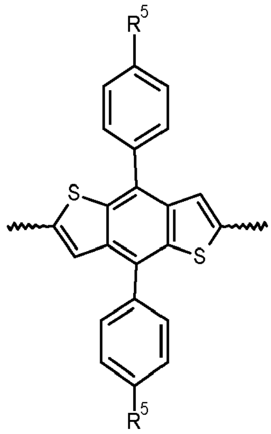

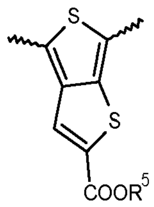

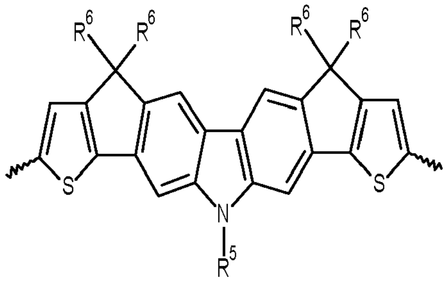

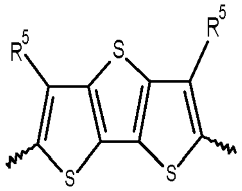

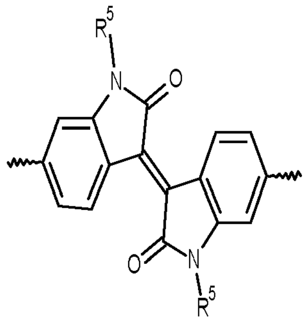

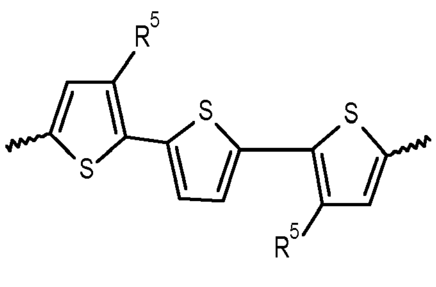

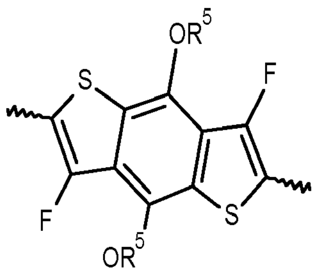

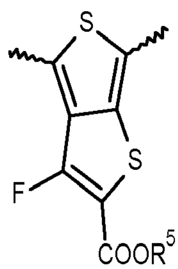

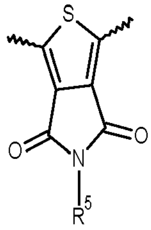

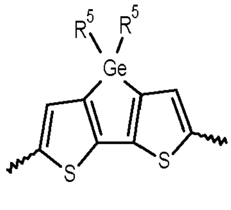

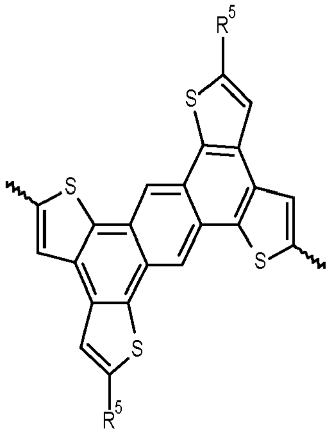

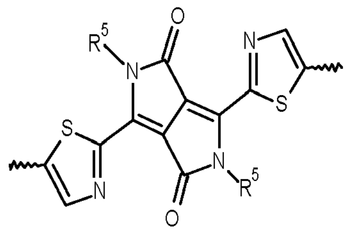

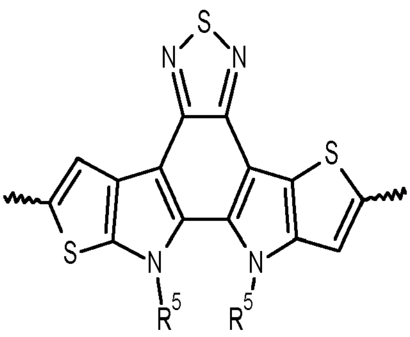

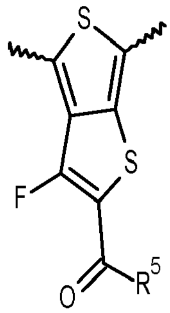

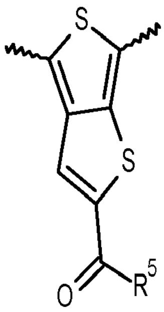

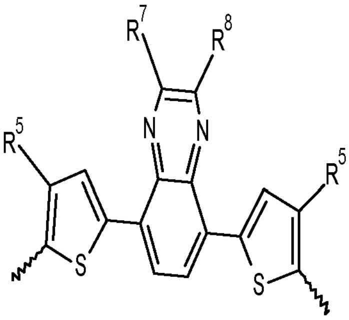

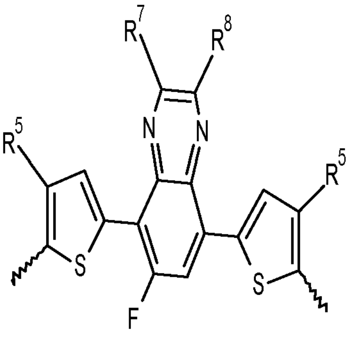

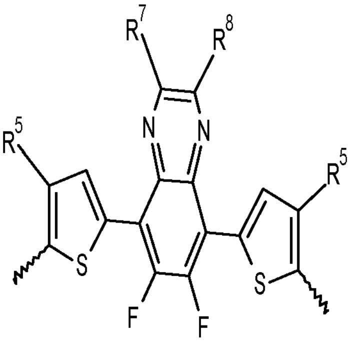

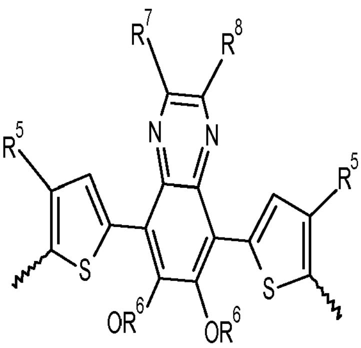

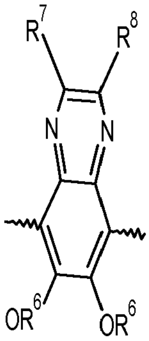

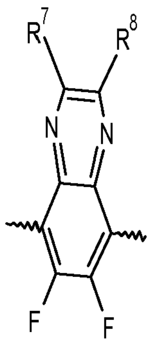

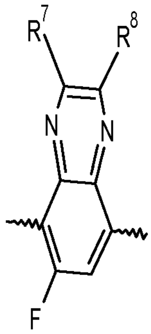

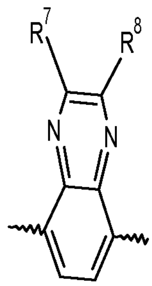

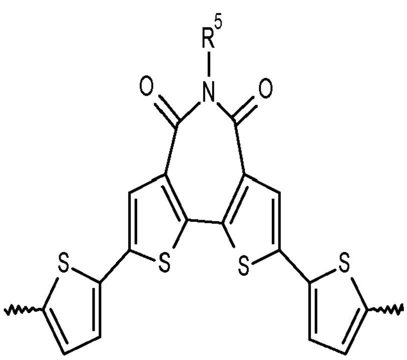

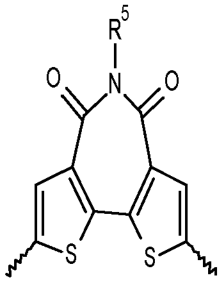

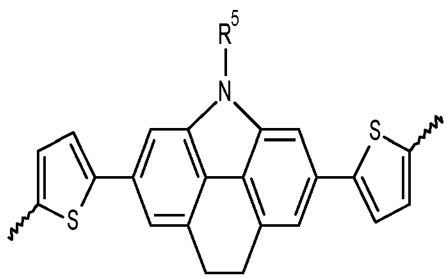

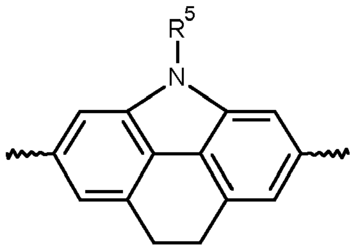

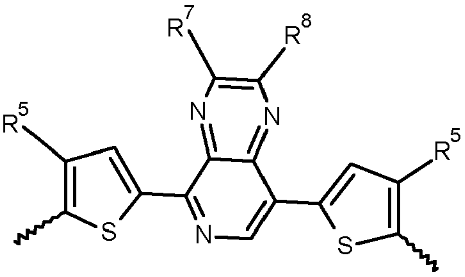

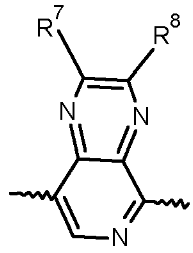

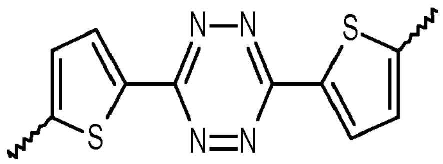

wherein $R^5$, $R^6$, $R^7$ and $R^8$ are the same or mutually different and represent in each case a hydrogen atom or a $C_1$-$C_{20}$ alkyl chain.

7. A polymer according to Claim 4, **characterized in that** $Ar^1$ or $Ar^2$ in formula (I'), the divalent aromatic amine residue, is selected from the group

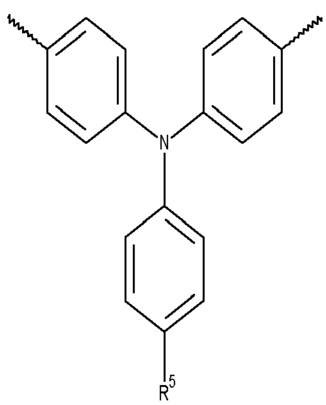

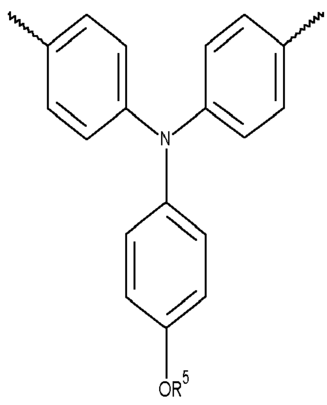

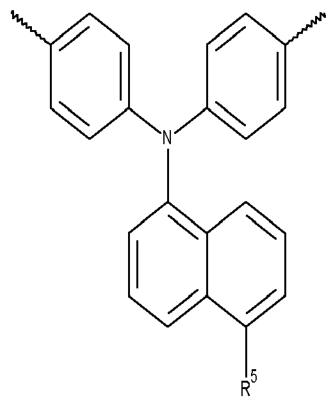

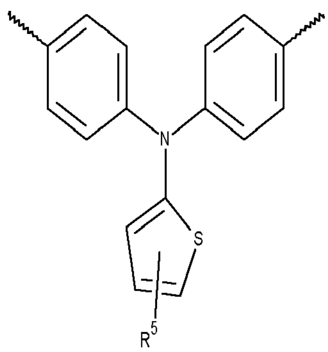

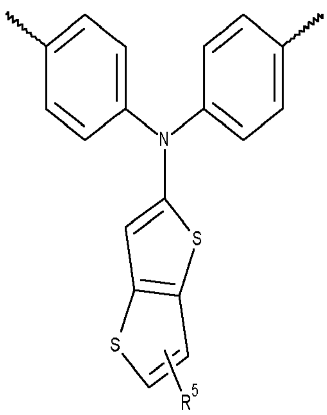

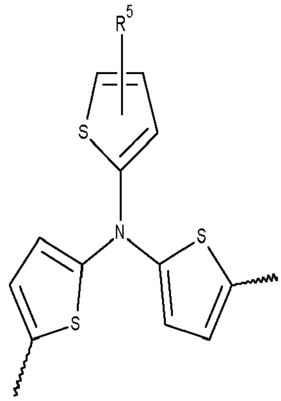

wherein $R^5$ represents a hydrogen atom or a $C_1$-$C_{20}$ alkyl chain.

**8.** A polymer according to one of Claims 4 to 7, **characterized in that** those comprise in their repeating unit at least one planar aromatic ring system A represented by formulas (IIa), (IIb), (IIc) or (IId):

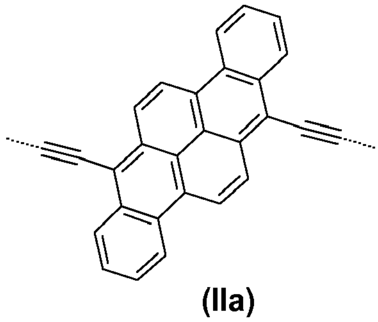

**(IIa)**

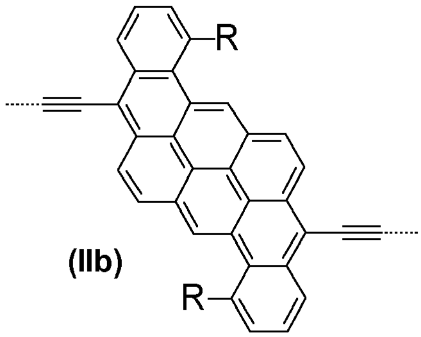

**(IIb)**

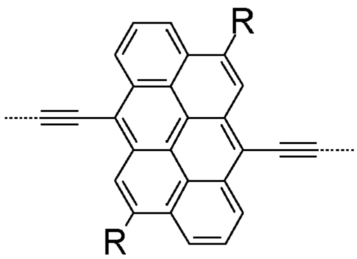

**(IIc)**

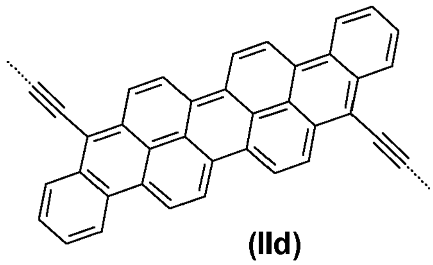

**(IId)**

wherein R represents an aryl or a heteroaryl group which is non-substituted or substituted with at least one solubilizing group selected from $C_1$-$C_{20}$ alkyl or $C_1$-$C_{20}$ alkoxy groups.

**9.** A polymer according to Claim 8, **characterized in that** R in formulas (IIa), (IIb), (IIc) and (IId) represents an aryl group selected from the list:

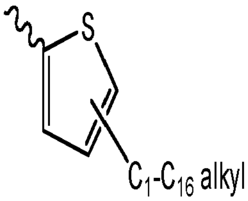
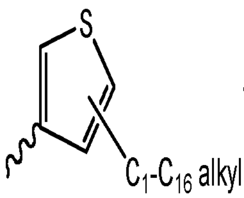
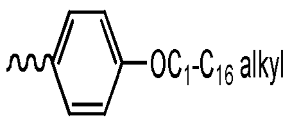
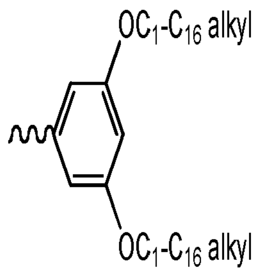

**10.** A polymer **characterized by** a formula of the group (II'a), (II'b), (II'c) or (II'd)

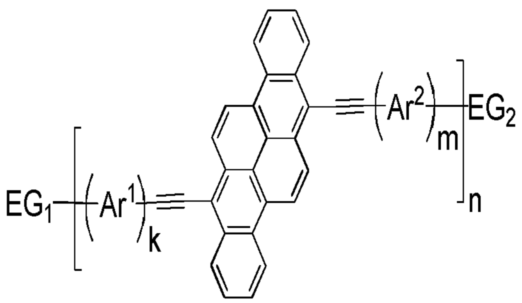

(II'a)

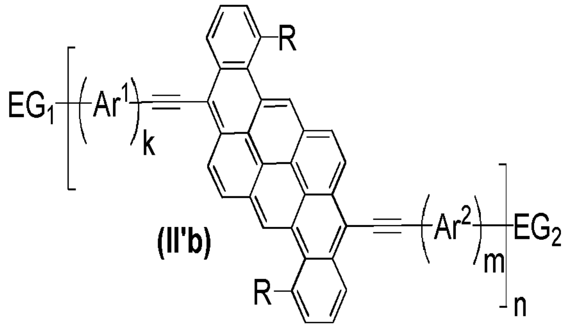

(II'b)

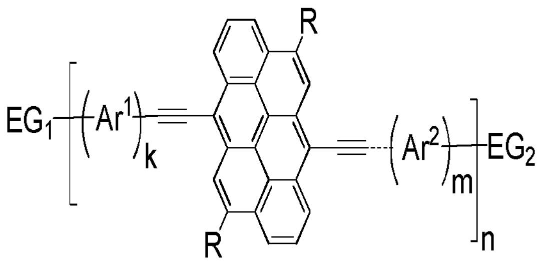

(II'c)

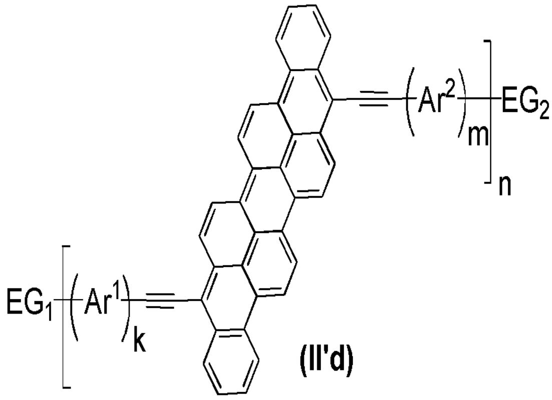

(II'd)

wherein
in each case $Ar^1$ and $Ar^2$ are the same or mutually different and independent from each other represent a divalent arylene group, a divalent heterocyclic group, or a divalent aromatic amine residue,
k represents in each case a number of $Ar^1$ units connected in series in the repeating unit of the conjugated polymer, preferably k is an integer from the numbers 0, 1, 2 or 3; and when k = 0 the polymer compound does not comprise an $Ar^1$ moiety;
m represents in each case a number of $Ar^2$ units connected in series in the repeating unit of the conjugated polymer, preferably m is an integer from the numbers 0, 1, 2 or 3; and when m = 0 the polymer compound does not comprise an $Ar^2$ moiety;
n is a number of repeating units, preferably an integer in the range from 2 to 2000,
$EG_1$ and $EG_2$ are the end groups of the respective polymer and in each case independent from each other those are selected from the group hydrogen, halogen, a trialkylstannyl group (-Sn(Alkyl)$_3$), a boronic acid group (-B(OH)$_2$), a boronic ester group (-B(OAlkyl)$_2$), an aryl unit or a heteroaryl unit.

**11.** A polymer **characterized by** formulas (III'a), (III'b), (III'c) or (III'd)

n

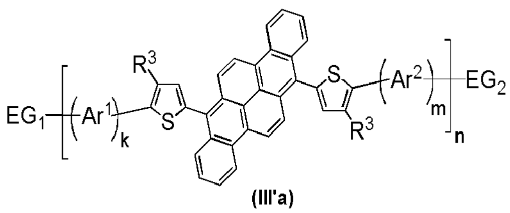

(III'a)

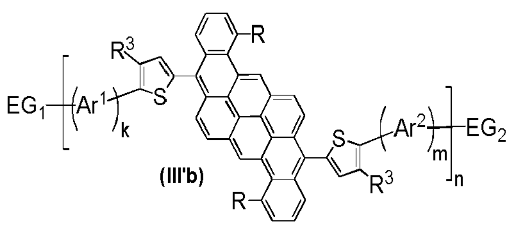

(III'b)

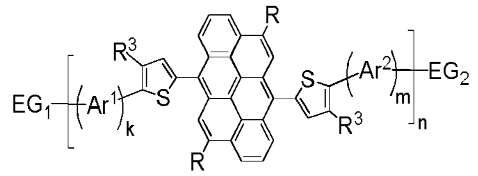

(III'c)

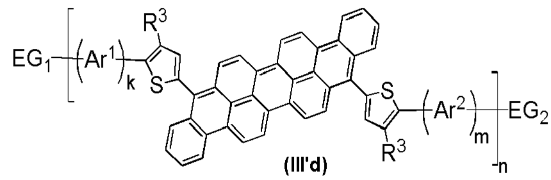

(III'd)

**characterized in that**

in each case $Ar^1$ and $Ar^2$ are the same or mutually different and represent independent from each other a divalent arylene group, a divalent heterocyclic group, or a divalent aromatic amine residue,
k represents in each case is the number of $Ar^1$ units connected in series in the repeating unit of the conjugated polymer, preferably k is an integer from the numbers 0, 1, 2 or 3; and when k = 0 the polymer compound does not comprise an $Ar^1$ moiety;
m in each case represents the number of $Ar^2$ units connected in series in the repeating unit of the conjugated polymer, preferably m is an integer from the numbers 0, 1, 2 or 3; and when m = 0 the polymer compound does not comprise an $Ar^2$ moiety;
n in each case is the number of repeating units, preferably an integer in the range from 2 to 2000,
R in each case represents an aryl or a heteroaryl group which is non-substituted or substituted with at least one solubilizing group selected from $C_1$-$C_{20}$ alkyl or $C_1$-$C_{20}$ alkoxy groups and $R^3$ in each case represents a hydrogen atom, an alkyl group, an alkoxy group or an alkylthio group, preferably $R^3$ represents a $C_1$-$C_{20}$ alkyl or a $C_1$-$C_{20}$ alkoxy group,
$EG_1$ and $EG_2$ in each case are the end groups of the respective polymer and independent from each other they represent hydrogen, halogen, a trialkylstannyl group (-Sn(Alkyl)$_3$), a boronic acid group (-B(OH)$_2$), a boronic ester group (-B(OAlkyl)$_2$), an aryl unit or a heteroaryl unit.

**12.** Combinations of at least one polymer represented by formula (I')

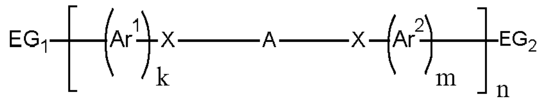

(I')

wherein

a represents a planar aromatic system selected from the list

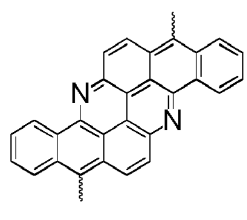

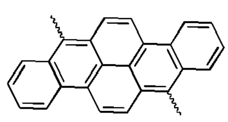

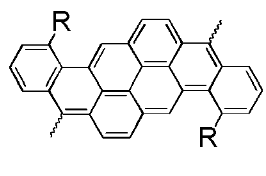

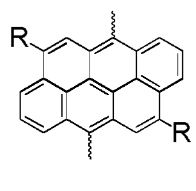

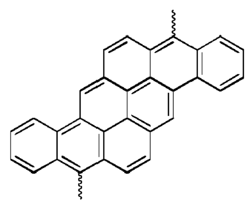

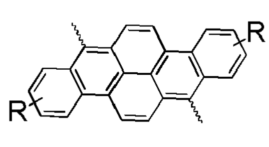

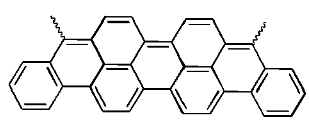

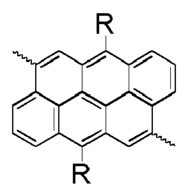

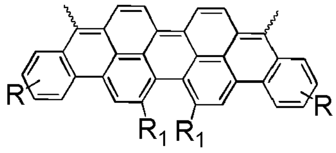 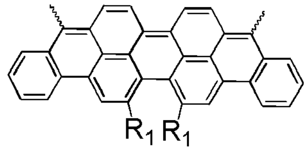 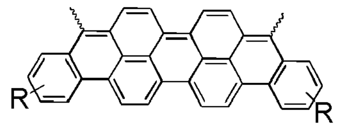

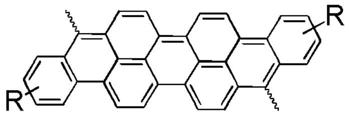 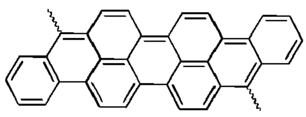 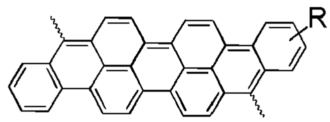

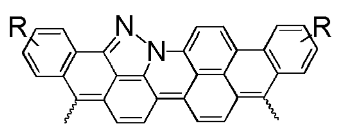 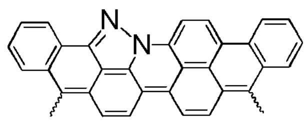

wavy bond shows the attachment positions of X-blocks in formula (I');

R represents an aryl or a heteroaryl group which is non-substituted or substituted with a solubilizing group selected from $C_1$-$C_{20}$ alkyl or $C_1$-$C_{20}$ alkoxy,
$R_1$ represents a $C_1$-$C_{20}$ alkoxy group or a $C_1$-$C_{20}$ alkylthio group,
$Ar^1$ and $Ar^2$ are the same or mutually different and independent from each other represent A divalent arylene group, a divalent heterocyclic group, or a divalent aromatic amine residue,
k represents the number of $Ar^1$ units connected in series in the repeating unit of the conjugated polymer and is a number between 0 and 3,
m represents a number of $Ar^2$ units connected in series in the repeating unit of the conjugated polymer and is a number between 0 and 3,
n represents an integer from 2 to 2000,
$EG_1$ and $EG_2$ are the end groups of the polymer and independent from each other they represent a hydrogen, a halogen, a trialkylstannyl unit (-Sn(Alkyl)$_3$), a boronic acid unit(-B(OH)$_2$), a boronic ester unit (-B(OAlkyl)$_2$), an aryl unit or a heteroaryl unit and
X represents in each case independent from each other a divalent acetylene fragment $X_1$ or a thiophene unit $X_2$,

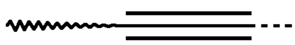

$X_1$

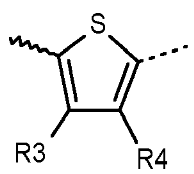

$X_2$

wherein
represents a wavy bond as the attachment position(s) of A and

R3 and R4 are the same or mutually different and represent a hydrogen atom, an alkyl group, an alkoxy group or an alkylthio group,
with at least one fullerene compound, preferably with at least one $C_{60}$ fullerene compound or at least one $C_{70}$ fullerene compound or their derivatives, more preferred with at least one $C_{60}$ fullerene compound or its derivatives, most preferred with [60]PCBM.

**13.** A process for the manufacture of polymers of formula (I')

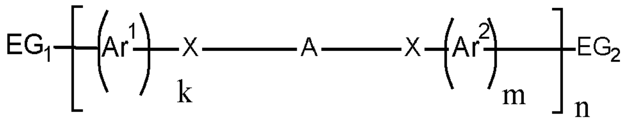

(I')

wherein

A represents a planar aromatic system selected from the list

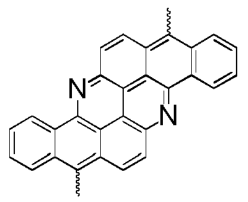
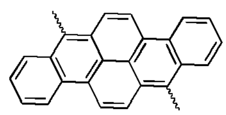
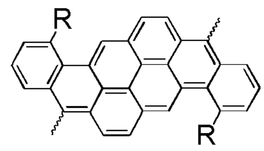
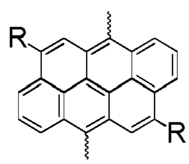

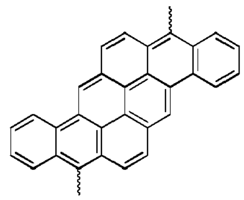
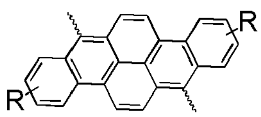
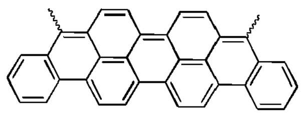
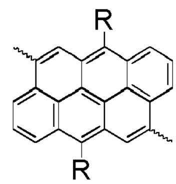

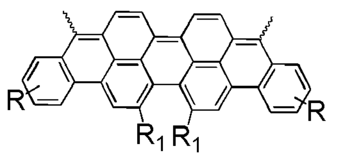
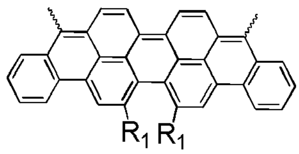
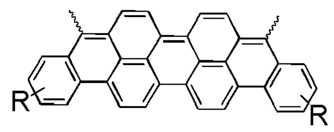

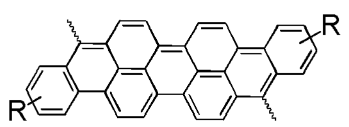
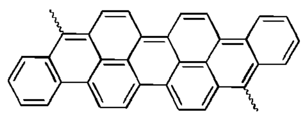
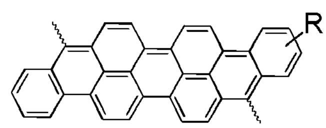

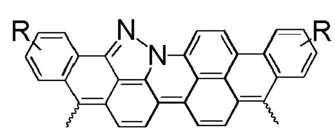
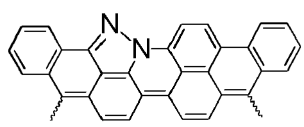

wavy bond 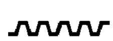 shows the attachment positions of X-blocks in formula (I');
R represents an aryl or a heteroaryl group which is non-substituted or substituted with a solubilizing group selected from $C_1$-$C_{20}$ alkyl or $C_1$-$C_{20}$ alkoxy,
$R_1$ represents a $C_1$-$C_{20}$ alkoxy group or a $C_1$-$C_{20}$ alkylthio group, $Ar^1$ and $Ar^2$ are the same or mutually different and independent from each other represent a divalent arylene group, a divalent heterocyclic group, or a divalent aromatic amine residue,
k represents the number of $Ar^1$ units connected in series in the repeating unit of the conjugated polymer and is a number between 0 and 3, preferably from 1 to 3,
m represents a number of $Ar^2$ units connected in series in the repeating unit of the conjugated polymer and is a number between 0 and 3, preferably from 1 to 3;
n represents an integer from 2 to 2000, preferably from 2 to 200,

EG$_1$ and EG$_2$ are the end groups of the polymer and independent from each other they represent a hydrogen, a halogen, a trialkylstannyl unit (-Sn(Alkyl)$_3$), a boronic acid unit(-B(OH)$_2$), a boronic ester unit (-B(OAlkyl)$_2$), an aryl unit or a heteroaryl unit and

X represents in each case independent from each other a divalent acetylene fragment X$_1$ or a thiophene unit X$_2$,

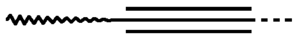

X$_1$

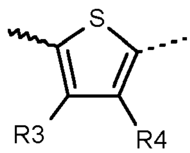

X$_2$

wherein 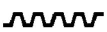 represents a wavy bond as the attachment position(s) of A and

R3 and R4 are the same or mutually different and represent a hydrogen atom, an alkyl group, an alkoxy group or an alkylthio group, **characterized in that** Suzuki or Stille polycondensation reaction is involved to link the monomers together thus forming a conjugated polymer.

**14.** Use of polymers represented by formula (I')

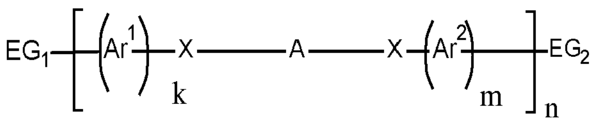

(I')

wherein

A represents a planar aromatic system selected from the list

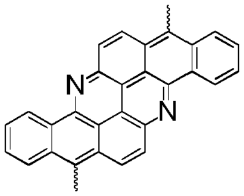 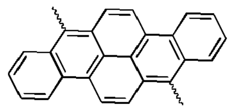 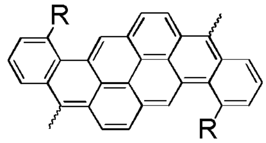 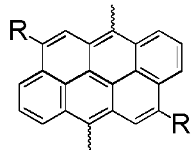

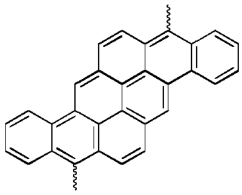 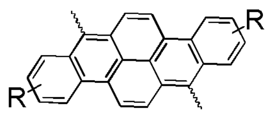 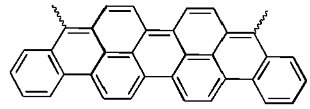 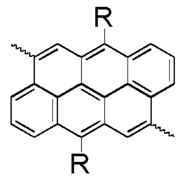

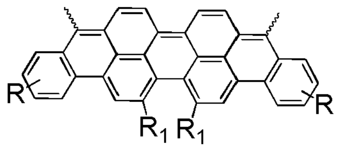 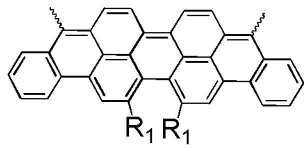 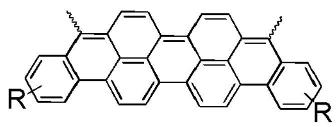

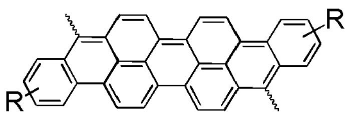 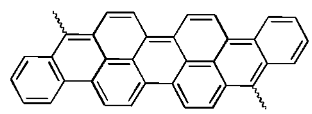 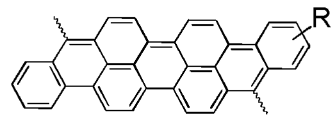

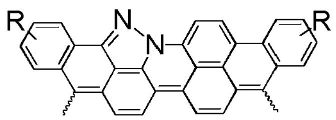 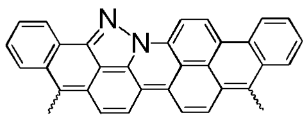

wavy bond shows the attachment positions of X-blocks in formula (I');

R represents an aryl or a heteroaryl group which is non-substituted or substituted with a solubilizing group selected from $C_1$-$C_{20}$ alkyl or $C_1$-$C_{20}$ alkoxy,

$R_1$ represents a $C_1$-$C_{20}$ alkoxy group or a $C_1$-$C_{20}$ alkylthio group, $Ar^1$ and $Ar^2$ are the same or mutually different and independent from each other represent a divalent arylene group, a divalent heterocyclic group, or a divalent aromatic amine residue,

k represents the number of $Ar^1$ units connected in series in the repeating unit of the conjugated polymer and is a number between 0 and 3, preferably from 1 to 3,

m represents a number of $Ar^2$ units connected in series in the repeating unit of the conjugated polymer and is a number between 0 and 3,

n represents an integer from 2 to 2000,

$EG_1$ and $EG_2$ are the end groups of the polymer and independent from each other they represent a hydrogen, a halogen, a trialkylstannyl unit (-Sn(Alkyl)$_3$), a boronic acid unit(-B(OH)$_2$), a boronic ester unit (-B(OAlkyl)$_2$), an aryl unit or a heteroaryl unit and

X represents in each case independent from each other a divalent acetylene fragment $X_1$ or a thiophene unit $X_2$

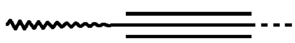 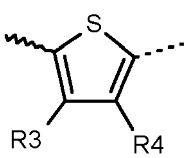

$X_1$ $X_2$

wherein

represents a wavy bond as the attachment position(s) of A and

R3 and R4 are the same or mutually different and represent a hydrogen atom, an alkyl group, an alkoxy group or an alkylthio group,
in optoelectronic devices, preferably in batteries or in photovoltaic devices.

**15.** Use according to Claim 14 **characterized in that** combinations of at least one polymer represented by formula (I')

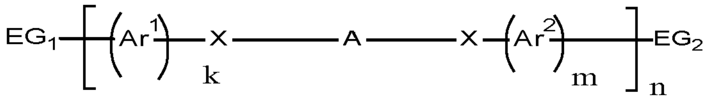

(I')

wherein

A represents a planar aromatic system selected from the list

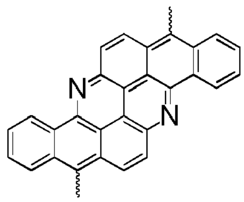
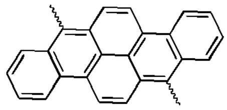
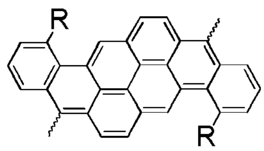
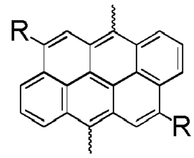
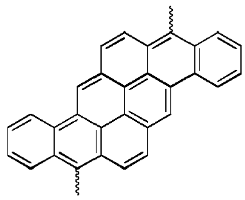
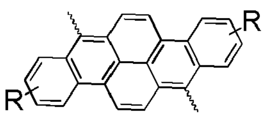
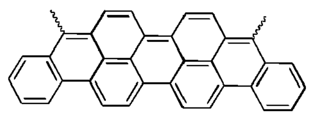
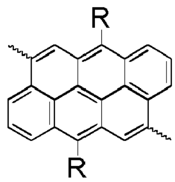
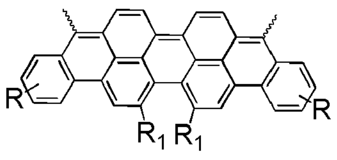
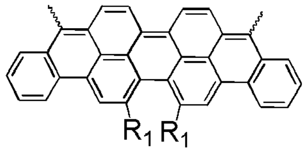
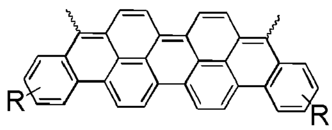
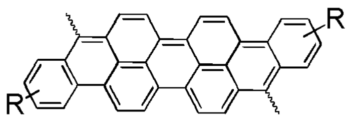
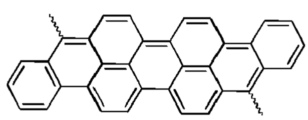
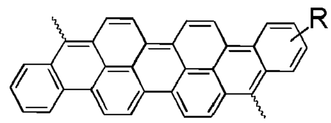
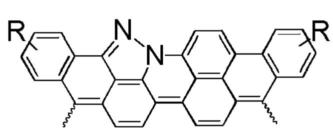
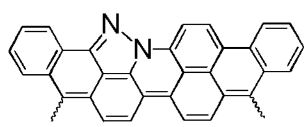

wavy bond 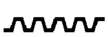 shows the attachment positions of X-blocks in formula (I');

R represents an aryl or a heteroaryl group which is non-substituted or substituted with a solubilizing group selected from $C_1$-$C_{20}$ alkyl or $C_1$-$C_{20}$ alkoxy,
$R_1$ represents a $C_1$-$C_{20}$ alkoxy group or a $C_1$-$C_{20}$ alkylthio group, $Ar^1$ and $Ar^2$ are the same or mutually different and independent from each other represent a divalent arylene group, a divalent heterocyclic group, or a divalent

aromatic amine residue,

k represents the number of $Ar^1$ units connected in series in the repeating unit of the conjugated polymer and is a number between 0 and 3,

m represents a number of $Ar^2$ units connected in series in the repeating unit of the conjugated polymer and is a number between 0 and 3

n represents an integer from 2 to 2000,

$EG_1$ and $EG_2$ are the end groups of the polymer and independent from each other they represent a hydrogen, a halogen, a trialkylstannyl unit ($-Sn(Alkyl)_3$), a boronic acid unit($-B(OH)_2$), a boronic ester unit ($-B(OAlkyl)_2$), an aryl unit or a heteroaryl unit and

X represents in each case independent from each other a divalent acetylene fragment $X_1$ or a thiophene unit $X_2$,

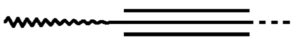

$X_1$

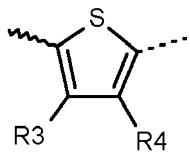

$X_2$

wherein

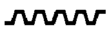 represents a wavy bond as the attachment position(s) of A and

R3 and R4 are the same or mutually different and represent a hydrogen atom, an alkyl group, an alkoxy group or an alkylthio group,

with at least one fullerene compound, preferably with at least one $C_{60}$ fullerene compound or at least one $C_{70}$ fullerene compound or their derivatives, more preferred with at least one $C_{60}$ fullerene compound or its derivatives, most preferred with [60]PCBM, are applied.

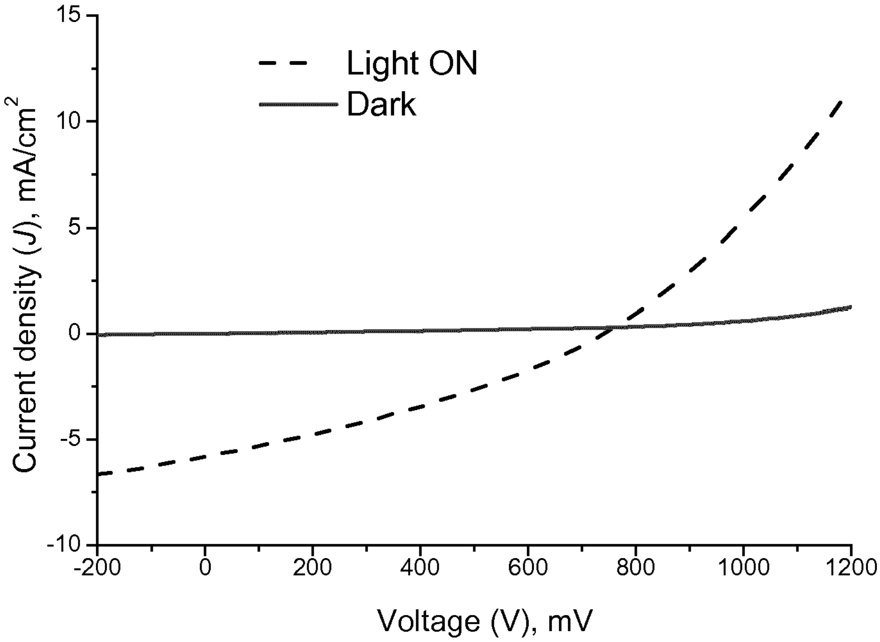

Light ON
Dark
Current density (J), mA/cm2
Voltage (V), mV
15
10
5
0
-5
-10
-200
0
200
400
600
800
1000
1200


**Fig.1**

Europäisches Patentamt
European Patent Office
Office européen des brevets

# EUROPEAN SEARCH REPORT

Application Number
EP 13 17 9740

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2005/048313 A1 (SOTOYAMA WATARU [JP]) 3 March 2005 (2005-03-03) * paragraph [0001] - paragraph [0168]; claims 1-36; examples * ----- | 1-15 | INV. C09K11/00 C08G61/12 H01B1/00 H01L51/00 |
| Y | US 2005/212409 A1 (SHI JIANMMIN [US] ET AL) 29 September 2005 (2005-09-29) * paragraph [0001] - paragraph [0248]; claims 1-11; examples * ----- | 1-15 | |
| Y | US 2005/214566 A1 (SHI JIANMIN [US] ET AL) 29 September 2005 (2005-09-29) * paragraph [0001] - paragraph [0149]; claims 1-11; examples * ----- | 1-15 | |
| Y | GB 2 483 628 A (CAMBRIDGE DISPLAY TECH [GB]; SUMITOMO CHEMICAL CO [JP]) 21 March 2012 (2012-03-21) * page 1 - page 24; claims 1-26; examples * ----- | 1-15 | |
| | | | TECHNICAL FIELDS SEARCHED (IPC) |
| Y | JIANMIN SHI ET AL: "61.4: Anthanthrene Derivatives for Stable Blue-Emitting Organic Electroluminescent Devices", 2005 SID INTERNATIONAL SYMPOSIUM. BOSTON, MA, MAY 24 - 27, 2005; [SID INTERNATIONAL SYMPOSIUM], SAN JOSE, CA : SID, US, vol. XXXVI, 24 May 2005 (2005-05-24), pages 1760-1763, XP007012392, * page 1760 - page 1763 * ----- | 1-15 | C09K C08G H01B H01L |
| | -/-- | | |

~~The present search report has been drawn up for all claims~~

1

| Place of search | Date of completion of the search | Examiner |
|---|---|---|
| The Hague | 14 May 2014 | Kiebooms, Rafaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 13 17 9740

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| Y | BIPIN K. SHAH ET AL: "Anthanthrene Derivatives as Blue Emitting Materials for Organic Light-Emitting Diode Applications", CHEMISTRY OF MATERIALS, vol. 18, no. 3, 1 February 2006 (2006-02-01), pages 603-608, XP055117953, ISSN: 0897-4756, DOI: 10.1021/cm052188x * page 603 - page 608 * ----- | 1-15 | |
| Y | BIPIN K. SHAH ET AL: "Photophysical Properties of Anthanthrene-Based Tunable Blue Emitters", THE JOURNAL OF PHYSICAL CHEMISTRY A, vol. 109, no. 34, 1 September 2005 (2005-09-01), pages 7677-7681, XP055117955, ISSN: 1089-5639, DOI: 10.1021/jp052337z * page 7677 - page 7681 * ----- | 1-15 | |
| | | | TECHNICAL FIELDS SEARCHED (IPC) |
| A,P | JEAN-BENOÎT GIGUÈRE ET AL: "Cruciform Alkynylated Anthanthrene Derivatives: A Structure-Properties Relationship Case Study", THE JOURNAL OF ORGANIC CHEMISTRY, vol. 79, no. 6, 21 March 2014 (2014-03-21), pages 2404-2418, XP055117950, ISSN: 0022-3263, DOI: 10.1021/jo402674m * the whole document * ----- -/-- | 1-15 | |

~~The present search report has been drawn up for all claims~~

1

| Place of search | Date of completion of the search | Examiner |
|---|---|---|
| The Hague | 14 May 2014 | Kiebooms, Rafaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 13 17 9740

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ANDREW C GRIMSDALE ET AL: "Synthesis of Light-Emitting Conjugated Polymers for Applications in Electroluminescent Devices", CHEMICAL REVIEWS, AMERICAN CHEMICAL SOCIETY, US, vol. 109, 1 February 2009 (2009-02-01), pages 897-1091, XP009133687, ISSN: 0009-2665, DOI: 10.1021/CR000013V * the whole document * ----- | 1-15 | |

TECHNICAL FIELDS SEARCHED (IPC)

1 ~~The present search report has been drawn up for all claims~~

| Place of search | Date of completion of the search | Examiner |
|---|---|---|
| The Hague | 14 May 2014 | Kiebooms, Rafaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

Application Number
EP 13 17 9740

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-15(partially)

☐ The present supplementary European search report has been drawn up for those parts of the European patent application which relate to the invention first mentioned in the claims (Rule 164 (1) EPC).

Europäisches Patentamt
European Patent Office
Office européen des brevets

## LACK OF UNITY OF INVENTION SHEET B

Application Number
EP 13 17 9740

The Search Division considers that the present European patent application does not comply with the requirements of unity of invention and relates to several inventions or groups of inventions, namely:

1. claims: 1-15(partially)

Formula A1-A16 in combination with X= thiophene or acetylene

---

2-32. claims: 1-15(partially)

Formula A1-A16 in combination with X= thiophene or acetylene

---

## ANNEX TO THE EUROPEAN SEARCH REPORT ON EUROPEAN PATENT APPLICATION NO.

EP 13 17 9740

This annex lists the patent family members relating to the patent documents cited in the above-mentioned European search report. The members are as contained in the European Patent Office EDP file on
The European Patent Office is in no way liable for these particulars which are merely given for the purpose of information.

14-05-2014

| Patent document cited in search report | Publication date | Patent family member(s) | Publication date |
|---|---|---|---|
| US 2005048313 A1 | 03-03-2005 | CN 1609163 A | 27-04-2005 |
| | | JP 2005075868 A | 24-03-2005 |
| | | KR 20050022870 A | 08-03-2005 |
| | | US 2005048313 A1 | 03-03-2005 |
| US 2005212409 A1 | 29-09-2005 | NONE | |
| US 2005214566 A1 | 29-09-2005 | NONE | |
| GB 2483628 A | 21-03-2012 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 0044686 A1
- EP 0120673 A2


### Non-patent literature cited in the description


- **C. DUAN.** *J. Mater. Chem.,* 2012, vol. 22, 10416-10434
- **Z.-G. ZHANG.** *J. Mater. Chem.,* 2012, vol. 22, 4178-4187
- **H. ZHOU.** *Macromolecules,* 2012, vol. 45, 607-632
- **F. HE.** *J. Am. Chem. Soc.,* 2011, vol. 133, 3284-3287
- **P. A. TROSHIN.** *Adv. Energ. Mater.,* 2013, vol. 3, 161-166
- **D. A. M. EGBE.** *Macromolecules,* 2004, vol. 37, 7451
- **Y. LEE.** *J. Mater. Chem.,* 2011, vol. 21, 8583-8590
- Lange's Handbook of Chemistr. McGraw Hill, 1979, 3-134, 3-138
- **KATRITZKY, A.R ; LAGOWSKI, J.M.** Heterocyclic Chemistry. John Wiley & Sons, 1960
- **F. C. KREBS.** *Solar Energy Materials & Solar Cells,* 2009, vol. 93, 394-412
- *Synth. Met.,* 1999, vol. 102, 982
- *Science,* 1995, vol. 270, 1789
- Microwave Methods in Organic Synthesis. Topics in Current Chemistry. 2006, vol. 266, 103-144
- Design and Synthesis of Conjugated Polymers. Wiley InterScience, 2010, 45-98
- **A. SUZUKI.** *Acc. Chem. Res.,* 1982, vol. 15, 178-184